(19) Europäisches Patentamt / European Patent Office / Office européen des brevets

(11) EP 4 497 802 A1

(12) **EUROPEAN PATENT APPLICATION**

(43) Date of publication: **29.01.2025 Bulletin 2025/05**

(21) Application number: **23187654.1**

(22) Date of filing: **25.07.2023**

(51) International Patent Classification (IPC): ***C09K 11/06*** *(2006.01)* ***C07F 5/02*** *(2006.01)* ***H10K 50/00*** *(2023.01)*

(52) Cooperative Patent Classification (CPC): **C09K 11/06; C07F 5/027; H10K 85/615; H10K 85/636; H10K 85/6574; H10K 85/658;** H10K 50/11

(84) Designated Contracting States: **AL AT BE BG CH CY CZ DE DK EE ES FI FR GB GR HR HU IE IS IT LI LT LU LV MC ME MK MT NL NO PL PT RO RS SE SI SK SM TR**
Designated Extension States: **BA**
Designated Validation States: **KH MA MD TN**

(71) Applicant: **Idemitsu Kosan Co., Ltd Tokyo 100-8321 (JP)**

(72) Inventors:
- **Boufflet, Pierre 4058 Basel (CH)**
- **Groarke, Michelle 4058 Basel (CH)**
- **Nishimae, Yuichi 4058 Basel (CH)**
- **Schäfer, Thomas 4058 Basel (CH)**
- **Lin, Chao-Chen 4058 Basel (CH)**

(74) Representative: **Büchel, Edwin Patentanwälte Isenbruck Bösl Hörschler PartG mbB Eastsite One Seckenheimer Landstraße 4 68163 Mannheim (DE)**

# (54) COMPOUND AND AN ORGANIC ELECTROLUMINESCENCE DEVICE COMPRISING THE COMPOUND

(57) The present invention relates to specific compounds, a material, preferably an emitter material, for an organic electroluminescence device comprising said specific compounds, an organic electroluminescence device comprising said specific compounds, an electronic equipment comprising said organic electroluminescence device, a light emitting layer comprising at least one host and at least one dopant, wherein the dopant comprises at least one of said specific compounds, and the use of said compounds in an organic electroluminescence device.

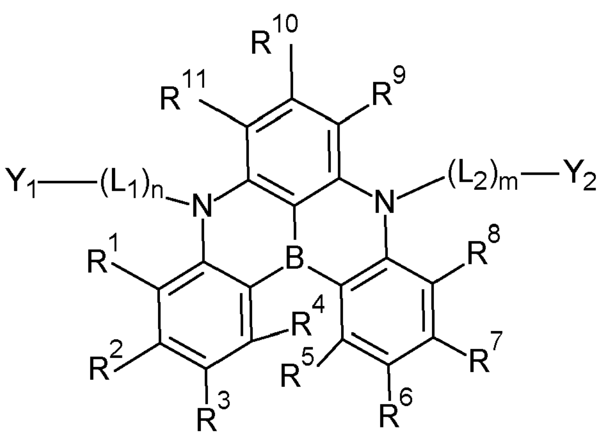

(I)

wherein
at least one of $R^1$, $R^2$, $R^3$ and $R^4$ represents an alkyl group having from 1 to 20 carbon atoms which is unsubstituted or substituted or an amino group $NR^{84}R^{85}$, and
at least one of $R^5$, $R^6$, $R^7$ and $R^8$ represents an aryl group having from 6 to 30 ring carbon atoms which is unsubstituted or substituted; or a heteroaryl group having from 5 to 30 ring atoms which is unsubstituted or substituted, whereby the aryl

group or the heteroaryl group may bind back to an adjacent residue and form a ring structure;
$Y_1$ and $Y_2$ each independently represents $R^Y$ or a group of formula (II)

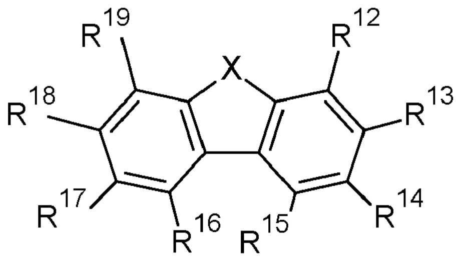

(II),

wherein at least one of $Y_1$ and $Y_2$ is a group of formula (II).

## Description

The present invention relates to specific compounds, a material, preferably an emitter material, for an organic electroluminescence device comprising said specific compounds, an organic electroluminescence device comprising said specific compounds, an electronic equipment comprising said organic electroluminescence device, a light emitting layer comprising at least one host and at least one dopant, wherein the dopant comprises at least one of said specific compounds, and the use of said compounds in an organic electroluminescence device.

When a voltage is applied to an organic electroluminescence device (hereinafter may be referred to as an organic EL device), holes are injected to an emitting layer from an anode and electrons are injected to an emitting layer from a cathode. In the emitting layer, injected holes and electrons are re-combined and excitons are formed.

An organic EL device comprises an emitting layer between the anode and the cathode. Further, there may be a case where it has a stacked layer structure comprising an organic layer such as a hole-injecting layer, a hole-transporting layer, an electron-injecting layer, an electron-transporting layer, etc.

US 2022/0020925 A1 and US 2021/0066599 A1 each relate to a compound represented by the following formula (1), wherein one of $R^{12}$ to $R^{18}$ is bonded with $L_2$.

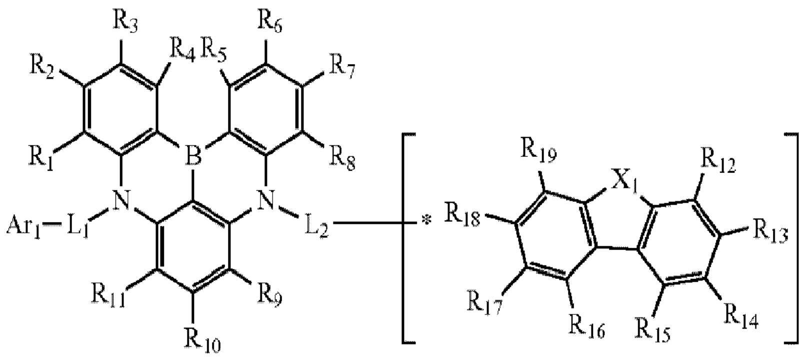

(1)

$R_1$ to $R_{11}$ which do not form the substituted or unsubstituted, saturated or unsaturated ring, and $R_{12}$ to $R_{19}$ which do not form the substituted or unsubstituted, saturated or unsaturated ring and which are not bonded with $L_2$ are among others independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 carbon atoms that form a ring.

US 2021/0062078 A1 relates to a compound represented by the following formula (1), wherein in the formula (1), at least one of $R_1$ to $R_8$ is a group represented by the following formula (2).

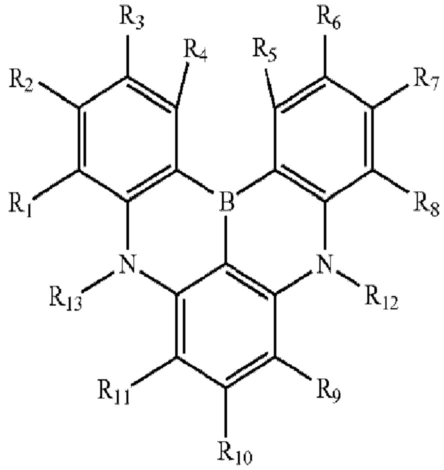

(1)

$$-L_1\text{-}H_{Ar} \qquad (2)$$

$R_1$ to $R_{11}$ which do not form the substituted or unsubstituted, saturated or unsaturated ring, and $R_{12}$ and $R_{13}$ are among others independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 carbon atoms that form a ring.

WO2021049889 A1 relates to a compound represented by the following formula (1):

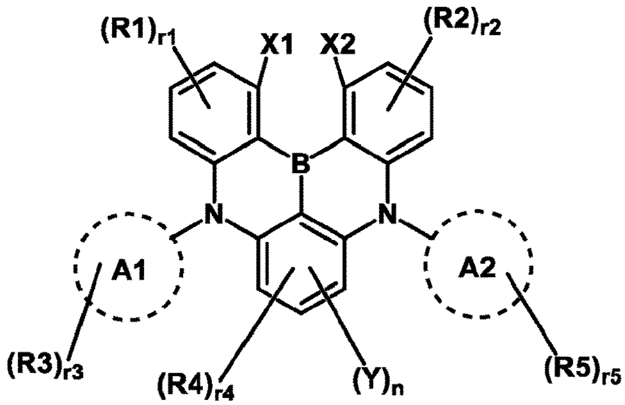

,

wherein

Y is an alkyl group having 1 to 3 carbon atoms substituted with deuterium; or represented by the following formula (2),

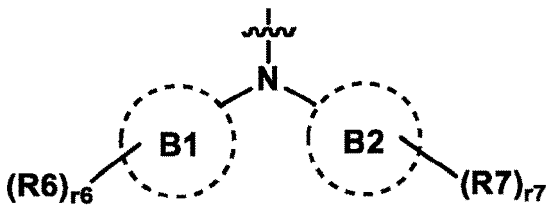

,

wherein

when Y is represented by Formula 2, at least one of X1, X2 and R1 to R7 is an alkyl group having 1 to 3 carbon atoms substituted with deuterium.

KR20190127529 A relates to an organic electroluminescent device comprising a boron-based organic compound of formula (1) and an anthracene-based organic compound of formula (2) in at least one organic layer included in the organic electroluminescent device.

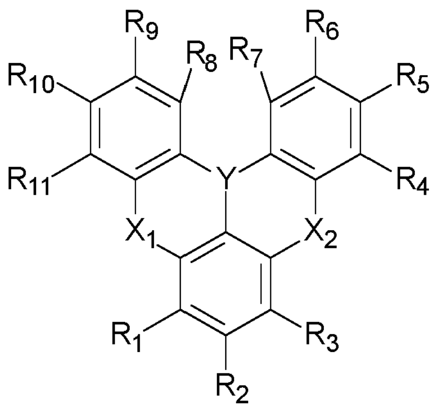

(1)

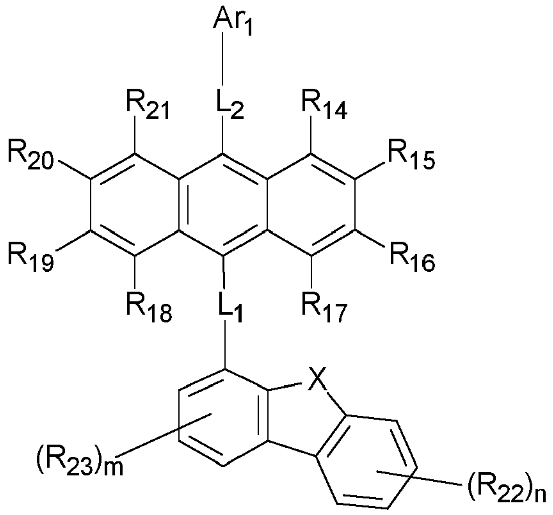

(2)

US20200176679 A1 relates to a compound represented by formula 1 as an organic compound having narrow light emission spectrum and full width half the maximum and capable of suppressing the concentration quenching phenomenon in spite of high doping concentration.

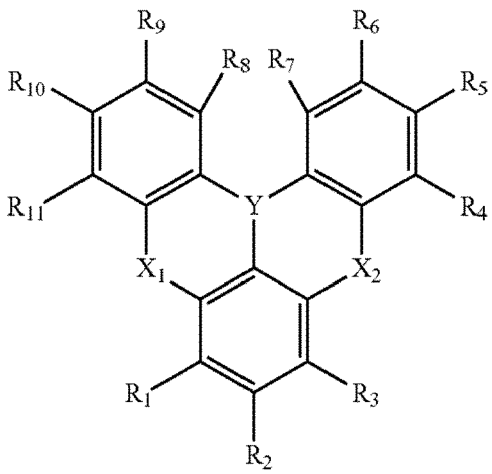

(1) ,

wherein

Y is B, P(=O) or P(=S) and $X_1$ and $X_2$ are the same as or different from each other, and are each independently selected from the group consisting of O, S, Se and $N(R_{12})$.

The compound of formula 1 includes at least one or more substituted or unsubstituted cycloalkyl groups having 1 to 20 carbon atoms.

WO2022191561 A1 relates to a material for an organic light emitting device that can be used in an organic light emitting device and can be used in a solution process at the same time.

The compound is represented by the following formula (1):

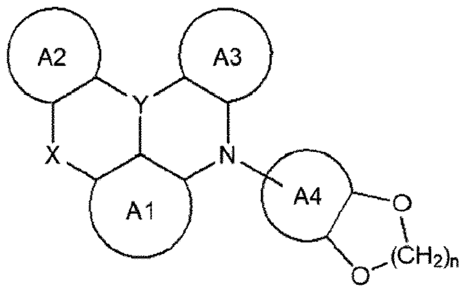

(1),

wherein

A1 is a C6-60 aromatic ring,
A2 is a C6-60 aromatic ring, or a C2-60 heteroaromatic ring comprising any one of N, O and S;
A3 is a C6-60 aromatic ring, or a C2-60 heteroaromatic ring comprising any one of N, O and S;
A4 is a C6-60 aromatic ring,
X is N-R, wherein R is substituted or unsubstituted C6-60 aryl;
Y is B;
n is an integer from 1 to 4.

KR20220073182 A relates to a compound of formula 1 and an organic light emitting device comprising the same.

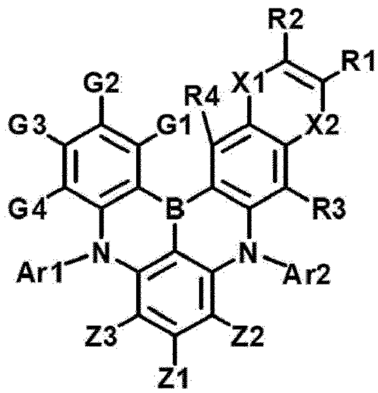

(1)

wherein

X1 and X2 are the same as or different from each other, and each independently represent CR11 R12, O, S, or SiR13R14;
if any one of X1 and X2 is CR11R12, the other one is O, S, or SiR13R14,
R1 to R4, R11 to R14, G1 to G4 and Z1 to Z3 are the same as or different from each other, and each independently hydrogen; heavy hydrogen; halogen group; cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a condensed ring group of a substituted or unsubstituted aromatic hydrocarbon ring and an aliphatic hydrocarbon ring; or a substituted or unsubstituted heterocyclic group, or a substituted or unsubstituted ring by combining with an adjacent group;
Ar1 and Ar2 are the same as or different from each other, and each independently a substituted or unsubstituted cycloalkyl group; a substituted or unsubstituted aryl group; a substituted or unsubstituted heterocyclic group; or a condensed ring group of a substituted or unsubstituted aromatic hydrocarbon ring and an aliphatic hydrocarbon ring.

WO2020080872 A1 relates to a heterocyclic compound represented by Formula 1 and an organic light emitting device including the same.

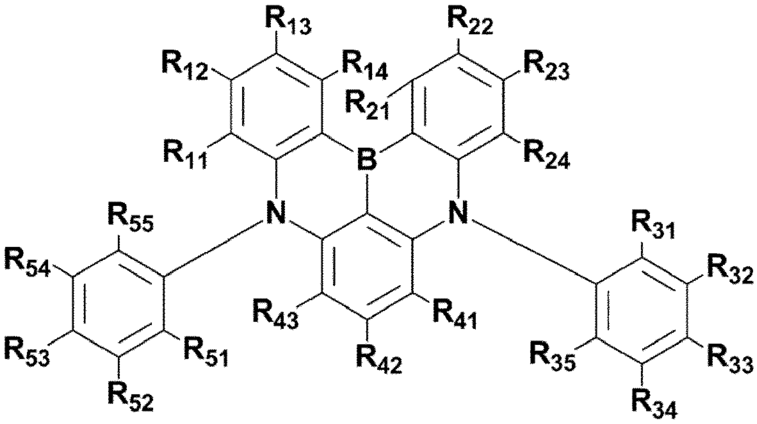

[Formula 1]

wherein (in Formula 1 and in Formula 2 below)

R11 to R14, R21 to R24, R31 to R35, R41 to R43, R51 to R55, and R61 to R64 are the same as or different from each other, and each independently hydrogen, deuterium, nitrile, halogen, substituted or unsubstituted alkyl group, substituted or unsubstituted cycloalkyl group, substituted or unsubstituted alkoxy group, substituted or unsubstituted silyl group, substituted or unsubstituted phosphine oxide group, substituted or unsubstituted amine group, substituted or unsubstituted boron group, a substituted or unsubstituted aryl group, a substituted or unsubstituted heterocyclic group, or combines with an adjacent substituent to form a substituted or unsubstituted ring,
two adjacent substituent groups among R11 to R14, R21 to R24, R31 to R35, R41 to R43, and R51 to R55 may form a substituted or unsubstituted ring,
wherein at least one group of the two adjacent substituent groups form a ring represented by Formula 2.

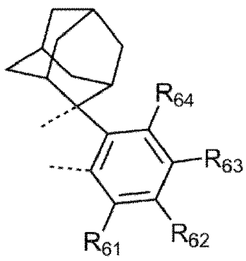

[Formula 2]

The specific structure and substitution pattern of compounds has a significant impact on the performance of the compounds in organic electronic devices.

Notwithstanding the developments described above, there remains a need for organic electroluminescence devices comprising new materials, especially dopant (= emitter) materials, to provide improved performance of electroluminescence devices.

Accordingly, it is an object of the present invention, with respect to the aforementioned related art, to provide materials suitable for providing organic electroluminescence devices which ensure good performance of the organic electroluminescence devices, especially a long lifetime and high external quantum efficiencies (EQE). More particularly, it should be possible to provide dopant (= emitter) materials, especially blue light emitting dopant materials having a narrow spectrum (small FWHM), i.e. good color purity when used as dopant in organic electroluminescence devices.

Said object is according to one aspect of the present invention solved by a compound represented by formula (I):

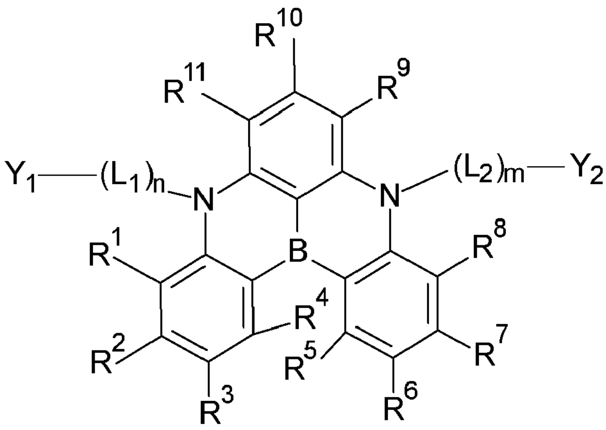

(I)

wherein

$R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen; preferably hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen; preferably $R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; $OR^{20}$; or an amino group $NR^{84}R^{85}$;

or

two adjacent residues of $R^1$, $R^2$, $R^3$, $R^4$, $R^5$, $R^6$, $R^7$, $R^8$, $R^9$and $R^{11}$, preferably $R^6$ and $R^7$ together form a ring structure which is unsubstituted or substituted;

wherein at least one of $R^1$, $R^2$, $R^3$ and $R^4$ represents an alkyl group having from 1 to 20 carbon atoms which is unsubstituted or substituted or an amino group $NR^{84}R^{85}$, and at least one of $R^5$, $R^6$, $R^7$ and $R^8$ represents an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure;

$Y_1$ and $Y_2$ each independently represents $R^Y$ or a group of formula (II);

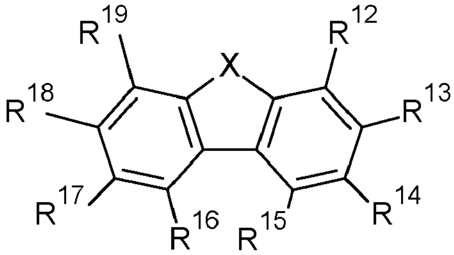

(II);

$R^Y$ represents an aryl group having from 6 to 30 ring carbon atoms which is unsubstituted or substituted, wherein the aryl group is not fused with a group of formula

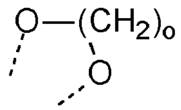

,

wherein o is 1, 2, 3 or 4 and the dotted lines are bonding sites; or a heteroaryl group having from 5 to 30 ring atoms which is unsubstituted or substituted; preferably, the aryl group is not fused with an aliphatic or heteroaliphatic group; more preferably, the aryl group and the heteroaryl group are not fused with an aliphatic or heteroaliphatic group;
wherein at least one of $Y_1$ and $Y_2$ is a group of formula (II)
wherein in formula (II)
$R^{12}$, $R^{13}$, $R^{14}$, $R^{15}$, $R^{16}$, $R^{17}$, $R^{18}$ and $R^{19}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen;
or
two adjacent residues together form a ring structure which is unsubstituted or substituted; wherein one of $R^{12}$, $R^{13}$, $R^{14}$, $R^{15}$, $R^{16}$, $R^{17}$, $R^{18}$ and $R^{19}$ is a bonding site;
X is O, S or $CR^{35'}R^{36'}$;
$L_1$ and $L_2$ each independently represents an unsubstituted or substituted aromatic group containing 6 to 30 ring atoms, wherein the aromatic group is not fused with a group of formula

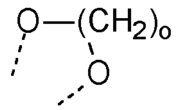

,

wherein o is 1, 2, 3 or 4 and the dotted lines are bonding sites; or an unsubstituted or substituted heteroaromatic group containing 5 to 30 ring atoms; preferably, the aromatic group is not fused with an aliphatic or heteroaliphatic group; more preferably, the aromatic group and the heteroaromatic group are not fused with an aliphatic or heteroaliphatic group; n and m are each independently 0, 1, 2 or 3; preferably 0, 1 or 2, more preferably 0 or 1; wherein in the case that $Y_1$ is a group of formula (II) and X is O or S, n is 1, 2 or 3;
and/or
wherein in the case that $Y_2$ is a group of formula (II) and X is O or S, m is 1, 2 or 3;
$R^{35'}$ and $R^{36'}$ each independently represents an alkyl group having from 1 to 20 carbon atoms which is unsubstituted or substituted; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; or
$R^{35'}$ and $R^{36'}$ together form an aromatic ring structure which is unsubstituted or substituted;
$R^{84}$ and $R^{85}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
$R^{20}$, $R^{21}$, $R^{22}$ and $R^{23}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
$R^{24}$, $R^{25}$ and $R^{26}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted.

The compounds of formula (I) can be in principal used in any layer of an EL device. Preferably, the compound of formula (I) is a dopant (= emitter) in organic EL elements, especially in the light-emitting layer, more preferably a

fluorescent dopant. Particularly, the compounds of formula (I) are used as fluorescent dopants in organic EL devices, especially in the light-emitting layer.

The term organic EL device (organic electroluminescence device) is used interchangeably with the term organic light-emitting diode (OLED) in the present application.

It has been found that organic EL devices comprising the compounds of the present invention are generally characterized by long lifetimes and high external quantum efficiencies (EQE), especially when the specific compounds of formula (I) are used as dopants (light emitting material), especially fluorescent dopants in organic electroluminescence devices.

The specific compounds of formula (I) preferably show a blue emission, more preferably a blue fluorescence. Further, the specific compounds of formula (I) preferably show a narrow emission characteristic, preferably a narrow fluorescence, more preferably a narrow blue fluorescence. Such a narrow emission characteristic is suitable to prevent energy losses by outcoupling. The compounds of formula (I) according to the present invention preferably have a Full width at half maximum (FWHM) of lower than 30 nm.

Examples of the optional substituent(s) indicated by "substituted or unsubstituted" and "may be substituted" referred to above or hereinafter include an aryl group having from 6 to 30 preferably from 6 to 18 ring carbon atoms which is in turn unsubstituted or substituted, a heteroaryl group having from 5 to 30, preferably 5 to 18 ring atoms which is in turn unsubstituted or substituted, an alkyl group having 1 to 20, preferably 1 to 8 carbon atoms, a group $OR^{20}$, an alkylhalide group having 1 to 20, preferably 1 to 8 carbon atoms, a cycloalkyl group having from 3 to 20, preferably 3 to 6 ring carbon atoms which is unsubstituted or substituted, an aralkyl group having from 7 to 30 carbon atoms which is unsubstituted or substituted, a halogen atom (fluorine, chlorine, bromine, iodine), CN, $C(=O)R^{22}$, $COOR^{23}$, a silyl group $SiR^{24}R^{25}R^{26}$, a group $SR^{21}$, $NO_2$ and $NR^{84}R^{85}$;
or

two adjacent substituents together form a ring structure which is in turn unsubstituted or substituted;
$R^{20}$, $R^{21}$, $R^{22}$, $R^{23}$, $R^{24}$, $R^{25}$, $R^{26}$, $R^{84}$ and $R^{85}$ are defined above.

The terms hydrogen, halogen, an alkyl group having from 1 to 20 carbon atoms which is unsubstituted or substituted, an alkylhalide group having from 1 to 20 carbon atoms which is unsubstituted or substituted, a cycloalkyl group having from 3 to 20 ring carbon atoms which is unsubstituted or substituted, a substituted or unsubstituted aryl group having 6 to 30, preferably from 6 to 18 ring carbon atoms; a substituted or unsubstituted heteroaryl group having 5 to 30, preferably 5 to 18 ring atoms, $C(=O)R^{22}$, $OR^{20}$, $SR^{21}$, $C(=O)R^{22}$, $COOR^{23}$, $SiR^{24}R^{25}R^{26}$, an aralkyl group having from 7 to 30 carbon atoms which is unsubstituted or substituted, an alkenyl group having from 2 to 20 carbon atoms which is unsubstituted or substituted and an alkynyl group having from 2 to 20 carbon atoms which is unsubstituted or substituted, and $NR^{84}R^{85}$;
are known in the art and generally have the following meaning, if said groups are not further specified in specific embodiments mentioned below.

The hydrogen atom referred to herein includes isotopes different from neutron numbers, i.e., light hydrogen (protium), heavy hydrogen (deuterium) and tritium.

In chemical formulae herein, it is meant that a hydrogen atom (i.e. protium, deuterium, or tritium) is bonded to each of bondable positions that are not annexed with symbols "R" etc., or a "D" representing a deuterium.

The term "unsubstituted" referred to by "unsubstituted or substituted" means that a hydrogen atom is not substituted by one of the groups mentioned above. The hydrogen atom(s) in the "unsubstituted" group is protium, deuterium, or tritium.

The substituted or unsubstituted aryl group having 6 to 30, preferably from 6 to 18 ring carbon atoms more preferably having from 6 to 13 ring carbon atoms, may be a non-condensed aromatic group or a condensed aromatic group. Specific examples thereof include phenyl group, naphthyl group, phenanthryl group, biphenyl group, terphenyl group, fluoranthenyl group, triphenylenyl group, phenanthrenyl group, fluorenyl group, indenyl group, anthracenyl, chrysenyl, spirofluorenyl group, benzo[c]phenanthrenyl group, with phenyl group, naphthyl group, biphenyl group, terphenyl group, phenanthryl group, triphenylenyl group, fluorenyl group, indenyl group and fluoranthenyl group being preferred, phenyl group, 1-naphthyl group, 2-naphthyl group, biphenyl-2-yl group, biphenyl-3-yl group, biphenyl-4-yl group, phenanthrene-9-yl group, phenan-threne-3-yl group, phenanthrene-2-yl group, triphenylene-2-yl group, fluorene-2-yl group, especially a 9,9-di-$C_{1-20}$alkylfluorene-2-yl group, like a 9,9-dimethylfluorene-2-yl group, a 9,9-di-$C_{6-18}$arylfluorene-2-yl group, like a 9,9-diphenylfluorene-2-yl group, or a 9,9-di-$C_{5-18}$heteroarylfluo-rene-2-yl group, fluorene-4-yl group, especially a 9,9-di-$C_{1-20}$alkylfluorene-4-yl group, like a 9,9-dimethylfluorene-4-yl group, a 9,9-di-$C_{6-18}$arylfluorene-4-yl group, like a 9,9-diphenylfluorene-4-yl group, or a 9,9-di-$C_{5-18}$heteroarylfluorene-4-yl group, 1,1-dimethylindenyl group, fluoranthene-3-yl group, fluoranthene-2-yl group and fluoranthene-8-yl group being more preferred, and phenyl group being most preferred.

The substituted or unsubstituted heteroaryl group having 5 to 30, preferably 5 to 18 ring atoms, more preferably

having from 5 to 13 ring atoms, may be a non-condensed heteroaromatic group or a condensed heteroaromatic group. Specific examples thereof include the residues of pyrrole ring, isoindole ring, benzofuran ring, isobenzofuran ring, benzothiophene, dibenzothiophene ring, isoquinoline ring, quinoxaline ring, quinazoline, phenanthridine ring, phenanthroline ring, pyridine ring, pyrazine ring, pyrimidine ring, pyridazine ring, indole ring, quinoline ring, acridine ring, carbazole ring, furan ring, thiophene ring, benzoxazole ring, benzothiazole ring, benzimidazole ring, dibenzofuran ring, triazine ring, oxazole ring, oxadiazole ring, thiazole ring, thiadiazole ring, triazole ring, imidazole ring, indolidine ring, imidazopyridine ring, 4-imidazo[1,2-a]ben-zimidazoyl, 5-benzimidazo[1,2-a]benzimidazoyl, and benzimidazolo[2,1-b][1,3]benzothiazolyl, with the residues of benzofuran ring, indole ring, benzothiophene ring, dibenzofuran ring, carbazole ring, and dibenzothiophene ring being preferred, and the residues of benzofuran ring, 1-phenylindol ring, benzothiophene ring, dibenzofuran-1-yl group, dibenzofuran-3-yl group, dibenzofuran-2-yl group, dibenzofuran-4-yl group, 9-phenylcarbazole-3-yl group, 9-phenylcarbazole-2-yl group, 9-phenylcarbazole-4-yl group, dibenzothiophene-2-yl group, and dibenzothiophene-4-yl, dibenzothiophene-1-yl group, and dibenzothiophene-3-yl group being more preferred.

The substituted or unsubstituted N-heteroaryl group having 5 to 30, preferably 5 to 18 ring atoms, more preferably having from 5 to 13 ring atoms, is described as the substituted or unsubstituted heteroaryl group mentioned above, wherein at least one of the ring atoms is nitrogen.

Examples of the alkyl group having from 1 to 20 carbon atoms which is unsubstituted or substituted, linear or branched include methyl group, ethyl group, n-propyl group, isopropyl group, n-butyl group, s-butyl group, isobutyl group, t-butyl group, n-pentyl group, isopentyl, t-pentyl group (t-amyl group), neopentyl, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, 1-methylpentyl group, with methyl group, ethyl group, n-propyl group, isopropyl group, n-butyl group, s-butyl group, isobutyl group, t-butyl group being preferred. Preferred are alkyl groups having 1 to 8 carbon atoms, more preferably 1 to 4 carbon atoms. Suitable examples for alkyl groups having 1 to 8 carbon atoms respectively 1 to 4 carbon atoms are mentioned before. Most preferred are methyl, isopropyl and t-butyl. Preferably, the alkyl group is unsubstituted, i.e. it does not comprise atoms other than C and H and does not comprise unsaturated or aromatic groups. However, the alkyl group is linear or branched.

Examples of the alkylhalide group having from 1 to 20 carbon atoms which is unsubstituted or substituted include those disclosed as alkyl groups wherein the hydrogen atoms thereof are partly or entirely substituted by halogen atoms. Preferred alkylhalide groups are fluoroalkyl groups having 1 to 20 carbon atoms including the alkyl groups mentioned above wherein the hydrogen atoms thereof are partly or entirely substituted by fluorine atoms, for example $CF_3$.

Examples of the alkenyl group having from 2 to 20 carbon atoms which is unsubstituted or substituted include ethene group, n-propene group, isopropene group, n-butene group, isobutene group, n-pentene group, n-hexene group, n-heptene group, n-octene group, n-nonene group, n-decene group, n-undecene group, n-dodecene group, n-tridecene group, n-tetradecene group, n-pentadecene group, n-hexadecene group, n-heptadecene group, n-octadecene group, with ethene group, n-propene group, isopropene group, n-butene group, isobutene group being preferred. Preferred are alkenyl groups having 2 to 8 carbon atoms, more preferably 2 to 4 carbon atoms. Suitable examples for alkenyl groups having 2 to 8 carbon atoms respectively 2 to 4 carbon atoms are mentioned before.

Examples of the alkynyl group having from 2 to 20 carbon atoms which is unsubstituted or substituted include ethynyl group, n-propynyl group, n-butynyl group, n-pentynyl group, n-hexynyl group, n-heptynyl group, n-octynyl group, with ethynyl group, n-propynyl group, n-butynyl group being preferred. Preferred are alkynyl groups having 2 to 8 carbon atoms, more preferably 2 to 4 carbon atoms. Suitable examples for alkynyl groups having 2 to 8 carbon atoms respectively 2 to 4 carbon atoms are mentioned before.

Examples of the cycloalkyl group having from 3 to 20 ring carbon atoms which is unsubstituted or substituted include cyclopropyl group, cyclobutyl group, cyclopentyl group, cyclohexyl group, cyclooctyl group, and adamantyl group, with cyclopentyl group, and cyclohexyl group being preferred. Preferred are cycloalkyl groups having 3 to 6 carbon atoms. Suitable examples for cycloalkyl groups having 3 to 6 carbon atoms are mentioned before.

An example for an aralkyl group having from 7 to 30 carbon atoms which is unsubstituted or substituted includes a benzyl group.

Examples of halogen atoms include fluorine, chlorine, bromine, and iodine, with fluorine being preferred.

The group $OR^{20}$ is preferably a $C_{1-20}$alkoxy group or a $C_{6-18}$aryloxy group. Examples of an alkoxy group having 1 to 20 carbon atoms, preferably 1 to 8 carbon atoms, include those having an alkyl portion selected from the alkyl groups mentioned above. Examples of an aryloxy group having 6 to 18 ring carbon atoms include those having an aryl portion selected from the aryl groups mentioned above, for example -OPh.

The group $SR^{21}$ is preferably a $C_{1-20}$alkylthio group or a $C_{6-18}$arylthio group. Examples of an al-kylthio group having 1 to 20 carbon atoms, preferably 1 to 8 carbon atoms, include those having an alkyl portion selected from the alkyl groups mentioned above. Examples of an arylthio group having 6 to 18 ring carbon atoms include those having an aryl portion selected from the aryl groups mentioned above, for example -SPh.

The group $SiR^{24}R^{25}R^{26}$ is preferably a $C_{1-20}$alkyl and/or $C_{6-18}$aryl substituted silyl group. Preferred examples of $C_{1-20}$alkyl and/or $C_{6-18}$aryl substituted silyl groups include alkylsilyl groups having 1 to 8 carbon atoms in each alkyl

residue, preferably 1 to 4 carbon atoms, including trimethylsilyl group, triethylsilyl group, tributylsilyl group, dimethylethylsilyl group, t-butyldimethylsilyl group, propyldimethylsilyl group, dimethylisopropylsilyl group, dimethylpropylsilyl group, dimethylbutyl-silyl group, dimethyltertiarybutylsilyl group, diethylisopropylsilyl group, and arylsilyl groups having 6 to 18 ring carbon atoms in each aryl residue, preferably triphenylsilyl group, and alkyl/arylsilyl groups, preferably phenyldimethylsilyl group, diphenylmethylsilyl group, and diphenyltertiarybutylsilyl group, with diphenyltertiarybutylsilyl group and t-butyldimethylsilyl group being preferred.

The group $NR^{84}R^{85}$ is an amino group, wherein $R^{84}$ and $R^{85}$ are described above. Preferably, $R^{84}$ and $R^{85}$ each independently represents an aryl group having from 6 to 30 ring carbon atoms which is unsubstituted or substituted; or a heteroaryl group having from 5 to 30 ring atoms which is unsubstituted or substituted, preferably, $R^{84}$ and $R^{85}$ each independently represents an aryl group having from 6 to 18 ring carbon atoms which is unsubstituted or substituted; or a heteroaryl group having from 5 to 18 ring atoms which is unsubstituted or substituted.

The optional substituents preferably each independently represents an aryl group having from 6 to 18 ring carbon atoms which is unsubstituted or substituted; a heteroaryl group having from 5 to 18 ring atoms which is unsubstituted or substituted; an alkyl group having from 1 to 20 carbon atoms which is unsubstituted or substituted; a cycloalkyl group having from 3 to 20, preferably 3 to 6 ring carbon atoms which is unsubstituted or substituted; halogen, CN; $SiR^{24}R^{25}R^{26}$, $SR^{21}$ or $OR^{20}$;

or

two adjacent substituents together form a ring structure which is in turn unsubstituted or substituted.

More preferably, the optional substituents each independently represents an aryl group having from 6 to 18 ring carbon atoms which is unsubstituted or substituted; a heteroaryl group having from 5 to 18 ring atoms which is unsubstituted or substituted; an alkyl group having from 1 to 20 carbon atoms which is unsubstituted or substituted; halogen, $SiR^{24}R^{25}R^{26}$ or CN;

or

two adjacent substituents together form a ring structure which is in turn unsubstituted or substituted.

Most preferably, the optional substituents each independently represents an alkyl group having 1 to 5 carbon atoms which is unsubstituted or substituted; an aryl group having 6 to 13 ring carbon atoms which is unsubstituted or substituted; a heteroaryl group having from 5 to 13 ring atoms which is unsubstituted or substituted; halogen, $SiR^{24}R^{25}R^{26}$ or CN.

$R^{20}$, $R^{21}$, $R^{22}$, $R^{23}$, $R^{24}$, $R^{25}$ and $R^{26}$ each independently represents an aryl group having from 6 to 30 ring carbon atoms which is unsubstituted or substituted; a heteroaryl group having from 5 to 30 ring atoms which is unsubstituted or substituted; or an alkyl group having from 1 to 20 carbon atoms which is unsubstituted or substituted.

The optional substituents mentioned above may be further substituted by one or more of the optional substituents mentioned above.

The number of the optional substituents depends on the group which is substituted by said substituent(s). The maximum number of possible substituents is defined by the number of hydrogen atoms present.

According to the present invention,

- at least one of $R^1$, $R^2$, $R^3$ and $R^4$, preferably at least one of $R^2$ and $R^3$, represents an alkyl group having from 1 to 20 carbon atoms which is unsubstituted or substituted or an amino group $NR^{84}R^{85}$,
- at least one of $R^5$, $R^6$, $R^7$ and $R^8$, preferably at least one of $R^6$ and $R^7$, represents an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure; and
- at least one of $Y_1$ and $Y_2$ is a group of formula (II).

The compound of formula (I) therefore mandatorily comprises at least 2 substituents (R), i.e. at least one of $R^1$, $R^2$, $R^3$ and $R^4$ as a first substituent, at least one of $R^5$, $R^6$, $R^7$ and $R^8$ as a second substituent and - in addition - at least one of $Y_1$ and $Y_2$ is a group of formula (II).

Preferably, the total number of substituents (R) in the compounds of formula (I) is 2, 3, 4, 5, 6, 7 or 8, preferably 3, 4, 5, or 6, i.e. the remaining substituents (R) are hydrogen.

Preferably, the substitution pattern of $R^1$, $R^2$, $R^3$ and $R^4$ is different from the substitution pattern of $R^5$, $R^6$, $R^7$ and $R^8$ and more preferably $-(L_1)_m-Y_1$ and $-(L_2)_n-Y_2$ are different. The compounds of formula (I) are therefore preferably not mirror-symmetrical.

The "carbon number of a to b" in the expression of "X group having a to b carbon atoms which is substituted or unsubstituted" is the carbon number of the unsubstituted X group and does not include the carbon atom(s) of an optional substituent.

The term "unsubstituted" referred to by "unsubstituted or substituted" means that a hydrogen atom is not substituted by one the substituents mentioned above.

An index of 0 in the definition in the formulae mentioned above and below means that a hydrogen atom is present at the position defined by said index.

Examples for ring structures formed by two adjacent substituents are shown below:

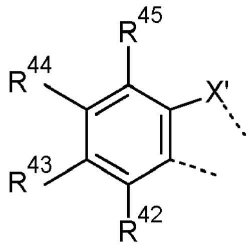

(A),

e.g.

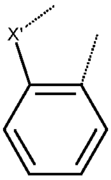

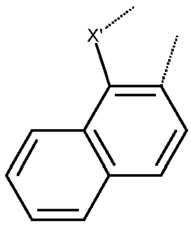

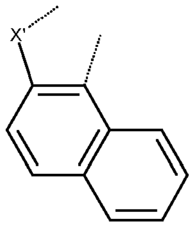

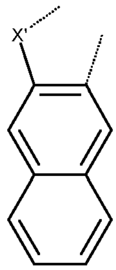

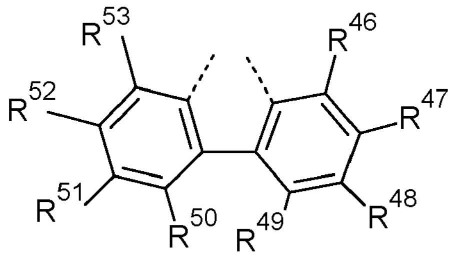

(B),

e.g.

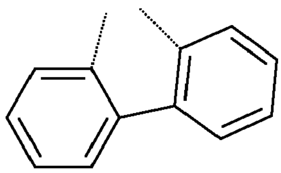

,

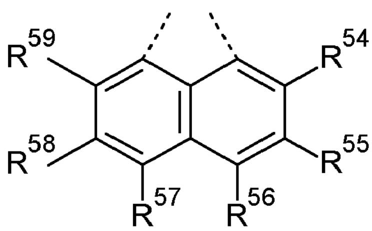

(C),

e.g.

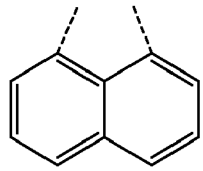,

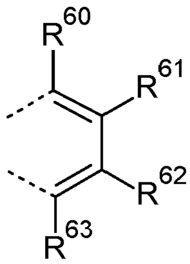 (D),

e.g.

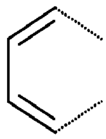, 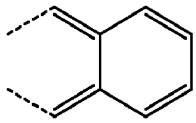,

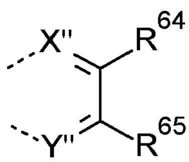 (Ea),

e.g.

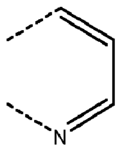, 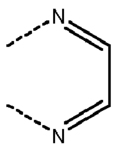,

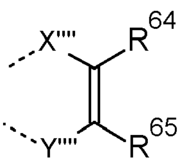 (Eb),

e.g.

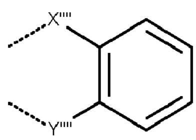,

like

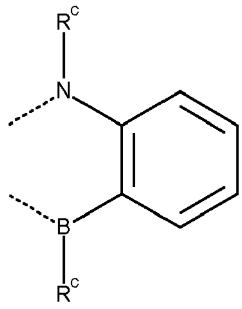

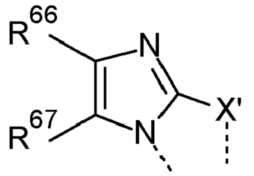

(F),

e.g.

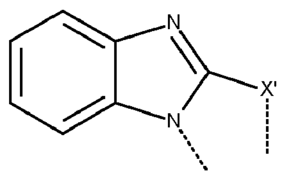

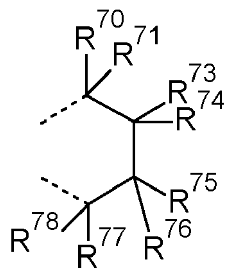

(G),

e.g.

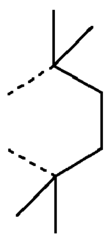

or

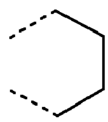

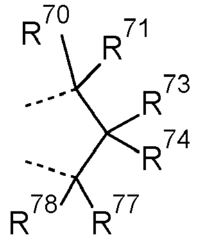

(H),

e.g.

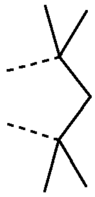
or
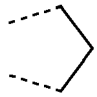

wherein

X' represents O, S or $CR^{68}R^{69}$;
$R^{42}$, $R^{43}$, $R^{44}$, $R^{45}$, $R^{46}$, $R^{47}$, $R^{48}$, $R^{49}$, $R^{50}$, $R^{51}$, $R^{52}$, $R^{53}$, $R^{54}$, $R^{55}$, $R^{56}$, $R^{57}$, $R^{58}$, $R^{59}$, $R^{60}$, $R^{61}$, $R^{62}$, $R^{63}$, $R^{64}$, $R^{65}$, $R^{66}$ and $R^{67}$, $R^{70}$, $R^{71}$, $R^{72}$, $R^{73}$, $R^{74}$, $R^{75}$, $R^{76}$, $R^{77}$ and $R^{78}$ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; or
two adjacent residues together form a ring structure which is unsubstituted or substituted,
wherein the dotted lines are bonding sites;
$R^{68}$ and $R^{69}$ each independently represents hydrogen; an aryl group having from 6 to 30 ring carbon atoms which is unsubstituted or substituted; a heteroaryl group having from 5 to 30 ring atoms which is unsubstituted or substituted or an alkyl group having from 1 to 20 carbon atoms which is unsubstituted or substituted;
or
$R^{68}$ and $R^{69}$ together form an aromatic ring structure having from 3 to 13 ring atoms which is unsubstituted or substituted or an aliphatic ring structure having from 3 to 9 ring atoms which is unsubstituted or substituted;
X" and Y" each independently represents $CR^c$, B or N,
X‴ and Y‴ each independently represents $CR^cR^d$, S, $BR^e$ or $NR^e$,
X⁗ and Y⁗ each independently represents S, $BR^e$ or $NR^e$,
$R^c$ and $R^d$ each independently represents $C_1$ to $C_8$ alkyl or substituted or unsubstituted $C_6$ to $C_{18}$ aryl, preferably $C_1$ to $C_4$ alkyl or substituted or unsubstituted $C_6$ to $C_{10}$ aryl, more preferably methyl or unsubstituted or substituted phenyl,
$R^e$ represents $C_1$ to $C_8$ alkyl, preferably $C_1$ to $C_4$ alkyl, or substituted or unsubstituted $C_6$ to $C_{10}$ aryl, preferably unsubstituted or substituted phenyl,
and
the dotted lines are bonding sites.

Preferred examples for ring structures formed by two adjacent substituents are the ring structures (A), (D), (G) and (H), more preferred ring structures formed by two adjacent substituents are

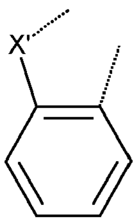
,
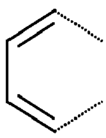
,
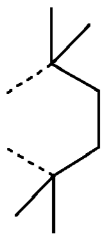
and
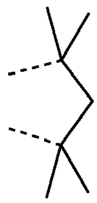

**The** compounds of formula (I)

In the compounds of formula (I):

- at least one of $R^1$, $R^2$, $R^3$ and $R^4$, preferably at least one of $R^2$ and $R^3$, represents an alkyl group having from 1 to 20 carbon atoms which is unsubstituted or substituted or an amino group $NR^{84}R^{85}$,
- at least one of $R^5$, $R^6$, $R^7$ and $R^8$, preferably at least one of $R^6$ and $R^7$, represents an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and

form a ring structure; and

- at least one of $Y_1$ and $Y_2$ is a group of formula (II).

In one embodiment, two adjacent residues of $R^1$, $R^2$, $R^3$, $R^4$, $R^5$, $R^6$, $R^7$ and $R^8$ in the compound of formula 1 do not form a ring structure of formula

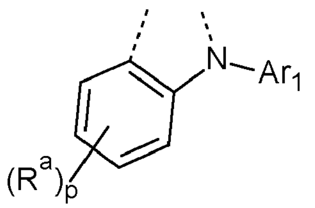

,

wherein $Ar_1$ is an aryl group having from 6 to 60 ring carbon atoms which is unsubstituted or substituted; and $R^a$ is defined as any one of $R^1$, $R^2$, $R^3$, $R^4$, $R^5$, $R^6$, $R^7$ and $R^8$ and p is 1, 2, 3 or 4.

In a further embodiment, two adjacent residues of $R^1$, $R^2$, $R^3$, $R^4$, $R^9$, $R^{10}$ and $R^{11}$ do not form a ring structure.

At least one of $R^1$, $R^2$, $R^3$ and $R^4$, preferably at least one of $R^2$ and $R^3$, represents an alkyl group having from 1 to 20 carbon atoms which is unsubstituted or substituted or an amino group $NR^{84}R^{85}$

Suitable and preferred alkyl groups having from 1 to 20 carbon atoms which are unsubstituted or substituted are mentioned above. Preferably, at least one of $R^1$, $R^2$, $R^3$ and $R^4$, preferably at least one of $R^2$ and $R^3$ represents an alkyl group having from 1 to 20 carbon atoms which is unsubstituted or substituted, more preferably an alkyl group having from 1 to 8 carbon atoms which is unsubstituted or substituted, most preferably an alkyl group having from 1 to 4 carbon atoms which is unsubstituted or substituted, further preferably, the alkyl group mentioned above is unsubstituted but it is linear or branched, further most preferably a methyl group, an i-propyl group or a t-butyl group.

Preferably, exactly one of $R^1$, $R^2$, $R^3$ and $R^4$, more preferably exactly one of $R^2$ and $R^3$ represents an alkyl group having from 1 to 20 carbon atoms which is unsubstituted or substituted or an amino group $NR^{84}R^{85}$. Preferred alkyl groups are mentioned above.

More preferably, one of $R^2$ and $R^3$ is hydrogen and the other one of $R^2$ and $R^3$ is an alkyl group having from 1 to 20 carbon atoms which is unsubstituted or substituted; or an amino group $NR^{84}R^{85}$.

In the amino group $NR^{84}R^{85}$:

Suitable and preferred residues $R^{84}$ and $R^{85}$ are defined above.

Preferably, the amino group $NR^{84}R^{85}$ is represented by the following formula $NAr_2Ar_3$, wherein

$Ar_2$ and $Ar_3$ each independently represents an aryl group having from 6 to 30 ring carbon atoms which is unsubstituted or substituted; a heteroaryl group having from 5 to 30 ring atoms which is unsubstituted or substituted, preferably, $Ar_2$ and $Ar_3$ each independently represents an aryl group having from 6 to 18 ring carbon atoms which is unsubstituted or substituted; a heteroaryl group having from 5 to 18 ring atoms which is unsubstituted or substituted.

More preferably, the the amino group $NAr_2Ar_3$ is represented by the following formula (III):

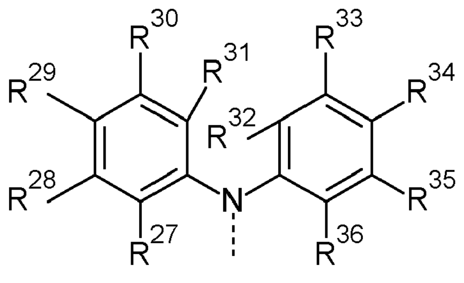

(III)

wherein

$R^{27}$, $R^{28}$, $R^{29}$, $R^{30}$, $R^{31}$, $R^{32}$, $R^{33}$, $R^{34}$, $R^{35}$ and $R^{36}$ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted, halogen, $SiR^{24}R^{25}R^{26}$ or CN;

or

two adjacent residues $R^{27}$, $R^{28}$, $R^{29}$, $R^{30}$ and $R^{31}$ and/or two adjacent residues $R^{32}$, $R^{33}$, $R^{34}$, $R^{35}$ and $R^{36}$ together form a ring structure which is unsubstituted or substituted,

preferably

$R^{27}$, $R^{28}$, $R^{29}$, $R^{30}$, $R^{31}$, $R^{32}$, $R^{33}$, $R^{34}$, $R^{35}$ and $R^{36}$ each independently represents hydrogen, an aryl group having from 6 to 10 ring carbon atoms which is unsubstituted or substituted,

or

two adjacent residues $R^{27}$, $R^{28}$, $R^{29}$, $R^{30}$ and $R^{31}$ and/or two adjacent residues $R^{32}$, $R^{33}$, $R^{34}$, $R^{35}$ and $R^{36}$ together form a ring structure of the following formula (A) or (D), preferably of the following formula (A)

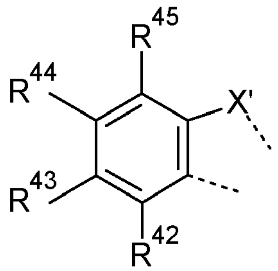 (A), 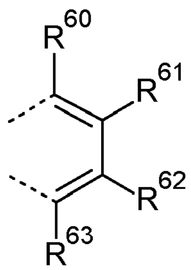 (D),

wherein

X' represents O, S or $CR^{68}R^{69}$, $NR^{86}$;

$R^{42}$, $R^{43}$, $R^{44}$, $R^{45}$, $R^{60}$, $R^{61}$, $R^{62}$ and $R^{63}$ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or halogen, $SiR^{24}R^{25}R^{26}$ or CN;

or

two adjacent residues together form a ring structure which is unsubstituted or substituted, wherein the dotted lines are bonding sites;

$R^{68}$ and $R^{69}$ each independently represents hydrogen; an aryl group having from 6 to 30 ring carbon atoms which is unsubstituted or substituted; a heteroaryl group having from 5 to 30 ring atoms which is unsubstituted or substituted or an alkyl group having from 1 to 20 carbon atoms which is unsubstituted or substituted;

or

$R^{68}$ and $R^{69}$ together form an aromatic ring structure having from 3 to 13 ring atoms which is unsubstituted or substituted or an aliphatic ring structure having from 3 to 9 ring atoms which is unsubstituted or substituted;

$R^{86}$ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted, preferably an aryl group having from 6 to 30 ring carbon atoms which is unsubstituted or substituted; a heteroaryl group having from 5 to 30 ring atoms which is unsubstituted or substituted or an alkyl group having from 1 to 20 carbon atoms which is unsubstituted or substituted.

Preferably, 0, 1 or 2 of $R^{27}$, $R^{28}$, $R^{29}$, $R^{30}$ and $R^{31}$ and/or 0, 1 or 2 of $R^{32}$, $R^{33}$, $R^{34}$, $R^{35}$ and $R^{36}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted, preferably an aryl group having from 6 to 10 ring carbon atoms which is unsubstituted or substituted or an alkyl group having from 1 to 4 carbon atoms,

or

two adjacent residues $R^{27}$, $R^{28}$, $R^{29}$, $R^{30}$ and $R^{31}$ and/or two adjacent residues $R^{32}$, $R^{33}$, $R^{34}$, $R^{35}$ and $R^{36}$ together form a ring structure which is unsubstituted or substituted, preferably a ring structure of the following formula (A) or (D), more preferably of the following formula (A)

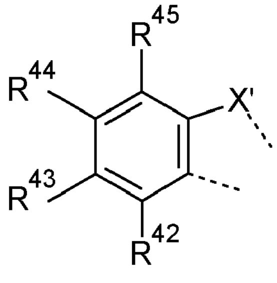 (A) , 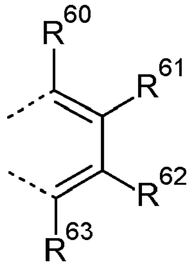 (D),

X' represents O, S or $CR^{68}R^{69}$, $NR^{86}$, preferably O;

$R^{42}$, $R^{43}$, $R^{44}$, $R^{45}$, $R^{60}$, $R^{61}$, $R^{62}$ and $R^{63}$ each independently represents hydrogen, an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; preferably hydrogen, an aryl group having from 6 to 13 ring carbon atoms which is unsubstituted or substituted; a heteroaryl group having from 5 to 13 ring atoms which is unsubstituted or substituted; an alkyl group having from 1 to 4 carbon atoms which is unsubstituted or substituted; more preferably, $R^{42}$, $R^{43}$, $R^{44}$ and $R^{45}$ are hydrogen; and

$R^{68}$ and $R^{69}$ each independently represents hydrogen; an aryl group having from 6 to 13 ring carbon atoms which is unsubstituted or substituted; a heteroaryl group having from 5 to 13 ring atoms which is unsubstituted or substituted or an alkyl group having from 1 to 4 carbon atoms which is unsubstituted or substituted;

$R^{86}$ represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted, preferably an aryl group having from 6 to 30 ring carbon atoms which is unsubstituted or substituted; a heteroaryl group having from 5 to 30 ring atoms which is unsubstituted or substituted or an alkyl group having from 1 to 20 carbon atoms which is unsubstituted or substituted;

and

the remaining residues of $R^{27}$, $R^{28}$, $R^{29}$, $R^{30}$, $R^{31}$, $R^{32}$, $R^{33}$, $R^{34}$, $R^{35}$ and $R^{36}$ are hydrogen, an aryl group having from 6 to 10 ring carbon atoms which is unsubstituted or substituted or an alkyl group having from 1 to 4 carbon atoms,

or

two adjacent residues $R^{27}$, $R^{28}$, $R^{29}$, $R^{30}$ and $R^{31}$ and/or two adjacent residues $R^{32}$, $R^{33}$, $R^{34}$, $R^{35}$ and $R^{36}$ together form a ring structure of the abovementioned formula (A) or (D), more preferably of the following formula (A).

More preferably, $R^{27}$, $R^{28}$, $R^{29}$, $R^{30}$, $R^{31}$, $R^{32}$, $R^{33}$, $R^{34}$, $R^{35}$ and $R^{36}$ are hydrogen, an aryl group having from 6 to 10 ring carbon atoms which is unsubstituted or substituted or an alkyl group having from 1 to 4 carbon atoms,

or

two adjacent residues $R^{27}$, $R^{28}$, $R^{29}$, $R^{30}$ and $R^{31}$ and/or two adjacent residues $R^{32}$, $R^{33}$, $R^{34}$, $R^{35}$ and $R^{36}$ together form a ring structure of the abovementioned formula (A) or (D), more preferably of the formula (A).

More preferably, the residues $R^1$, $R^2$, $R^3$ and $R^4$ which do not represent an alkyl group having from 1 to 20 carbon atoms which is unsubstituted or substituted or an amino group N $R^{84}R^{85}$ are hydrogen.

At least one of $R^5$, $R^6$, $R^7$ and $R^8$, preferably at least one of $R^6$ and $R^7$, represents an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure Suitable and preferred aryl groups having from 6 to 30 ring carbon atoms which are unsubstituted or substituted; and heteroaryl groups having from 5 to 30 ring atoms which are unsubstituted or substituted are mentioned above.

The meaning of the term "whereby the aryl group or the heteroaryl group may bind back to an adjacent residue" and form a ring structure is shown in the following:

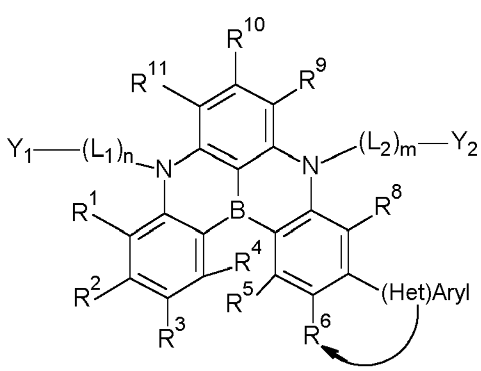

(Ia),

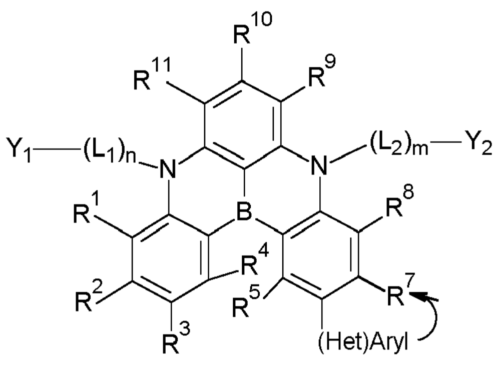

(Ib),

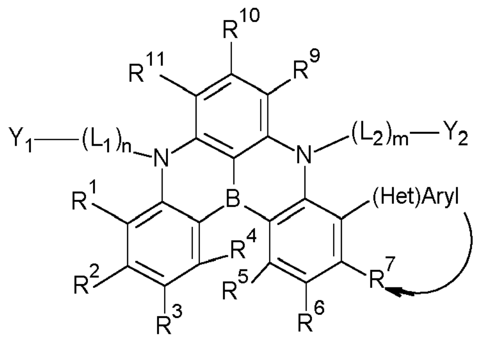

(Ic),

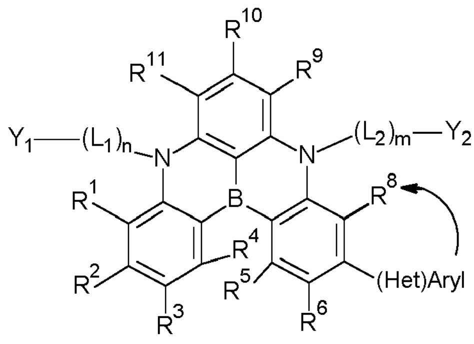

(Id),

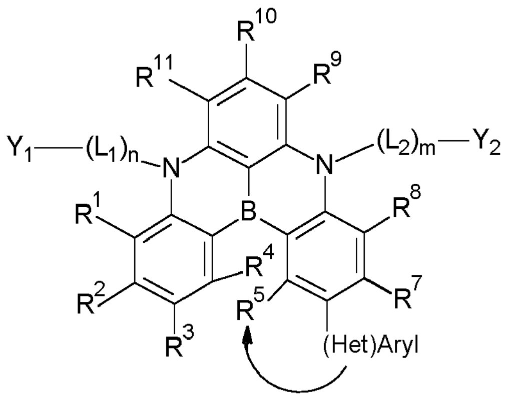

(Ie),

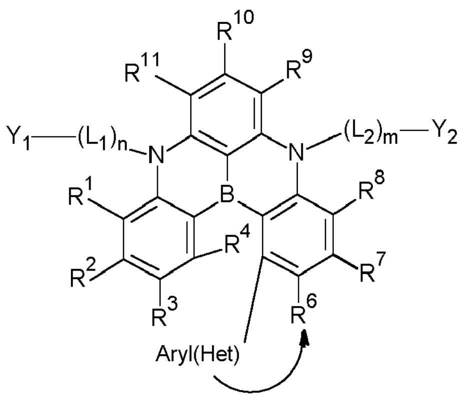

(If)

wherein (Het)Aryl represents an aryl group having from 6 to 30 ring carbon atoms which is unsubstituted or substituted; or a heteroaryl group having from 5 to 30 ring atoms which is unsubstituted or substituted and preferred aryl goups and heteroaryl groups are defined above;

and all othe residues, groups and indices in Formulae (Ia) to (If) are defined above and below for formula (I).

Preferred structures are Formulae (Ia) and (Ib).

Specific examples for the group

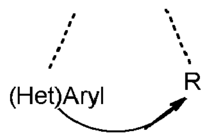

,

wherein R represents any one of $R^5$, $R^6$, $R^7$ and $R^8$, preferably $R^6$ or $R^7$ and the dotted lines are bonding sites, are ring structures (A), (B) and (C) mentioned above, preferably ring structure (A).

Preferably, one of $R^6$ and $R^7$ represents hydrogen; and the other one of $R^6$ and $R^7$ represents an aryl group having from 6 to 30 ring carbon atoms which is unsubstituted or substituted; or a heteroaryl group having from 5 to 30 ring atoms which is unsubstituted or substituted; or $R^6$ and $R^7$ together form a ring structure which is unsubstituted or substituted.

More preferably, the residues $R^5$, $R^6$, $R^7$ and $R^8$ which do not represent an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure are hydrogen.

At least one of $Y_1$ and $Y_2$ is a group of formula (II)

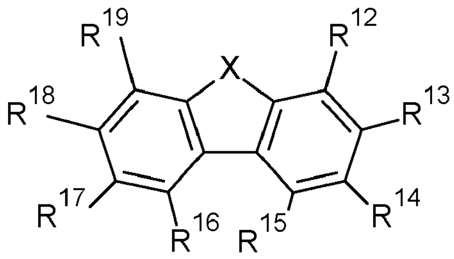

(II),

wherein

$R^{12}$, $R^{13}$, $R^{14}$, $R^{15}$, $R^{16}$, $R^{17}$, $R^{18}$ and $R^{19}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen;
or
two adjacent residues together form a ring structure which is unsubstituted or substituted;
one of $R^{12}$, $R^{13}$, $R^{14}$, $R^{15}$, $R^{16}$, $R^{17}$, $R^{18}$ and $R^{19}$ is a bonding site.

X is O, S or $CR^{35'}R^{36'}$.

Preferably, $R^{12}$, $R^{13}$, $R^{14}$, $R^{15}$, $R^{16}$, $R^{17}$, $R^{18}$ and $R^{19}$ each independently represents hydrogen; an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; or halogen; or

two adjacent residues together form a ring structure which is unsubstituted or substituted, wherein suitable and preferred ring structures are mentioned above;
one of $R^{12}$, $R^{13}$, $R^{14}$, $R^{15}$, $R^{16}$, $R^{17}$, $R^{18}$ and $R^{19}$ is a bonding site.

More preferably, $R^{12}$, $R^{13}$, $R^{14}$, $R^{15}$, $R^{16}$, $R^{17}$, $R^{18}$ and $R^{19}$ each independently represents hydrogen; an alkyl group having from 1 to 20 carbon atoms which is unsubstituted or substituted; or a cycloalkyl group having from 3 to 20 ring carbon atoms which is unsubstituted or substituted;
or

two adjacent residues together form a ring structure which is unsubstituted or substituted, wherein suitable and preferred ring structures are mentioned above;
one of $R^{12}$, $R^{13}$, $R^{14}$, $R^{15}$, $R^{16}$, $R^{17}$, $R^{18}$ and $R^{19}$ is a bonding site.

Most preferably, $R^{12}$, $R^{13}$, $R^{14}$, $R^{15}$, $R^{16}$, $R^{17}$, $R^{18}$ and $R^{19}$ each independently represents hydrogen; an alkyl group having from 1 to 20 carbon atoms which is unsubstituted or substituted; or a cycloalkyl group having from 3 to 20 ring carbon atoms which is unsubstituted or substituted; one of $R^{12}$, $R^{13}$, $R^{14}$, $R^{15}$, $R^{16}$, $R^{17}$, $R^{18}$ and $R^{19}$ is a bonding site.

Further most preferably, 0, 1 or 2 of $R^{12}$, $R^{13}$, $R^{14}$, $R^{15}$, $R^{16}$, $R^{17}$, $R^{18}$ and $R^{19}$ each independently represents hydrogen; an alkyl group having from 1 to 20 carbon atoms which is unsubstituted or substituted; or a cycloalkyl group having from 3 to 20 ring carbon atoms which is unsubstituted or substituted and the remaining residues are H;
one of $R^{12}$, $R^{13}$, $R^{14}$, $R^{15}$, $R^{16}$, $R^{17}$, $R^{18}$ and $R^{19}$ is a bonding site.

$R^{35'}$ and $R^{36'}$ each independently represents an alkyl group having from 1 to 20 carbon atoms which is unsubstituted or substituted; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; or
$R^{35'}$ and $R^{36'}$ together form an aromatic ring structure which is unsubstituted or substituted.

Preferably, $R^{35'}$ and $R^{36'}$ each independently represents an alkyl group having from 1 to 8 carbon atoms which is unsubstituted, more preferably an alkyl group having from 1 to 5 carbon atoms which is unsubstituted, most preferably methyl; or an aryl group having from 6 to 18 ring carbon atoms which is unsubstituted or substituted, preferably a phenyl

group which is unsubstituted or substituted; or a heteroaryl group having from 5 to 18 ring atoms which is unsubstituted or substituted.

Examples for suitable groups of formula (II) are:

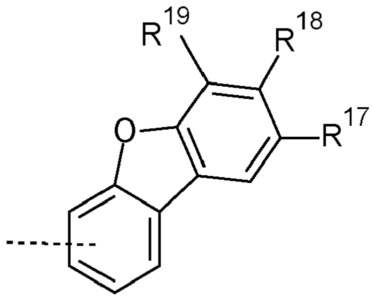
,
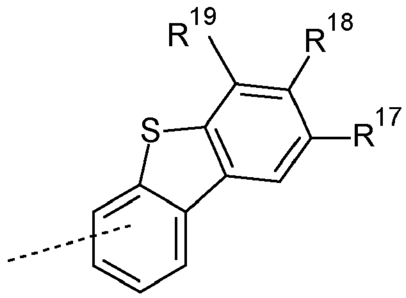
,
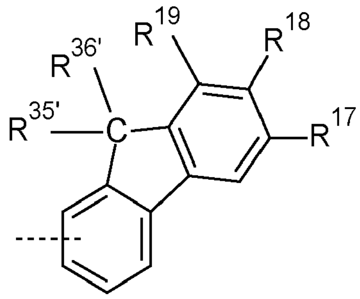

wherein

$R^{17}$, $R^{18}$, $R^{19}$, $R^{35'}$ and $R^{36'}$ are described above, and
the dotted line is a bonding site.

In a preferred embodiment, exactly one of $Y^1$ and $Y^2$ represents a group of formula (II). Preferred groups of formula (II) are mentioned above.

The remaining residues $R^1$, $R^2$, $R^3$, $R^4$, $R^5$, $R^6$, $R^7$, $R^8$, $R^9$, $R^{10}$ and $R^{11}$

The remaining residues $R^1$, $R^2$, $R^3$, $R^4$, $R^5$, $R^6$, $R^7$, $R^8$, $R^9$, $R^{10}$ and $R^{11}$, i.e. the groups which are not mandatorily defined as an alkyl group having from 1 to 20 carbon atoms which is unsubstituted or substituted or an amino group $NR^{84}R^{85}$ (at least one of $R^1$, $R^2$, $R^3$ and $R^4$, preferably at least one of $R^2$ and $R^3$), an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure (at least one of $R^5$, $R^6$, $R^7$ and $R^8$, preferably at least one of $R^6$ and $R^7$), and a group of formula (II) (at least one of $Y_1$ and $Y_2$),

each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen

or

two adjacent residues of $R^1$, $R^2$, $R^3$, $R^4$, $R^5$, $R^6$, $R^7$, $R^8$, $R^9$ and $R^{11}$ together form a ring structure which is unsubstituted or substituted;

Preferably, remaining residues $R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen;

or

two adjacent residues of $R^1$, $R^2$, $R^3$, $R^4$, $R^5$, $R^6$, $R^7$, $R^8$, $R^9$ and $R^{11}$ together form a ring structure which is unsubstituted or substituted.

More preferably, the remaining residues $R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; $OR^{20}$; or an amino group $NR^{84}R^{85}$.

More preferably, the residues $R^1$, $R^2$, $R^3$ and $R^4$ which do not represent an alkyl group having from 1 to 20 carbon atoms which is unsubstituted or substituted or an amino group N $R^{84}R^{85}$ and the residues $R^5$, $R^6$, $R^7$ and $R^8$ which do not represent an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure, are hydrogen.

Preferably, $R^1$, $R^4$, $R^5$ and $R^8$ represent hydrogen.

Preferably, at least one of $R^9$, $R^{10}$ and $R^{11}$, preferably $R^{10}$ represents an alkyl group having from 1 to 20 carbon atoms which is unsubstituted or substituted, or a cycloalkyl group having from 3 to 20 ring carbon atoms which is unsubstituted or substituted, an aryl group having from 6 to 30 ring carbon atoms which is unsubstituted or substituted; a heteroaryl group having from 5 to 30 ring atoms which is unsubstituted or substituted; $NR^{84}R^{85}$, or
$R^9$ and $R^{10}$ and/or $R^{10}$ and $R^{11}$ together form a ring structure which is unsubstituted or substituted, preferably an alkyl ring which is unsubstituted or substituted. Suitable ring structures are mentioned above. More preferably, the remaining residues $R^9$, $R^{10}$ and $R^{11}$, preferably $R^9$ and $R^{11}$ are hydrogen.

Further more preferably, $R^{10}$ is an alkyl group having from 1 to 20 carbon atoms which is unsubstituted or substituted; preferably an alkyl group having from 1 to 8 carbon atoms which is unsubstituted, more preferably an alkyl group having from 1 to 4 carbon atoms which is unsubstituted.

Preferred residues $R^1$, $R^2$, $R^3$, $R^4$, $R^5$, $R^6$, $R^7$, $R^8$, $R^9$ and $R^{11}$ are mentioned above.

**The remaining group $Y_1$ or $Y_2$**

The remaining group $Y_1$ or $Y_2$ which is not mandatorily a group of formula (II) represents $R^Y$ or a group of formula (II)

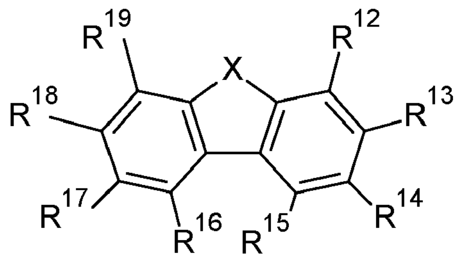

(II),

wherein the residues $R^{12}$ to $R^{19}$ and X are described above.

$R^Y$ represents an aryl group having from 6 to 30 ring carbon atoms which is unsubstituted or substituted, wherein the aryl group is not fused with a group of formula

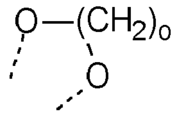

,

wherein o is 1, 2, 3 or 4 and the dotted lines are bonding sites; or a heteroaryl group having from 5 to 30 ring atoms which is unsubstituted or substituted; preferably, the aryl group is not fused with an aliphatic or heteroaliphatic group; more preferably, the aryl group and the heteroaryl group are not fused with an aliphatic or heteroaliphatic group.

Preferably, the remaining group $Y_1$ or $Y_2$ represents $R^Y$.

Preferably, $R^Y$ represents an unsubstituted or substituted phenyl group, unsubstituted or substituted naphthyl group, unsubstituted or substituted phenanthryl group, unsubstituted or substituted biphenyl group, unsubstituted or substituted terphenyl group, unsubstituted or substituted fluoranthenyl group, unsubstituted or substituted triphenylenyl group, unsubstituted or substituted phenanthrenyl group, unsubstituted or substituted fluorenyl group, unsubstituted or substituted indenyl group, unsubstituted or substituted anthracenyl, unsubstituted or substituted chrysenyl group, unsubstituted or substituted spirofluorenyl group or an unsubstituted or substituted benzo[c]phenanthrenyl group,

further more preferably an unsubstituted or substituted phenyl group, unsubstituted or substituted naphthyl group, unsubstituted or substituted biphenyl group, unsubstituted or substituted terphenyl group, unsubstituted or substituted phenanthryl group, unsubstituted or substituted triphenylenyl group, unsubstituted or substituted fluorenyl group, unsubstituted or substituted indenyl group or an unsubstituted or substituted fluoranthenyl group, and most preferably an unsubstituted or substituted phenyl group.

Suitable substituents for $R^Y$ are mentioned above.

Most preferred substituents are

an unsubstituted aryl group having from 6 to 18 ring carbon atoms;
an aryl group having from 6 to 18 ring carbon atoms substituted by an unsubstituted phenyl group, a phenyl group substituded by a C1-C4alkyl group or a C1-C4alkyl group;
an unsubstituted heteroaryl group having from 5 to 18 ring atoms; a unsubstituted heteroaryl group having from 5 to 18 ring atoms substituted by an unsubstituted phenyl group, a phenyl group substituded by a C1-C4alkyl group or a C1-C4alkyl group; or
an unsubstituted alkyl group having from 1 to 8 carbon atoms;
further most preferred substituents are
an unsubstituted phenyl group;
a phenyl group substituded by an unsubstituted phenyl group, a phenyl group substituded by a C1-C4alkyl group or a C1-C4alkyl group;
an unsubstituted heteroaryl group having from 5 or 6 ring atoms;
a heteroaryl group having from 5 or 6 ring atoms substituted by an unsubstituted phenyl group, a phenyl group substituded by a C1-C4alkyl group or a C1-C4alkyl group; or an unsubstituted alkyl group having from 1 to 4 carbon atoms.

The alkyl groups are linear or branched.

**$L_1$, $L_2$, m, n**

$L_1$ and $L_2$ each independently represents an unsubstituted or substituted aromatic group containing 6 to 30 ring atoms, wherein the aromatic group is not fused with a group of formula

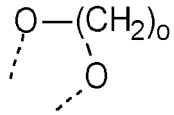

,

wherein o is 1, 2, 3 or 4 and the dotted lines are bonding sites; or an unsubstituted or substituted heteroaromatic group containing 5 to 30 ring atoms; preferably, the aromatic group is not fused with an aliphatic or heteroaliphatic group; more preferably, the aromatic group and the heteroaromatic group are not fused with an aliphatic or heteroaliphatic group.

Preferably, $L_1$ and $L_2$ each independently represents an unsubstituted or substituted aromatic group containing 6 to 18 ring atoms, wherein the aromatic group is not fused with a group of formula

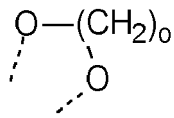

,

wherein o is 1, 2, 3 or 4 and the dotted lines are bonding sites; or an unsubstituted or substituted heteroaromatic group containing 5 to 18 ring atoms; preferably, the aromatic group is not fused with an aliphatic or heteroaliphatic group; more preferably, the aromatic group and the heteroaromatic group are not fused with an aliphatic or heteroaliphatic group.

More preferably, $L_1$ and $L_2$ each independently represents a phenylene group which is unsubstituted or substituted, a naphthyl group which is unsubstituted or substituted, an anthryl group which is unsubstituted or substituted, a phenanthryl group which is unsubstituted or substituted, a triphenylenyl group which is unsubstituted or substituted, a 9,9-dimethyl fluorene group which is unsubstituted or substituted, a 9,9-diphenyl fluorene group which is unsubstituted or substituted.

Most preferably, $L_1$ and $L_2$ each independently represents an unsubstituted or substituted phenylene group, an unsubstituted or substituted naphthyl group, an unsubstituted or substituted anthryl, an unsubstituted or substituted phenanthryl group, an unsubstituted or substituted triphenylenyl group, an unsubstituted or substituted 9,9-dimethyl fluorene group, an unsubstituted or substituted 9,9-diphenyl fluorene group; or an unsubstituted or substituted heteroaryl group having 5 or 6 ring atoms.

Further most preferably, $L_1$ and $L_2$ each independently represents an unsubstituted or substituted phenylene group, e.g. an unsubstituted or substituted 1,2-phenylene group, an unsubstituted or substituted 1,3-phenylene group or

an unsubstituted or substituted 1,4-phenylene group.

Suitable substituents for $L_1$ and $L_2$ are mentioned above.

Most preferred substituents are

an unsubstituted aryl group having from 6 to 18 ring carbon atoms;
an aryl group having from 6 to 18 ring carbon atoms substituted by an unsubstituted phenyl group, a phenyl group substituded by a C1-C4alkyl group or a C1-C4alkyl group;
an unsubstituted heteroaryl group having from 5 to 18 ring atoms; a unsubstituted heteroaryl group having from 5 to 18 ring atoms substituted by an unsubstituted phenyl group, a phenyl group substituded by a C1-C4alkyl group or a C1-C4alkyl group; or
an unsubstituted alkyl group having from 1 to 8 carbon atoms;
further most preferred substituents are
an unsubstituted phenyl group;
a phenyl group substituted by an unsubstituted phenyl group, a phenyl group substituded by a C1-C4alkyl group or a C1-C4alkyl group;
an unsubstituted heteroaryl group having from 5 or 6 ring atoms;
a heteroaryl group having from 5 or 6 ring atoms substituted by an unsubstituted phenyl group, a phenyl group substituded by a C1-C4alkyl group or a C1-C4alkyl group; or an unsubstituted alkyl group having from 1 to 4 carbon atoms.

The alkyl groups are linear or branched.

Even further most preferably, $L_1$ and $L_2$ each independently represents an unsubstituted or substituted phenylene group.

n and m are each independently 0, 1, 2 or 3; preferably 0, 1 or 2, more preferably 0 or 1; wherein in the case that $Y_1$ is a group of formula (II) and X is O or S, n is 1, 2 or 3, preferably 1 or 2, more preferably 1;
and/or
wherein in the case that $Y_2$ is a group of formula (II) and X is O or S, m is 1, 2 or 3, preferably 1 or 2, more preferably 1.

In the case that m represents 0, there is a direct bond between N and $Y^2$. In the case that n represents 0, there is a direct bond between N and $Y^1$.

In the case that n is 1 and m is 1 respectively, $L_1$ and $L_2$ each independently preferably represents a group of the following formula:

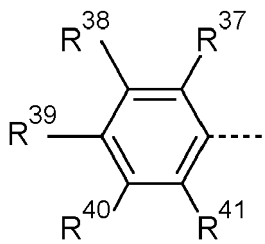

wherein

$R^{37}$, $R^{38}$, $R^{39}$, $R^{40}$ and $R^{41}$
each independently represents hydrogen; an aryl group having from 6 to 30 preferably from 6 to 18 ring carbon atoms which is in turn unsubstituted or substituted, a heteroaryl group having from 5 to 30, preferably 5 to 18 ring atoms which is in turn unsubstituted or substituted, an alkyl group having 1 to 20, preferably 1 to 8 carbon atoms, a group $OR^{20}$, an alkylhalide group having 1 to 20, preferably 1 to 8 carbon atoms, a cycloalkyl group having from 3 to 20, preferably 3 to 6 ring carbon atoms which is unsubstituted or substituted, an aralkyl group having from 7 to 30 carbon atoms which is unsubstituted or substituted, a halogen atom (fluorine, chlorine, bromine, iodine), CN, $C(=O)R^{22}$, $COOR^{23}$, a silyl group $SiR^{24}R^{25}R^{26}$, a group $SR^{21}$, $NO_2$ and $NR^{84}R^{85}$;
or
two adjacent substituents together form a ring structure which is in turn unsubstituted or substituted; wherein the ring structure is not formed by a group of formula

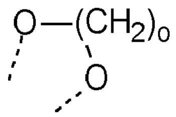

,

wherein o is 1, 2, 3 or 4 and the dotted lines are bonding sites; or an unsubstituted or substituted heteroaromatic group containing 5 to 18 ring atoms; preferably, the the ring structure is not formed by an aliphatic or heteroaliphatic group; $R^{20}$, $R^{21}$, $R^{22}$, $R^{23}$, $R^{24}$, $R^{25}$, $R^{26}$, $R^{84}$ and $R^{85}$ are defined above;

wherein

one of $R^{37}$, $R^{38}$, $R^{39}$, $R^{40}$ and $R^{41}$, preferably $R^{39}$ or $R^{40}$, more preferably $R^{39}$ is a bonding site to $Y^1$ or $Y^2$, respectively; and the dotted line is a bonding site.

In the case that n is 2 or 3 and m is 2 or 3, the groups $L_1$ and the groups $L_2$ respectively may be the same or different. In this case, the group $-(L_1)_n-$ can be described as $-L_{11}-L_{12}-$ in the case of n = 2 and $-L_{11}-L_{12}-L_{13}-$ in the case of n = 3; and the group $-(L_2)_m-$ can be described as $-L_{21}-L_{22}-$ in the case of n = 2 and $-L_{21}-L_{22}-L_{23}-$ in the case of n = 3.

In this case (n = 2 or 3), $L_{11}$ and $L_{21}$ respectively are the group farthest from N and $L_{12}$ and $L_{22}$ respectively (in the case of n = 2) or $L_{13}$ and $L_{23}$ respectively (in the case of n = 3) respectively are the groups closest to N.

$L_{11}$, $L_{12}$ and $L_{13}$ and $L_{21}$, $L_{22}$ and $L_{23}$ are defined in the same way as $L_1$ and $L_2$.

Preferably, m and n are each independently 0 or 1,

wherein in the case that $Y_1$ is a group of formula (II) and X is O or S, n is 1;

and/or

wherein in the case that $Y_2$ is a group of formula (II) and X is O or S, m is 1.

Examples for groups $Y^1-(L_1)_n-$ and $Y^2-(L_2)_m-$ respectively, wherein $Y^1$ and/or $Y^2$ are a group of formula (II) are each independently

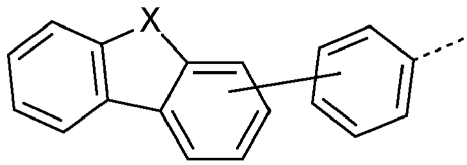

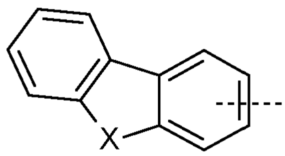

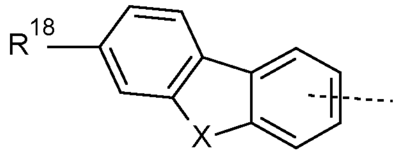

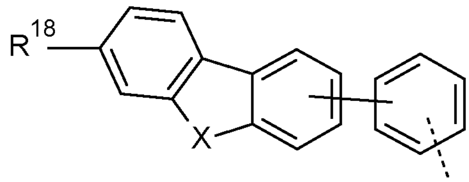

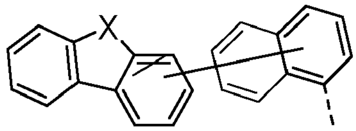

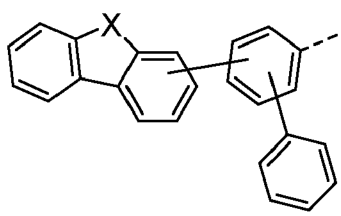

wherein the residues and groups $R^{18}$ and X are described above and below. Preferably, exactly one group $Y^1$ or $Y^2$ is a group of formula (II).

Examples for groups $Y^1-(L_1)_n-$ and $Y^2-(L_2)_m-$ respectively, wherein $Y^1$ or $Y^2$ are a residue $R^Y$ are

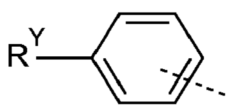

,

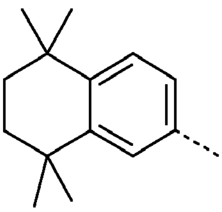 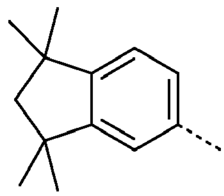 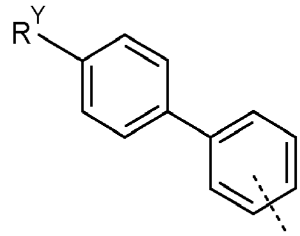 ,

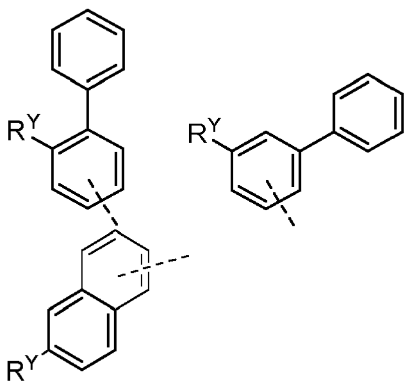 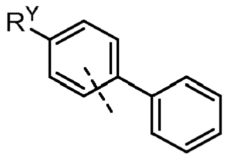 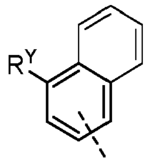 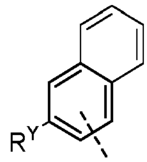 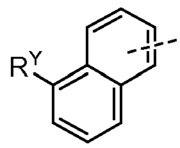

more preferred examples are:

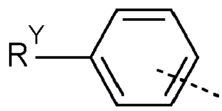 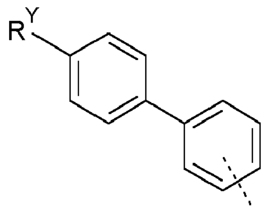

wherein the residue $R^Y$ is described above and below.

More preferred groups $Y^1$-$(L_1)_n$- and $Y^2$-$(L_2)_m$- respectively, wherein $Y^1$ and/or $Y^2$ are a group of formula (II) are each independently

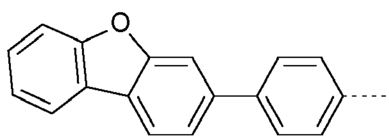 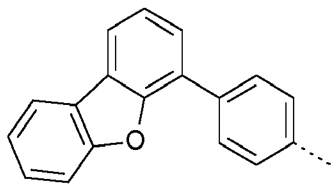

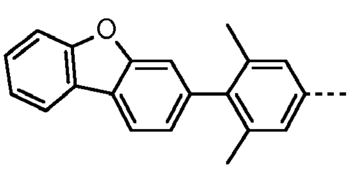 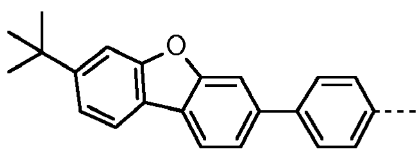

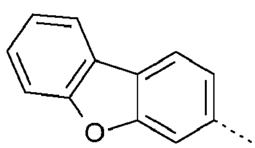

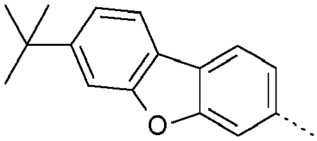
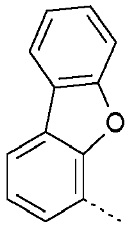
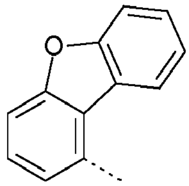
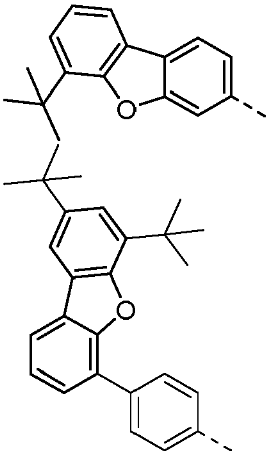
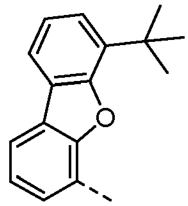
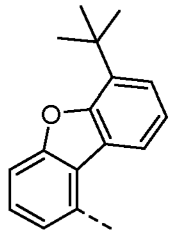
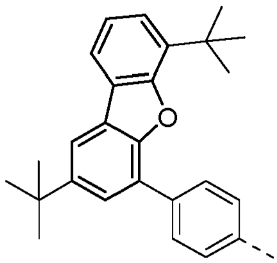
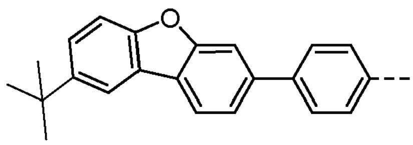
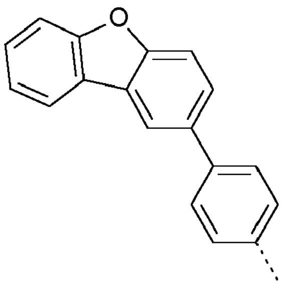
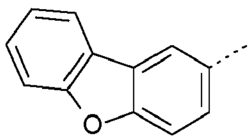
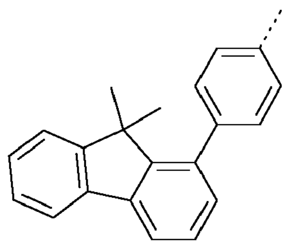
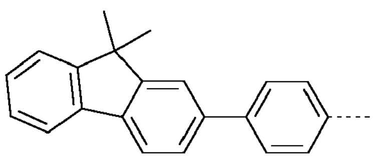
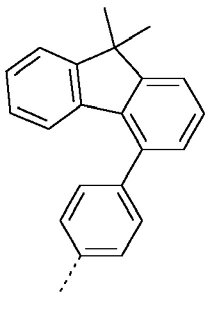
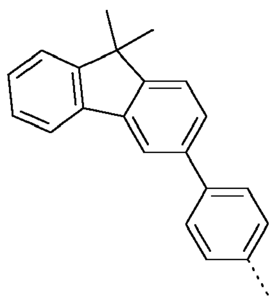

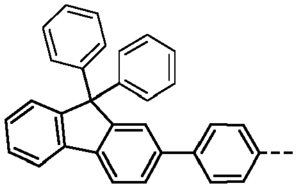
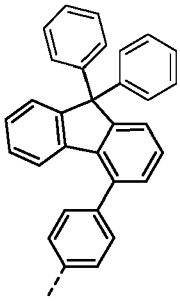
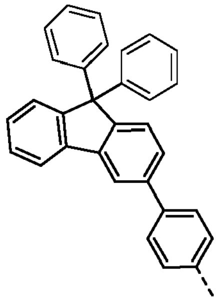

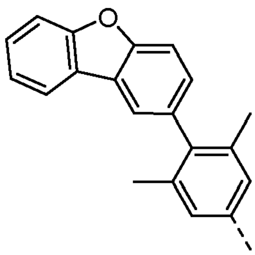
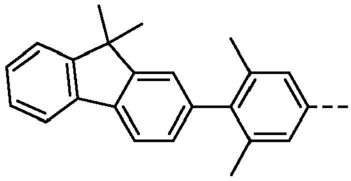
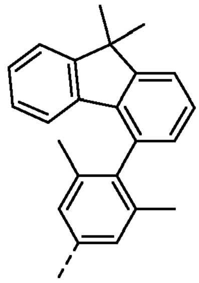

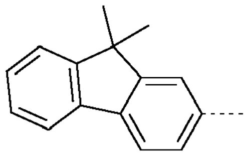
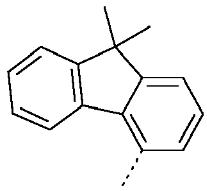
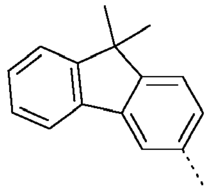
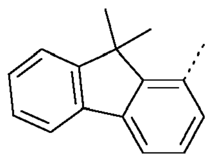

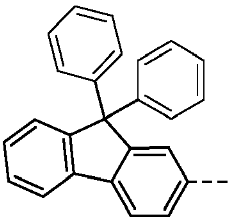
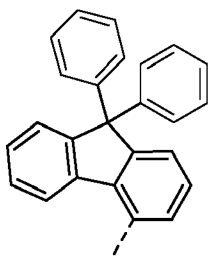
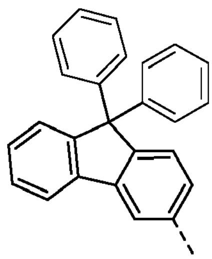

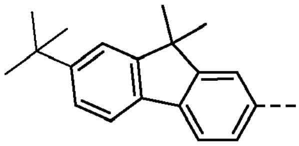
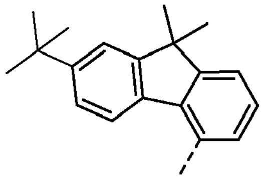
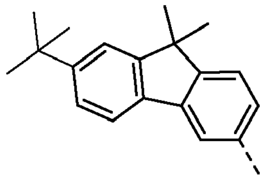
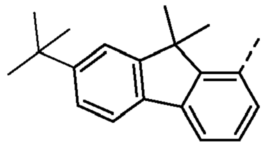

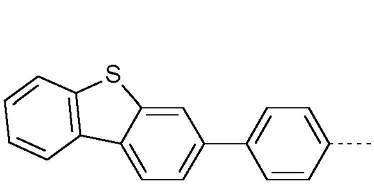
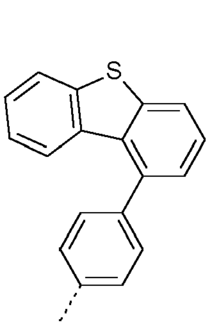
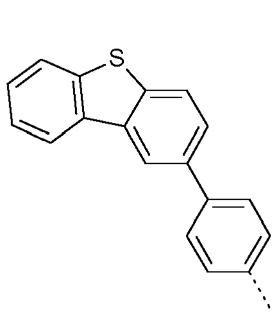

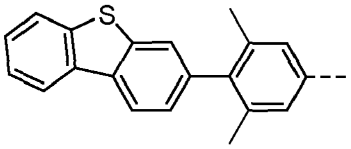
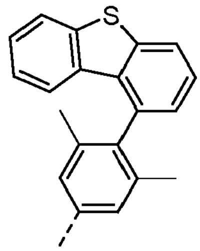
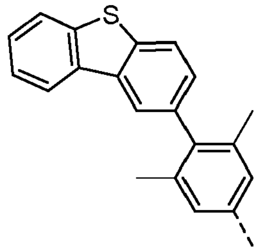

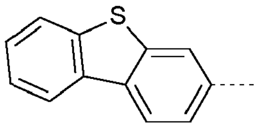
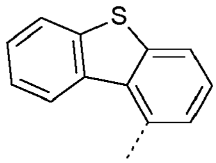
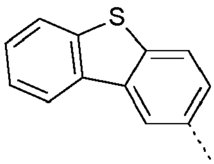
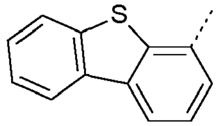

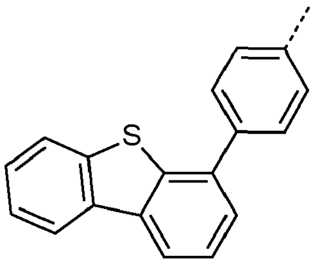

Preferably, exactly one group $Y^1$ or $Y^2$ is a group of formula (II).

Preferred groups $Y^1$-$(L_1)_n$- and $Y^2$-$(L_2)_m$- respectively, wherein $Y^1$ or $Y_2$ are a residue $R^Y$ are

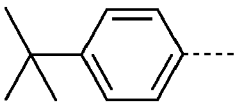
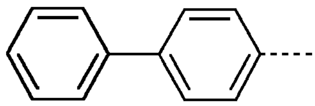
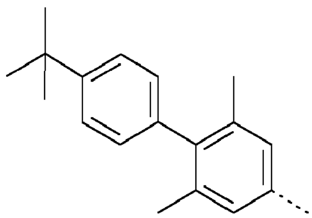

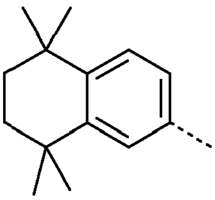
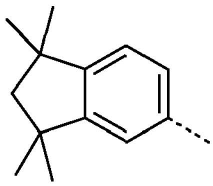
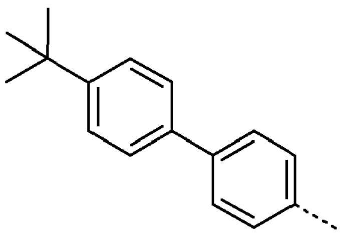

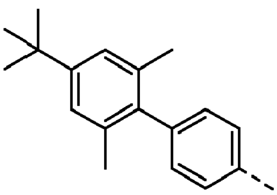
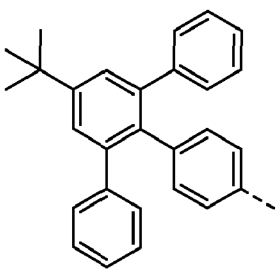
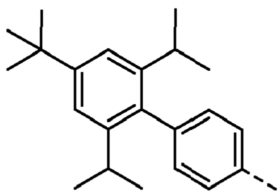

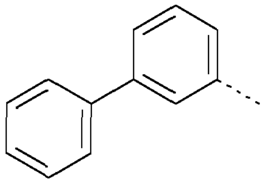 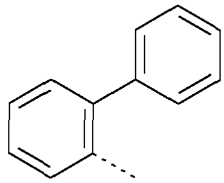

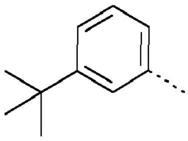 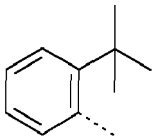 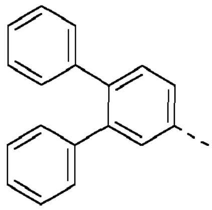 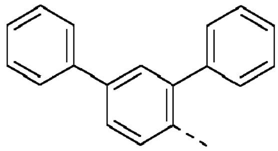 , 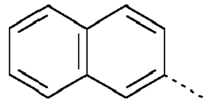 ,

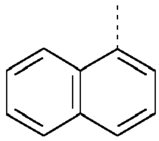 , 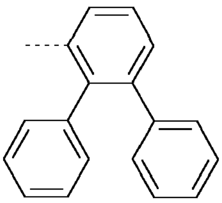 , 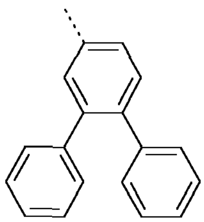 , 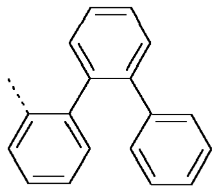 , 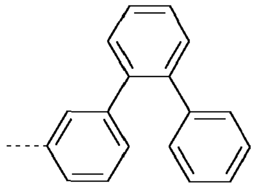 ,

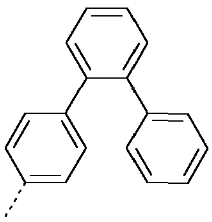 , 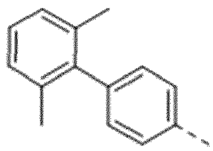 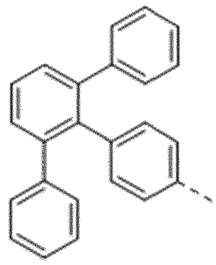 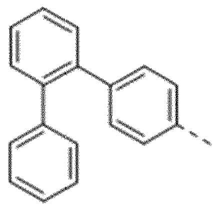

,

More preferred groups $Y^L(L_1)_n$- and $Y^2$-$(L_2)_m$- respectively, wherein $Y^1$ or $Y_2$ are a residue $R^Y$ are

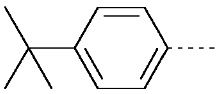 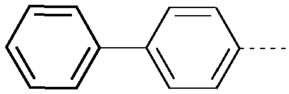

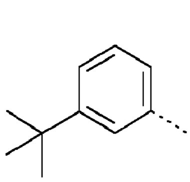 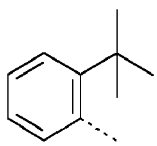

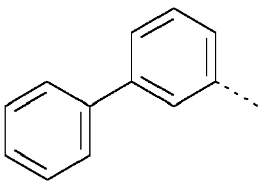 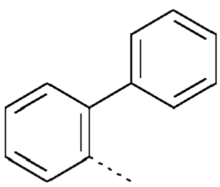 , 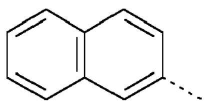 , 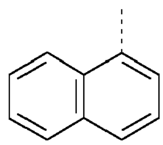 ,

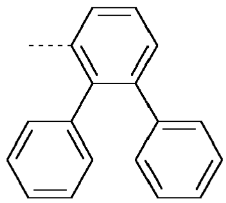 , 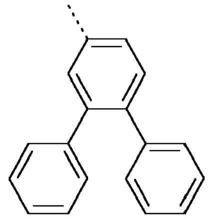 , 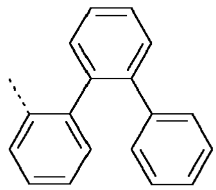 , 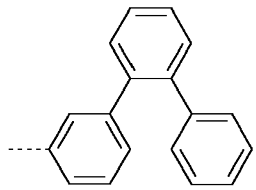 ,

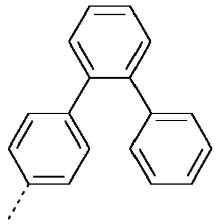 , 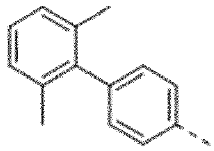 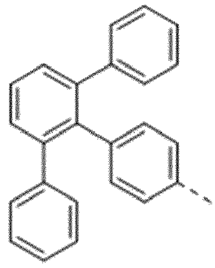 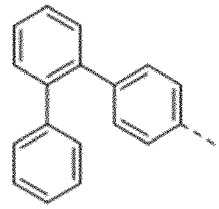

Preferred compounds of formula (I) are shown in the following, wherein the residues and groups and indices are defined above:

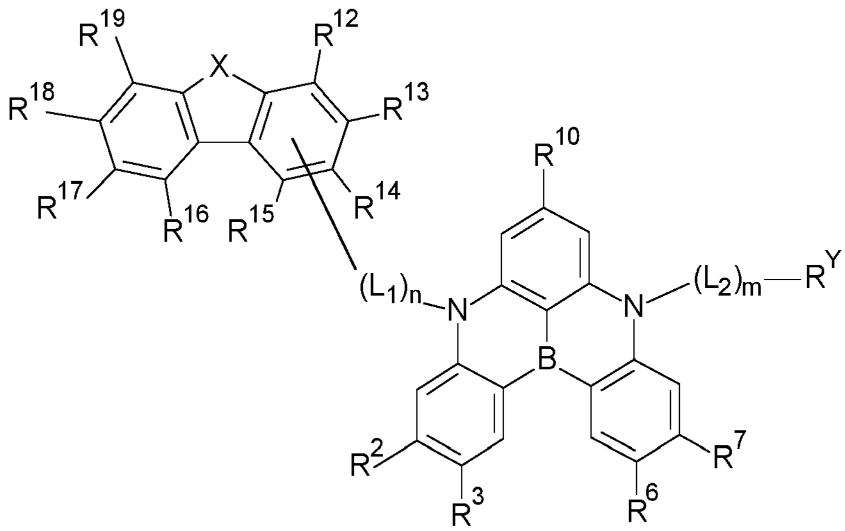

(IA)

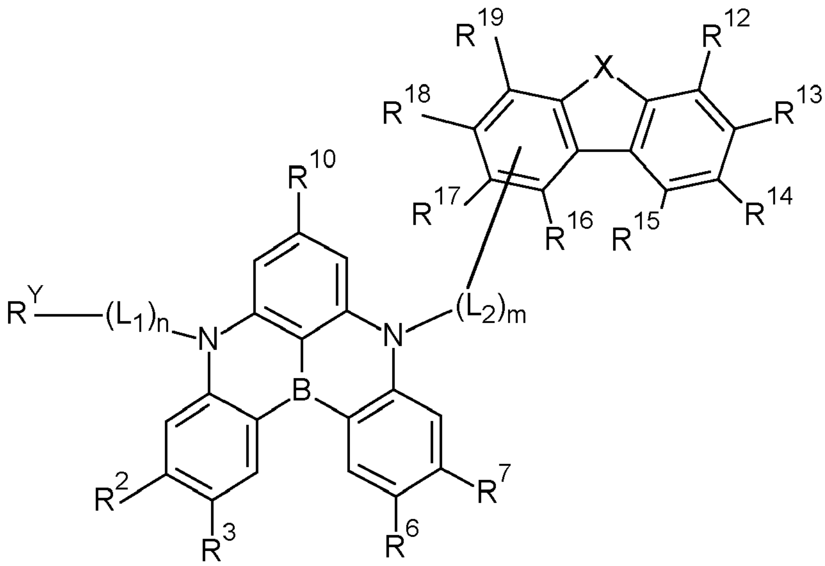

(IB)

Preferably, $L_1$ and $L_2$ in the compounds of formula (IA) and (IB) represent a phenylene group which is unsubstituted or substituted, and m and n are each independently 0 or 1,

wherein in the case that in formula (IA) X is O or S, n is 1;
and/or
wherein in the case that in formula (IB) X is O or S, m is 1.

More preferably, in the compounds of formula (IA) and (IB):

$R^2$ or $R^3$ represents an alkyl group having from 1 to 20 carbon atoms which is unsubstituted or substituted or an amino group $NR^{84}R^{85}$; and the remaining residue of $R^2$ and $R^3$ represents hydrogen;
$R^6$ or $R^7$ represents an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to the remaining residue $R^6$ or $R^7$ and form a ring structure; and - in the case that the aryl group or the heteroaryl group does not bind back to the remaining residue $R^6$ or $R^7$, the remaining residue of $R^6$ or $R^7$ represents hydrogen;
$R^{10}$ represents hydrogen, an alkyl group having from 1 to 20 carbon atoms which is unsubstituted or substituted, or $NR^{84}R^{85}$;
$R^Y$ represents an unsubstituted or substituted phenyl group, unsubstituted or substituted naphthyl group, unsubstituted or substituted biphenyl group, unsubstituted or substituted terphenyl group, unsubstituted or substituted phenanthryl group, unsubstituted or substituted triphenylenyl group, unsubstituted or substituted fluorenyl group, unsubstituted or substituted indenyl group or an unsubstituted or substituted fluoranthenyl group; preferably an unsubstituted or substituted phenyl group;
$R^{84}$ and $R^{85}$ each independently represents an aryl group having from 6 to 30 ring carbon atoms which is unsubstituted or substituted; a heteroaryl group having from 5 to 30 ring atoms which is unsubstituted or substituted;
$L_1$ and $L_2$ each independently represents a phenylene group which is unsubstituted or substituted, preferably unsubstituted 1,4-phenylene; and
n and m are each independently 0 or 1,
wherein in the case that in formula (IA) X is O or S, n is 1;
and/or
wherein in the case that in formula (IB) X is O or S, m is 1;
the residues $R^{12}$ to $R^{19}$ as well as preferred residues $R^2$, $R^3$, $R^6$, $R^7$, $R^{10}$, $R^Y$, $R^{84}$ and $R^{85}$ and preferred groups $L_1$ and $L_2$ are defined above and below.

Below, examples for compounds of formula (I) are given:

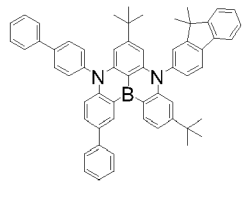
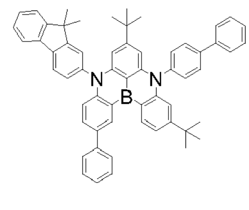
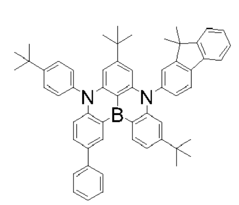
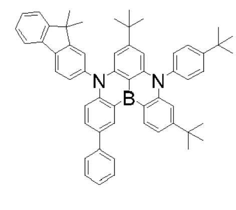

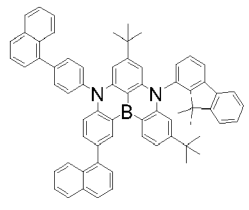
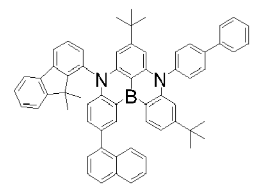
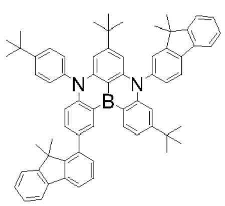
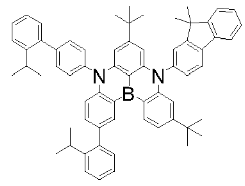

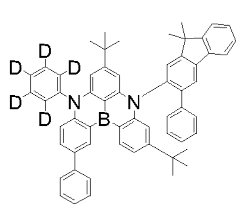
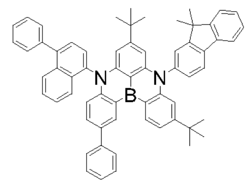
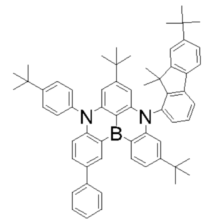
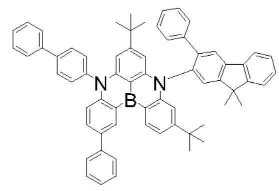

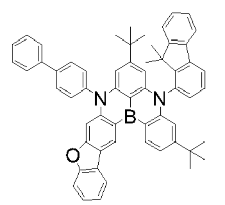
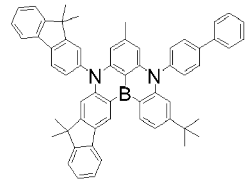
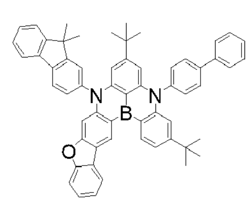
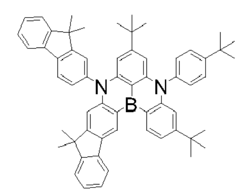

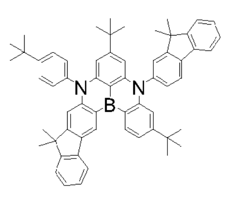
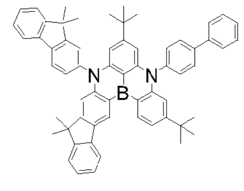
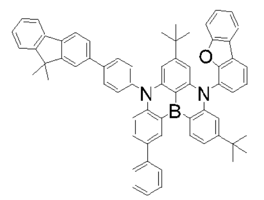
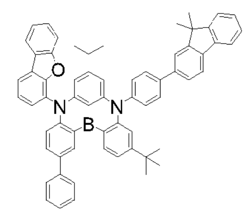

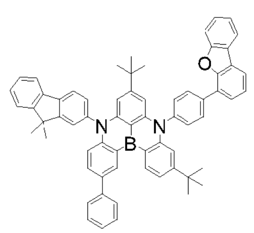
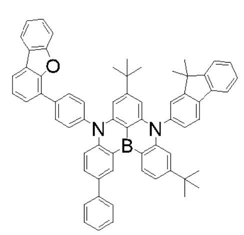
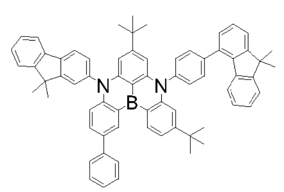
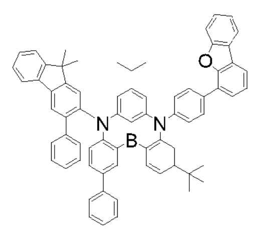

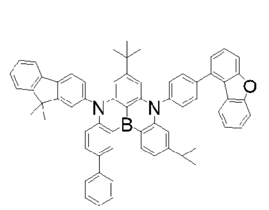
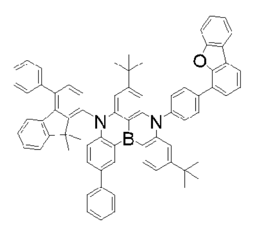
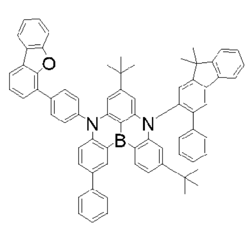
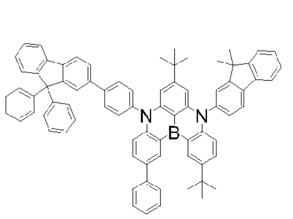

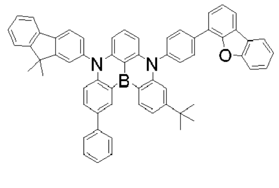
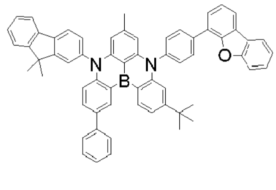
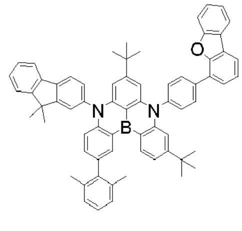
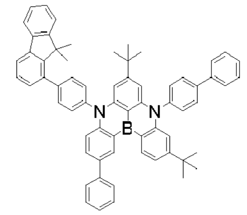
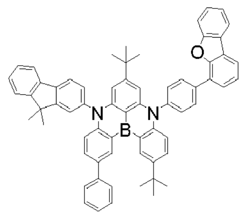
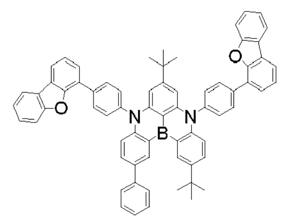
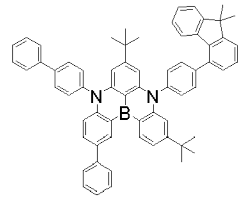
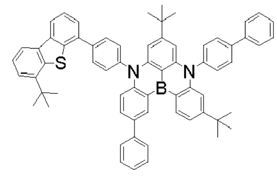
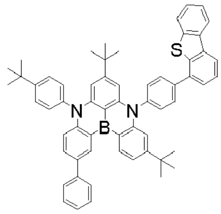
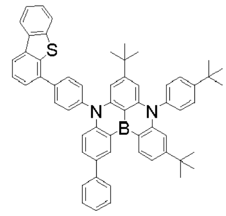
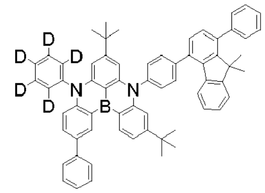
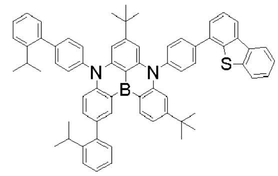
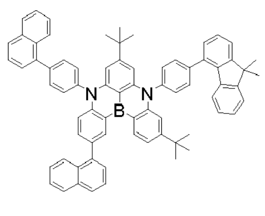
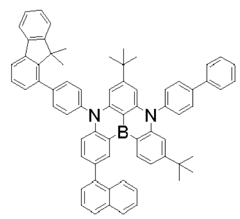
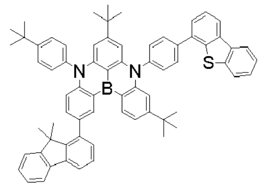
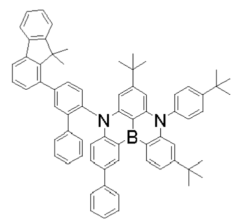
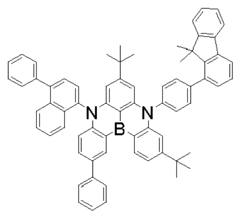
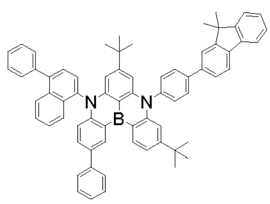
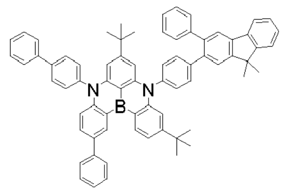
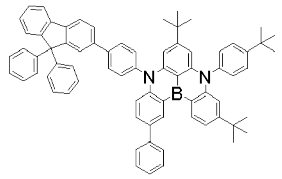

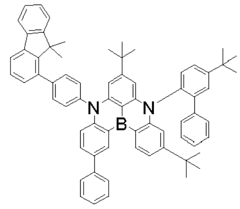
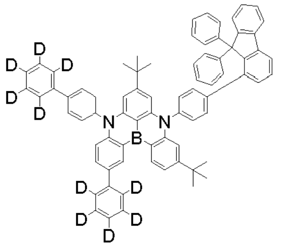
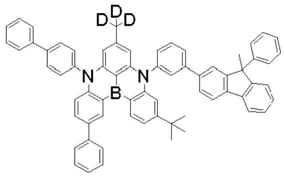
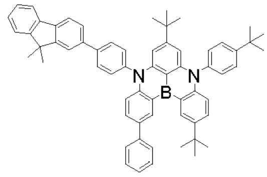
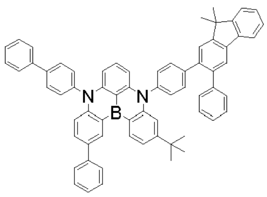
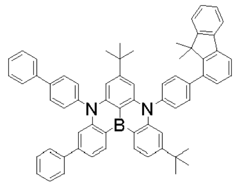
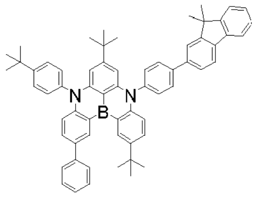
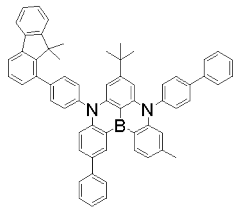
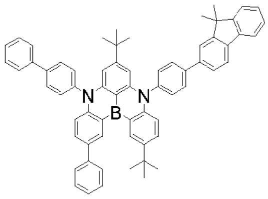
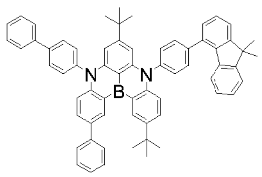
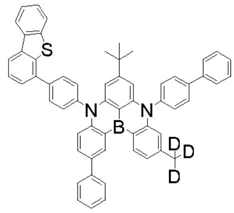
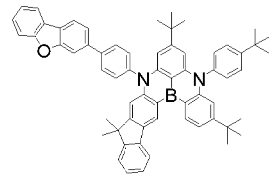
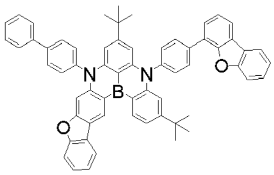
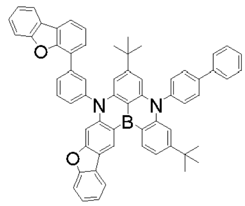
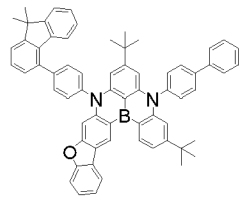
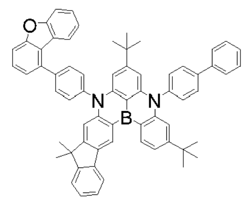
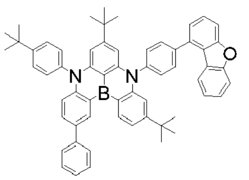
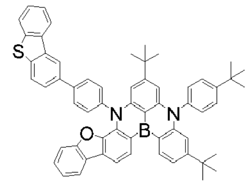
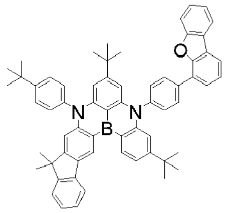
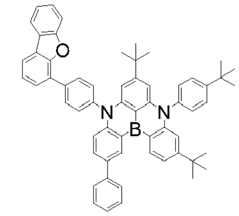
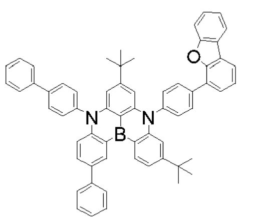
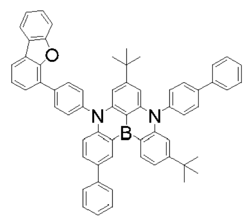
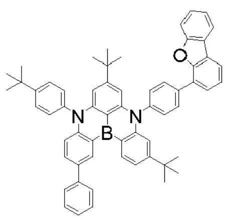
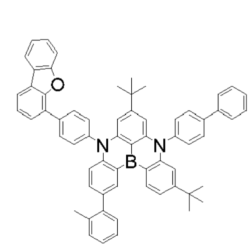

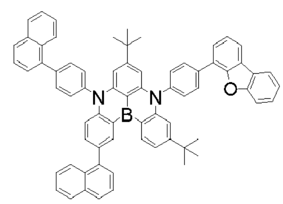
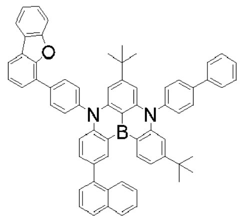
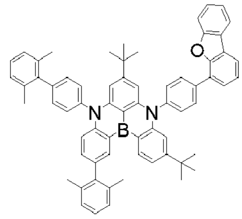
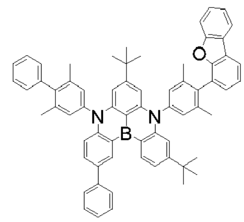
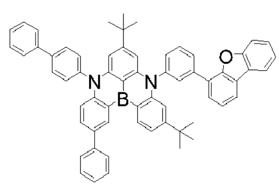
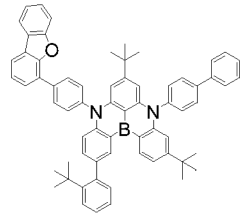
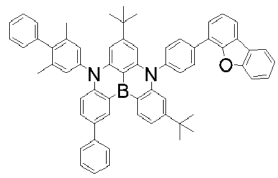
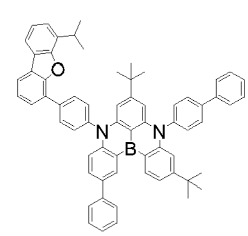
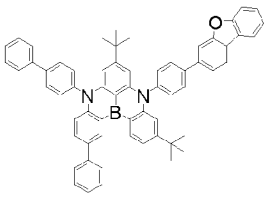
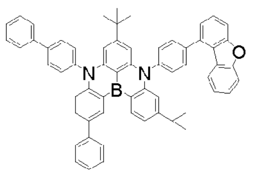
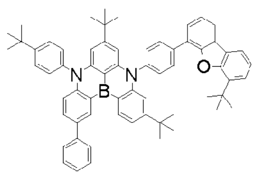
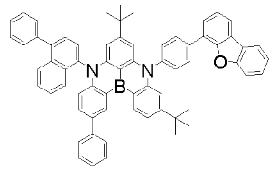
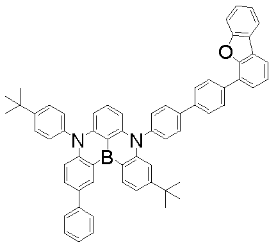
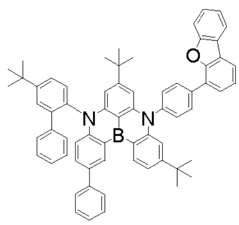
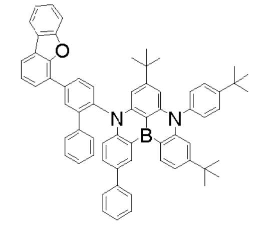
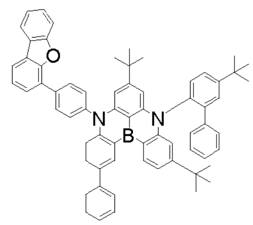
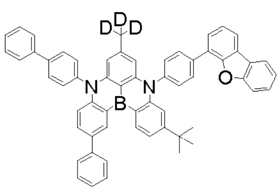
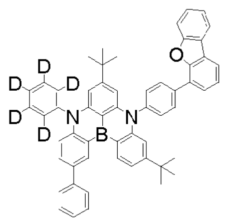
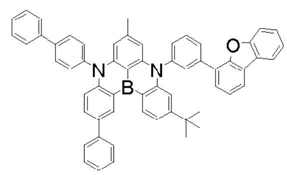
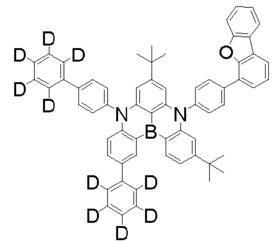
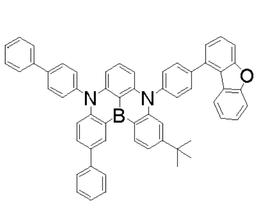
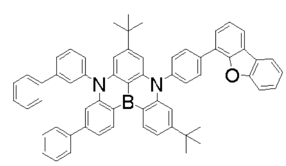
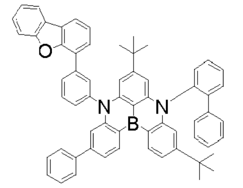
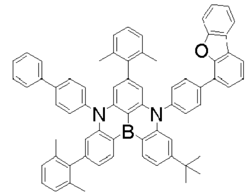

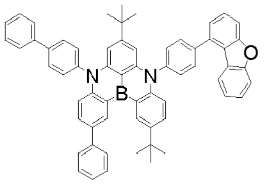
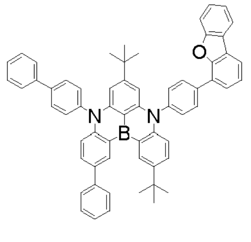
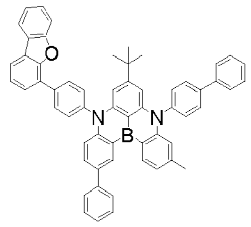
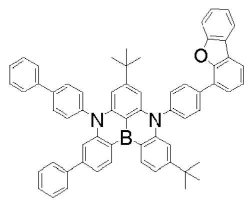

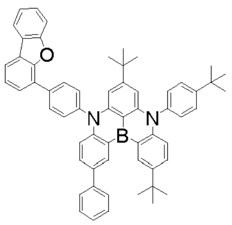
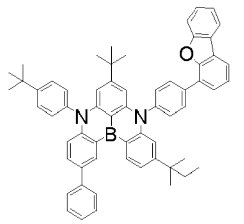
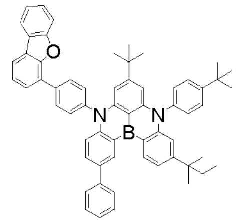
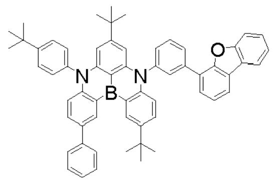

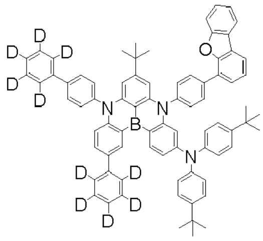
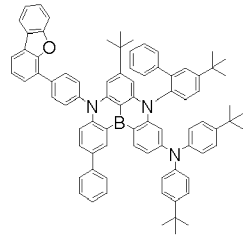
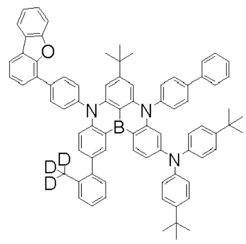
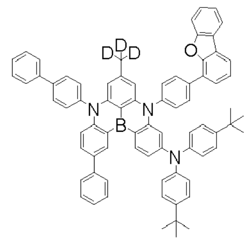

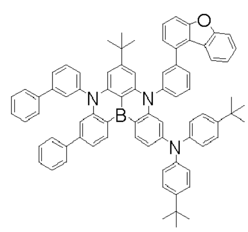
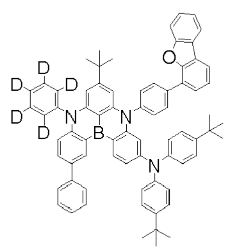
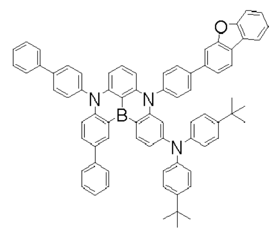
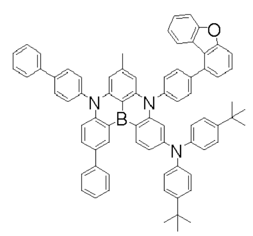

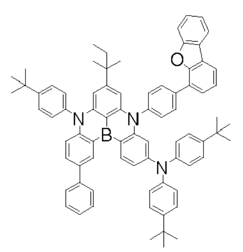
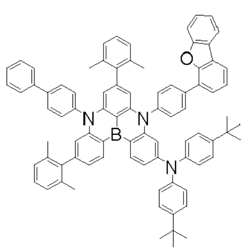
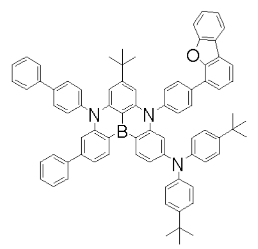
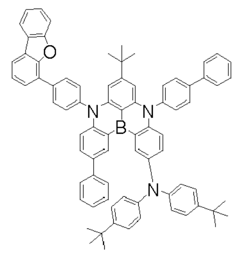

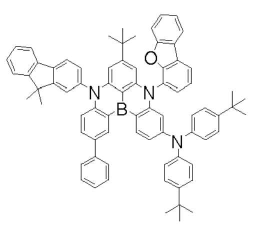
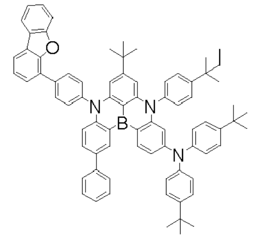
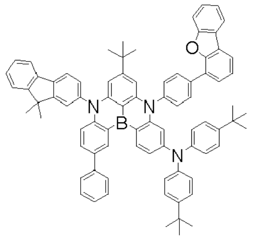
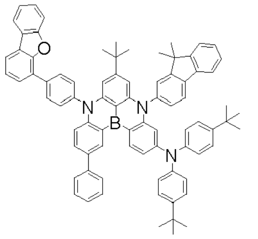

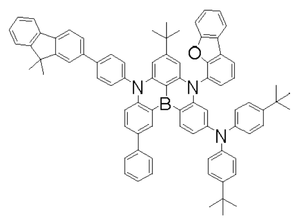
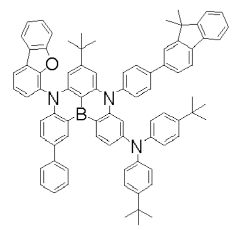
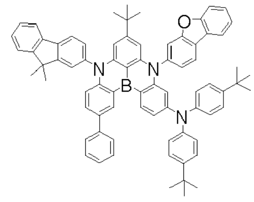
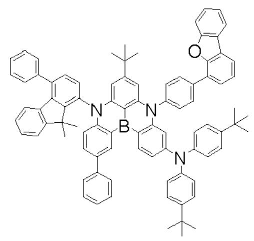
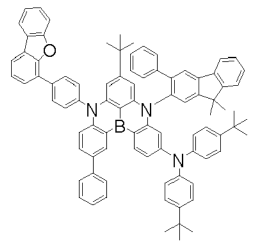
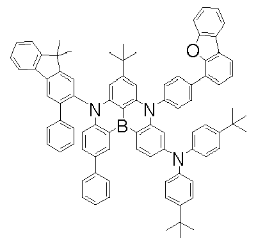
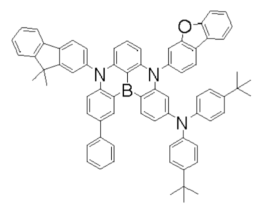
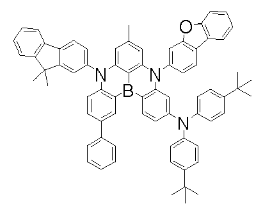
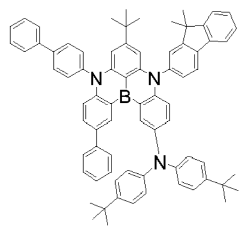
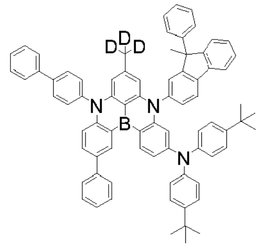
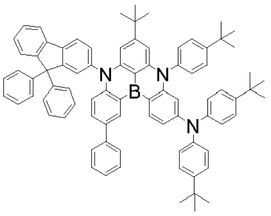
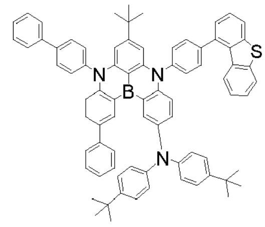
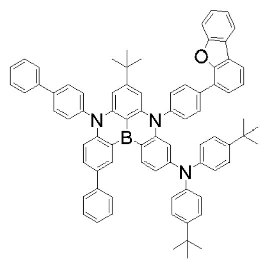
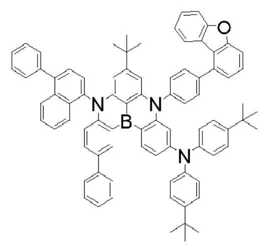
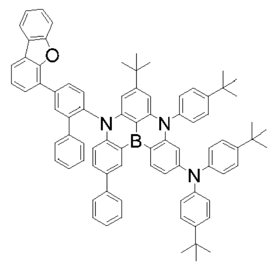
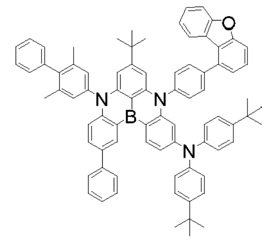
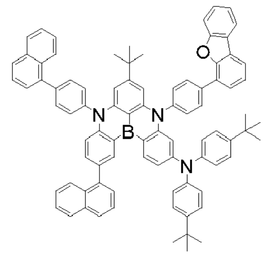
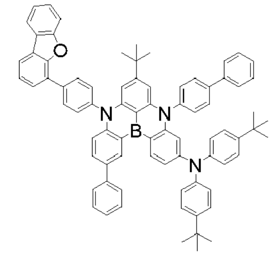
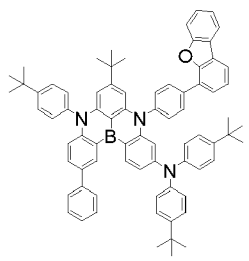
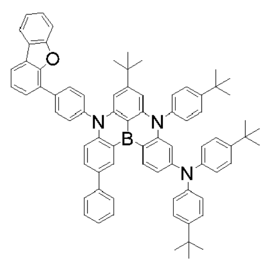

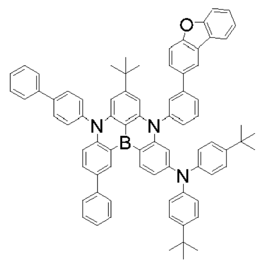
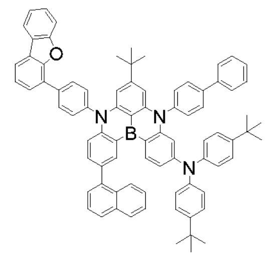
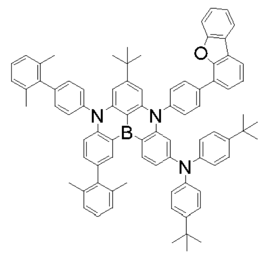
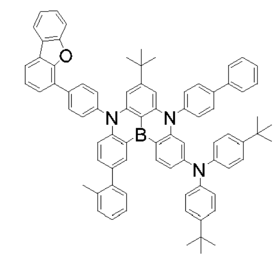

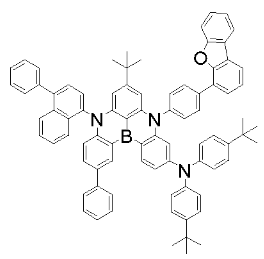
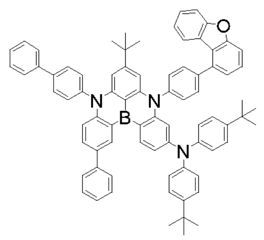
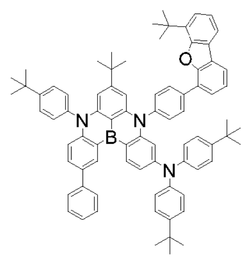
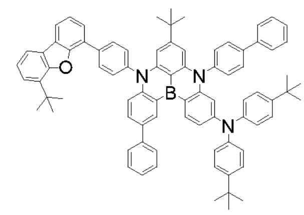

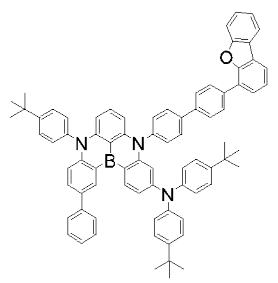
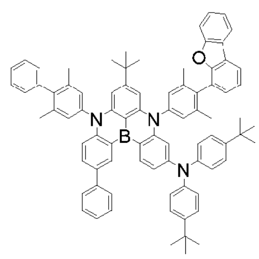
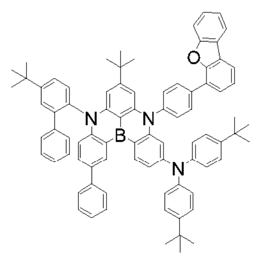
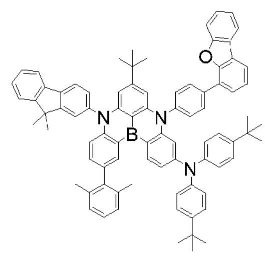

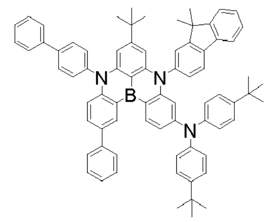
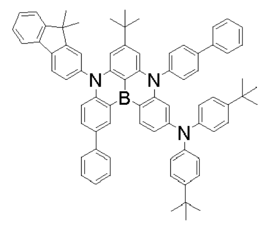
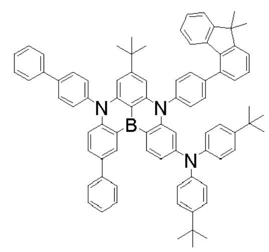
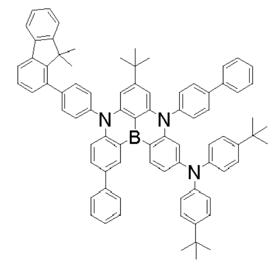

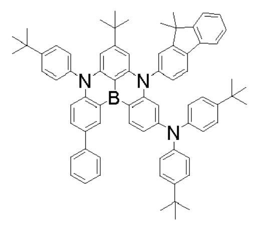
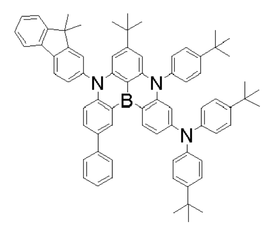
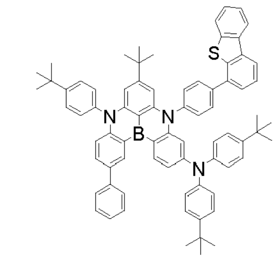
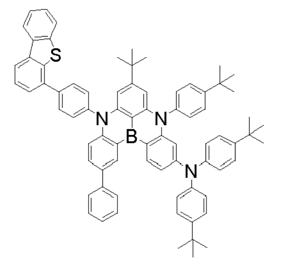

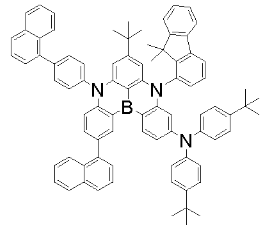
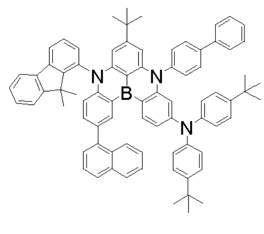
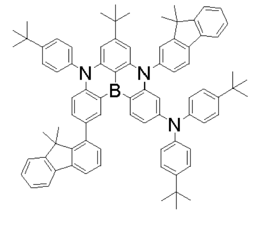
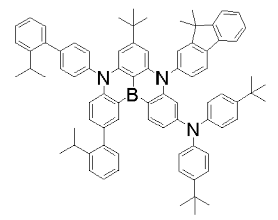

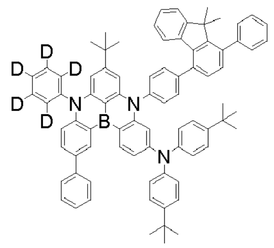
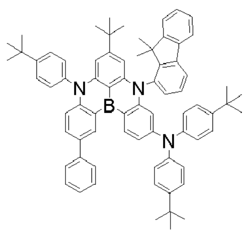
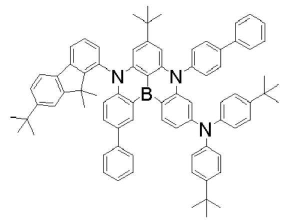
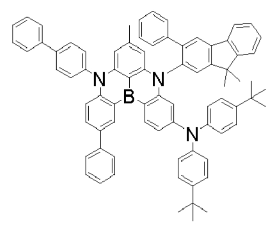

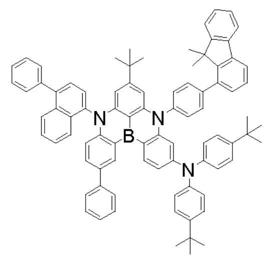
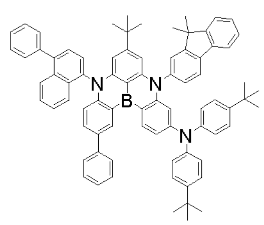
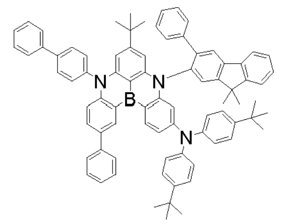
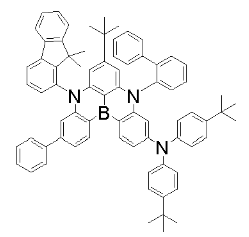

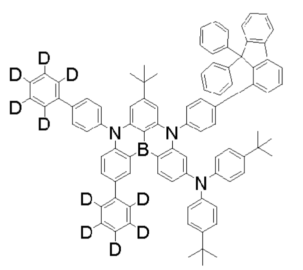
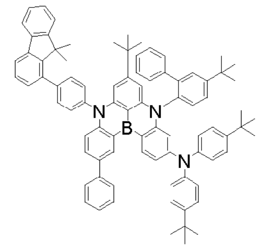
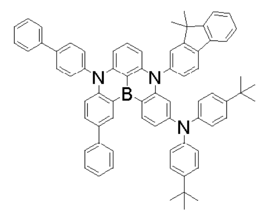
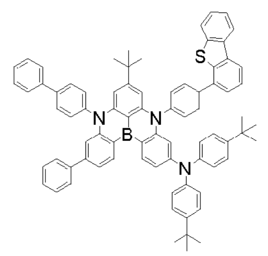

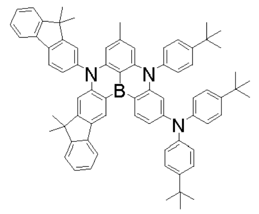
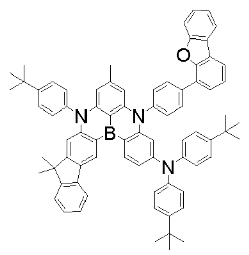
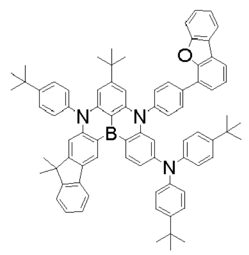
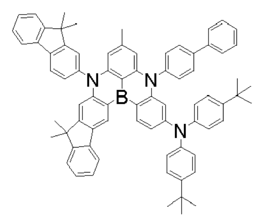

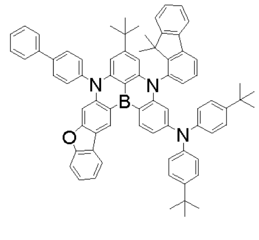
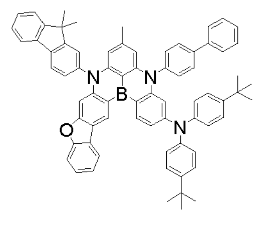
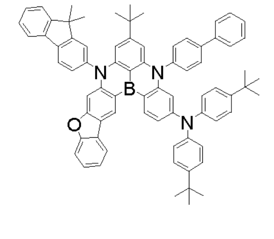
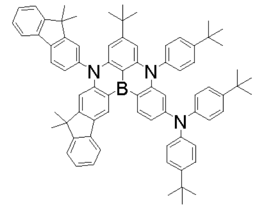

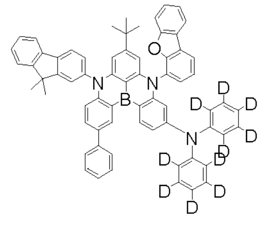
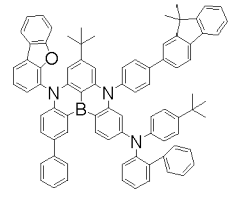
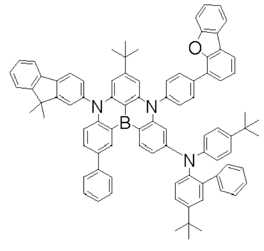
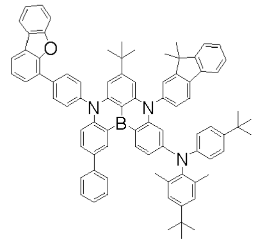

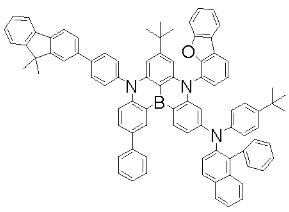
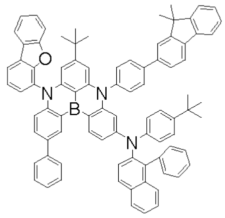
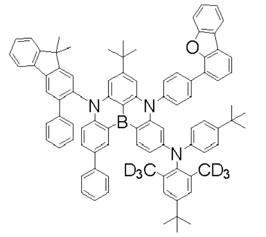
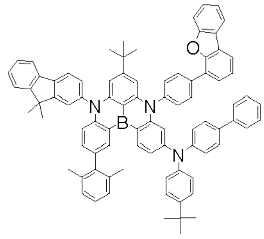
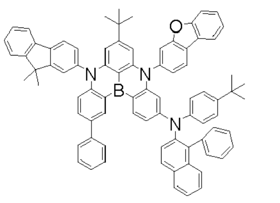
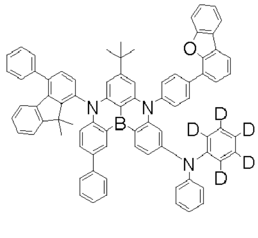
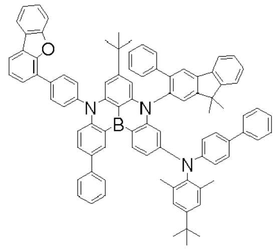
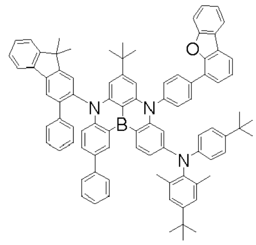
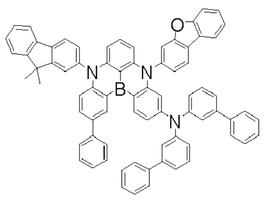
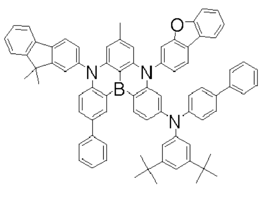
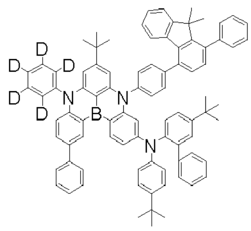
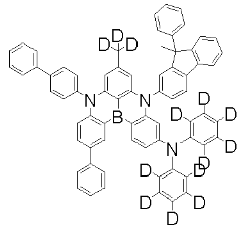
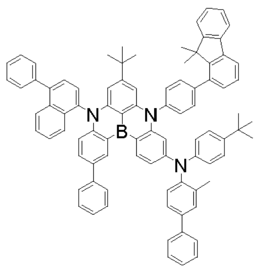
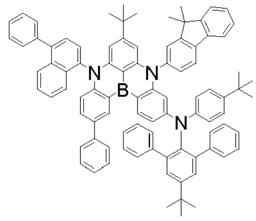
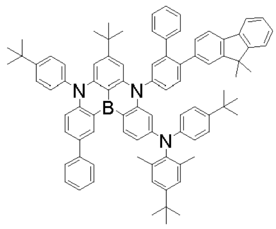
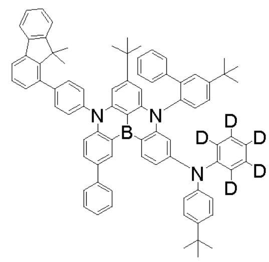
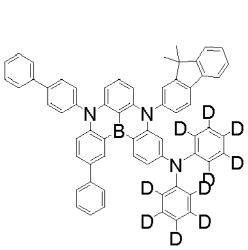
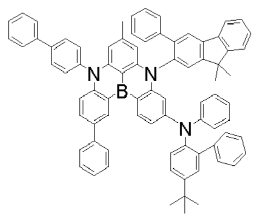
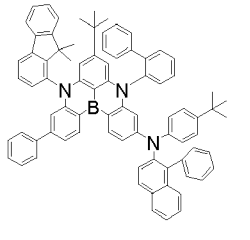
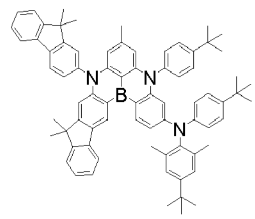
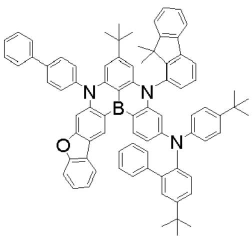
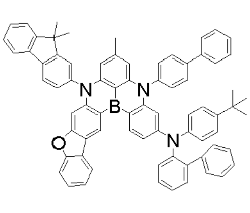
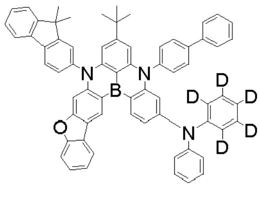
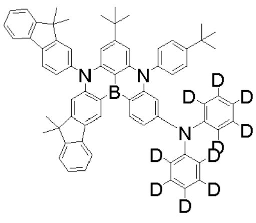

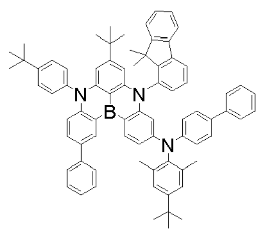
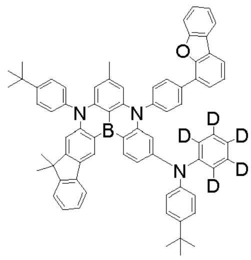
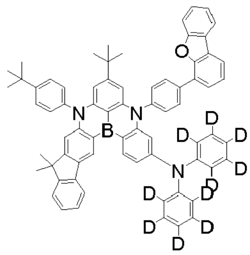
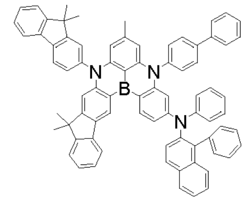

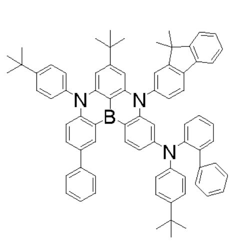
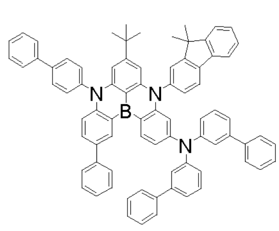
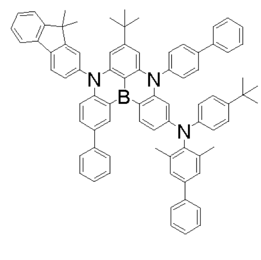
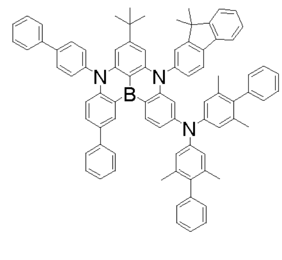

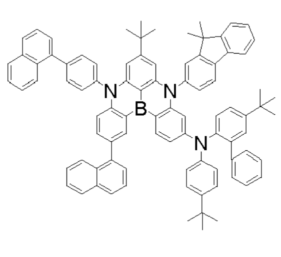
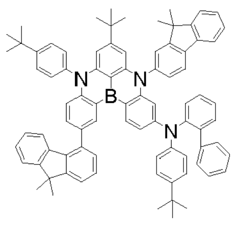
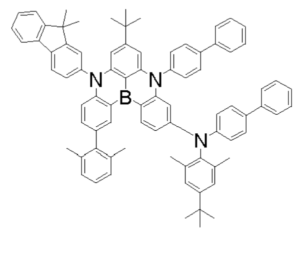
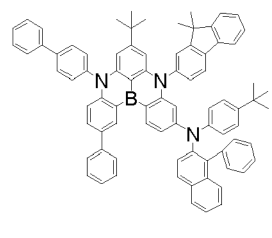

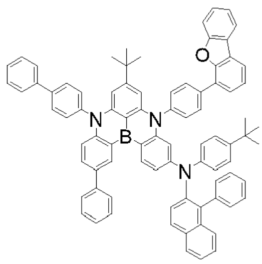
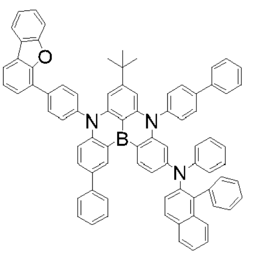
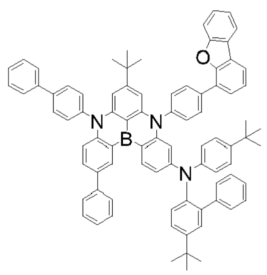
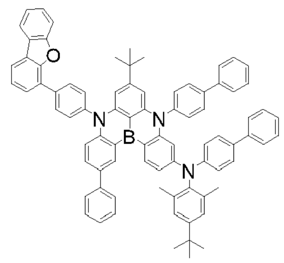

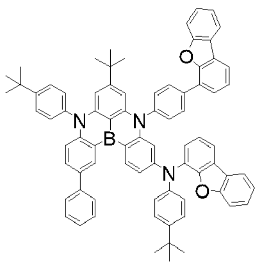
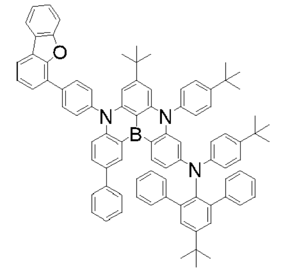
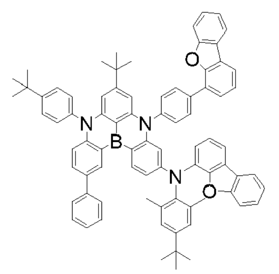
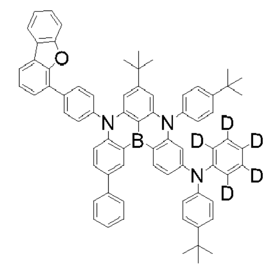

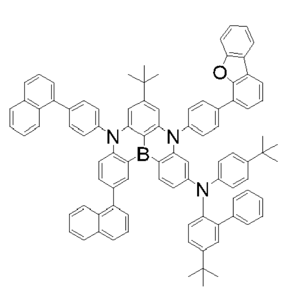
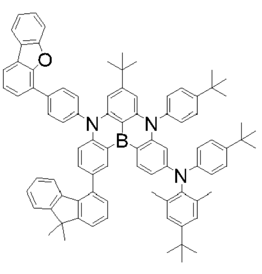
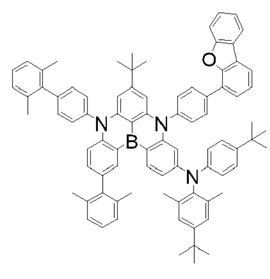
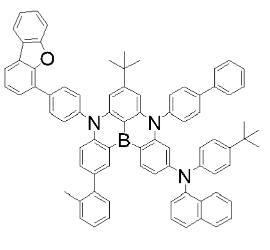

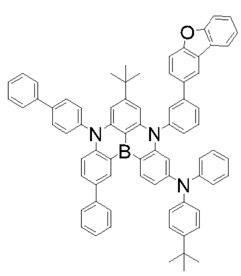
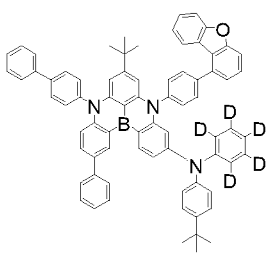
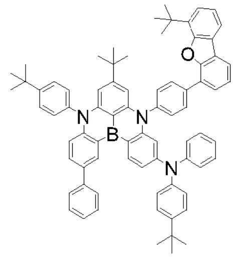
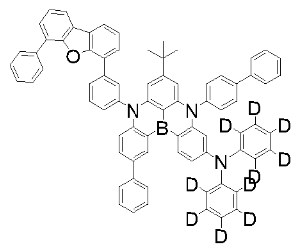

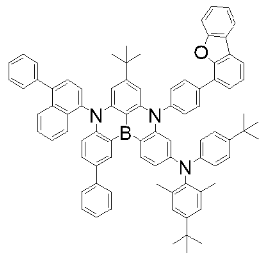
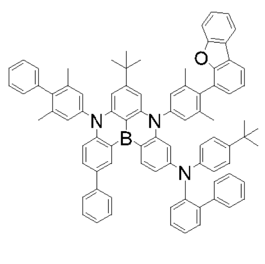
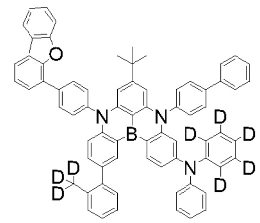
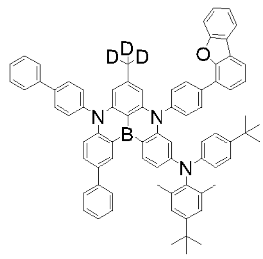

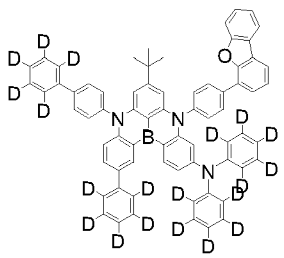
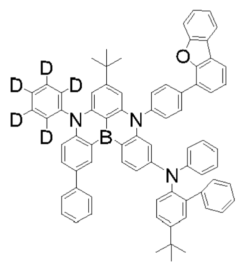
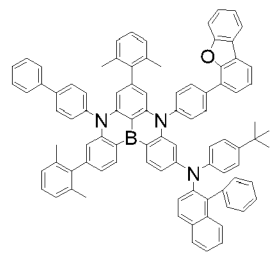
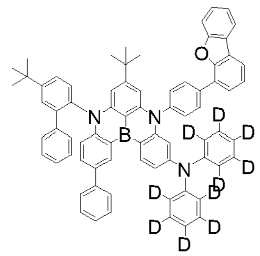

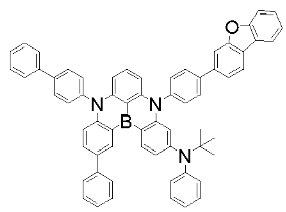
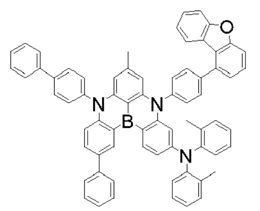
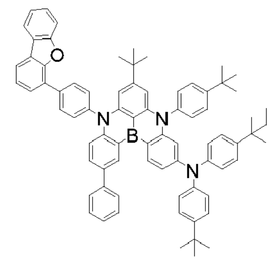
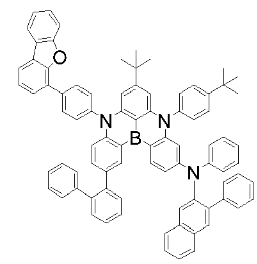

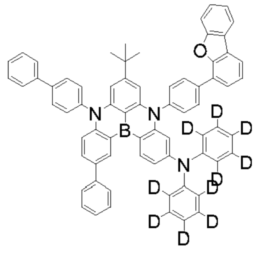
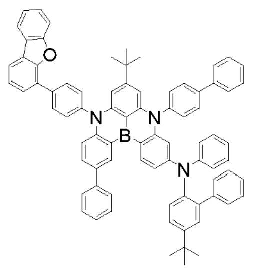
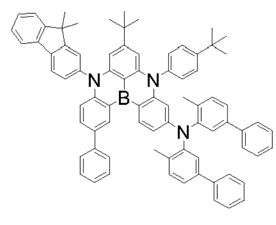
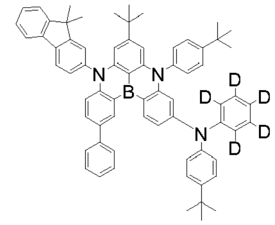

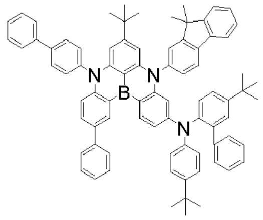
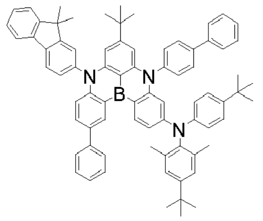
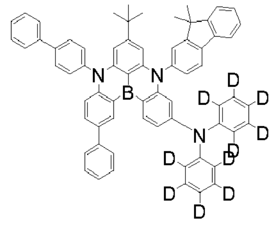
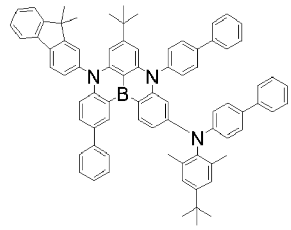
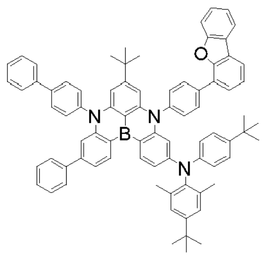
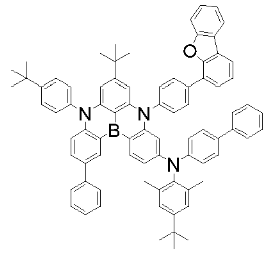
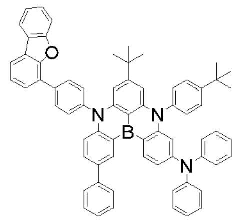
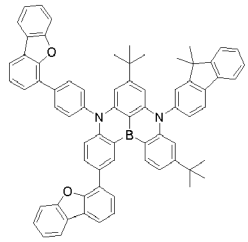
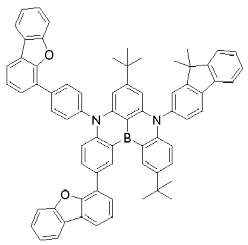
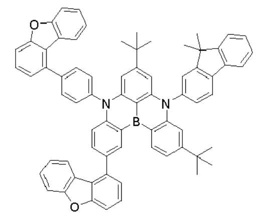
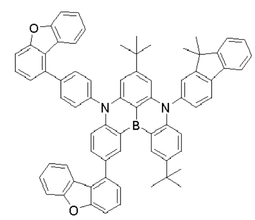
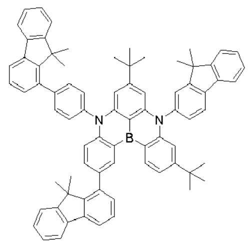
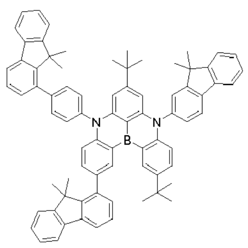
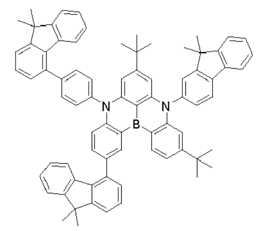
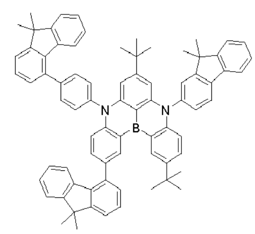
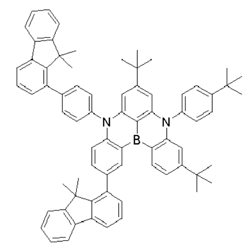
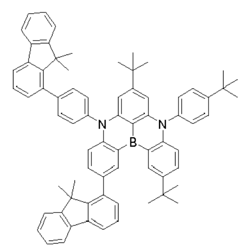
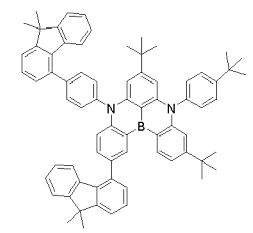
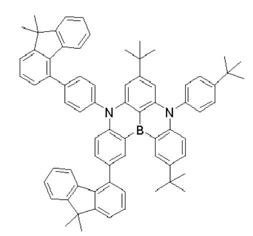
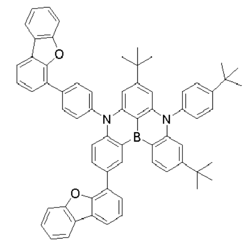
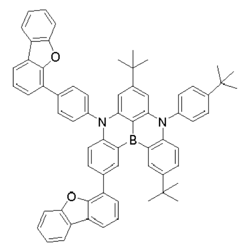
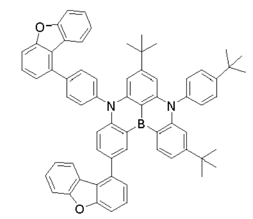
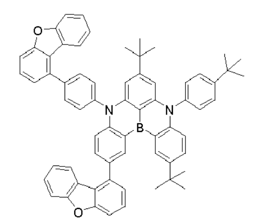

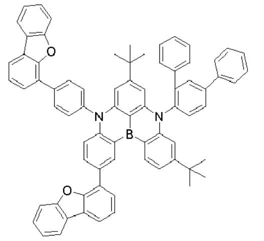
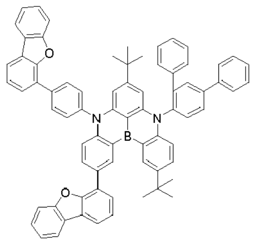
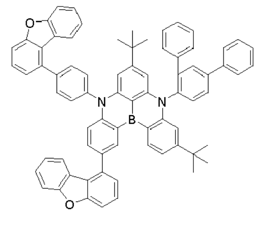
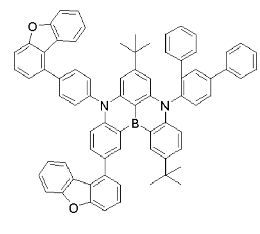

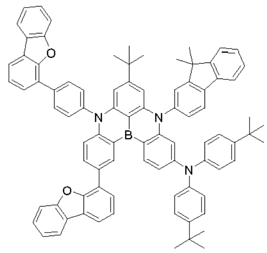
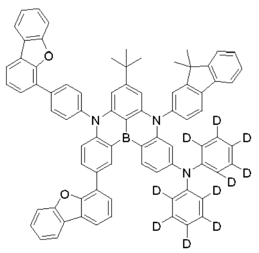
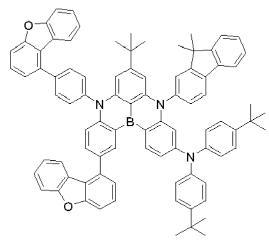
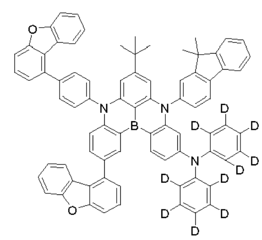

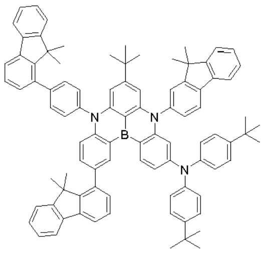
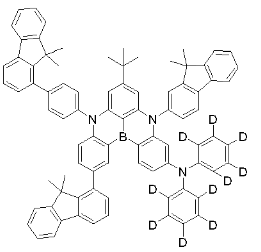
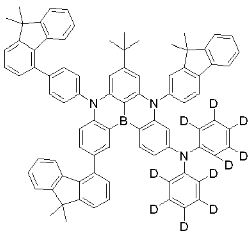
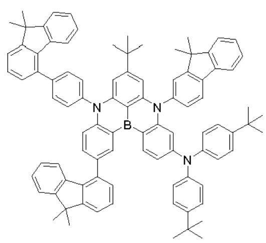

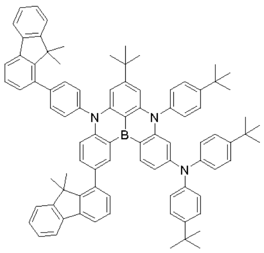
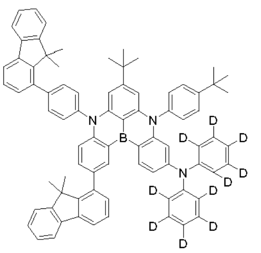
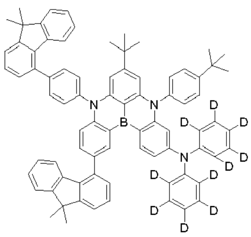
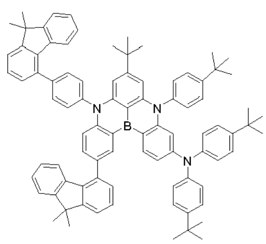

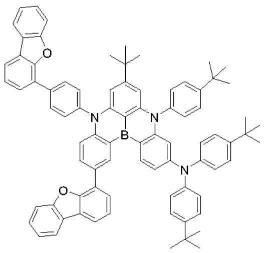
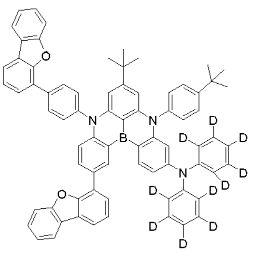
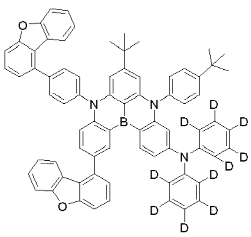
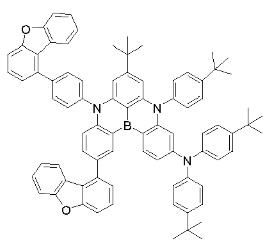

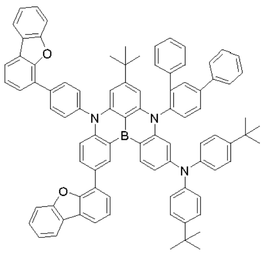
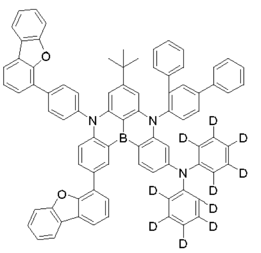
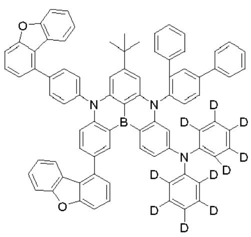
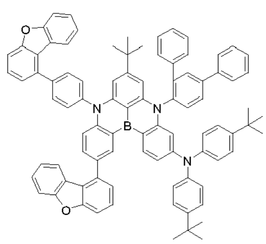

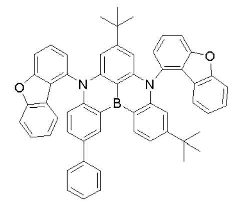
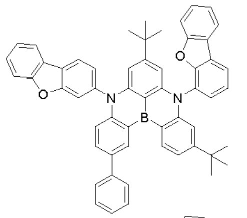
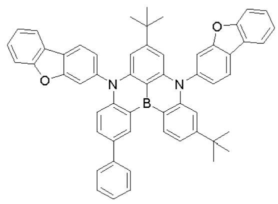
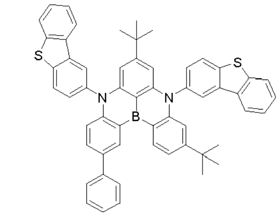
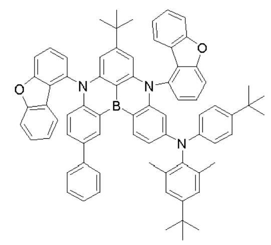
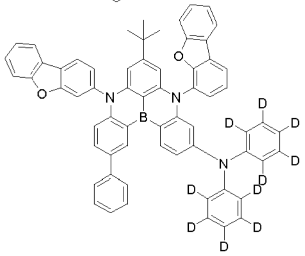
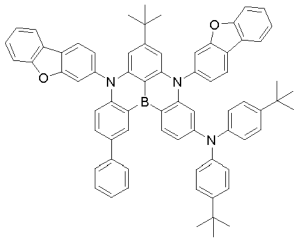
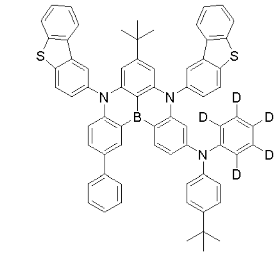
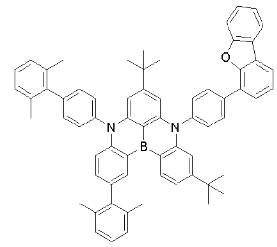
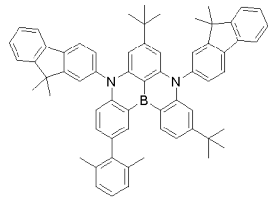
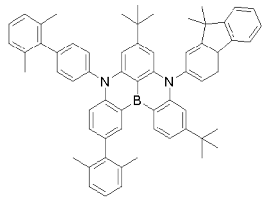
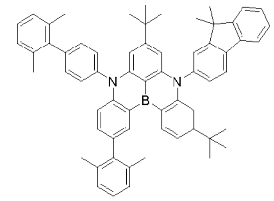
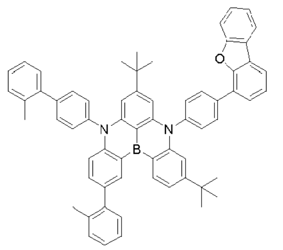
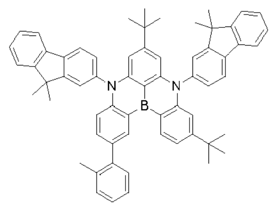
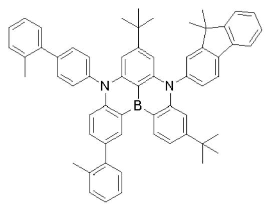
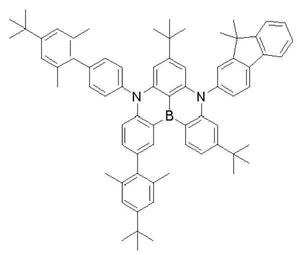
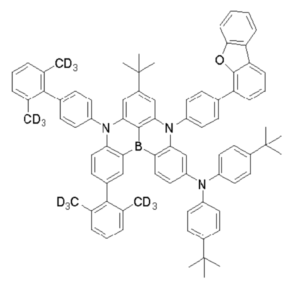
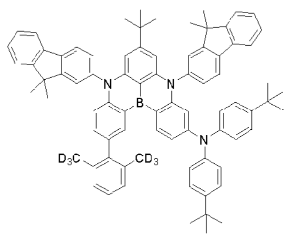
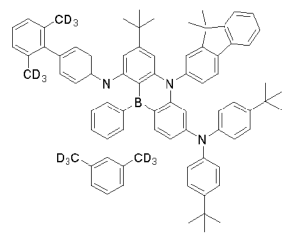
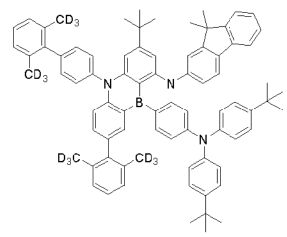
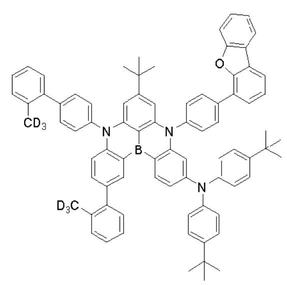
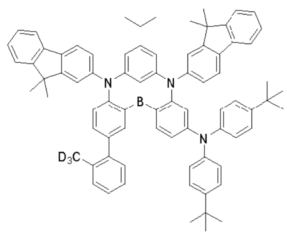
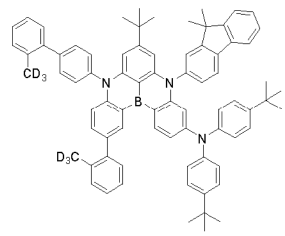
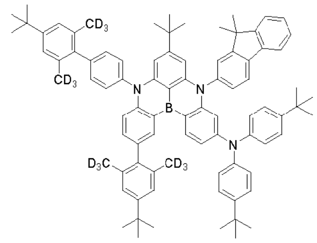

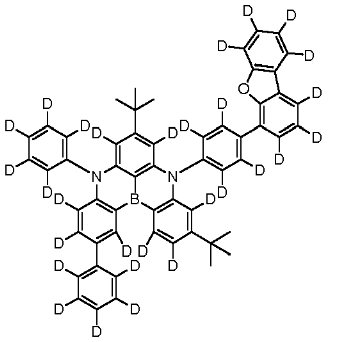

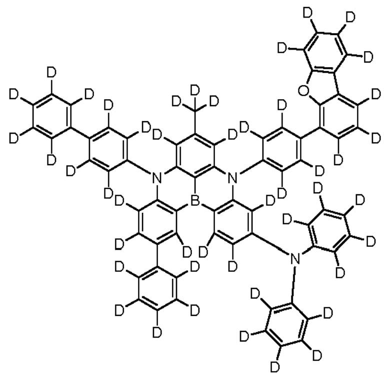

## Preparation of the compounds of formula (I)

The compounds represented by formula (I) can be synthesized in accordance with the reactions conducted in the examples of the present application, and by using alternative reactions or raw materials suited to an intended product, in analogy to reactions and raw materials known in the art.

The compounds of formula (IA) are for example prepared by the following steps:

(i) Addition of $BHal'_3$ to the intermediate (IVA), whereby intermediate (VA) is obtained:

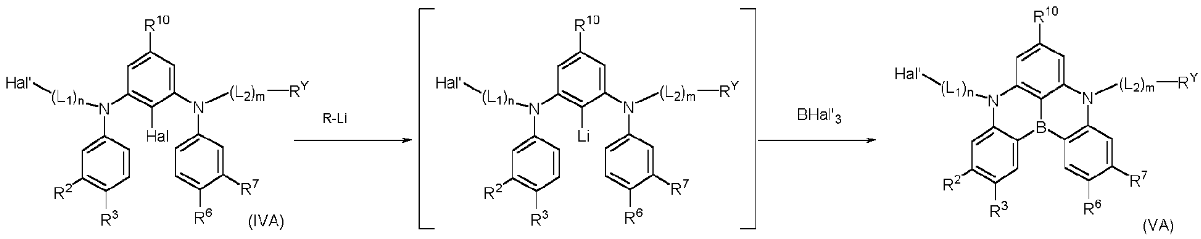


(IVA) (VA)

wherein

Hal represents halogen, preferably F, Cl, Br or I, more preferably Cl or Br and most preferably Br;
Hal' represents halogen, preferably F, Cl, Br or I, more preferably Cl or Br and most preferably Cl;
R represents a substituted or unsubstituted alkyl group having 1 to 8 carbon atoms which may be linear or branched, a substituted or unsubstituted cycloalkyl group having 3 to 6 carbon atoms or a substituted or unsubstituted aryl group having 6 to 13 carbon atoms, preferably, A represents an unsubstituted alkyl group having 1 to 6 carbon atoms which may be linear or branched;
all other residues, groups and indices are as defined before;

(ii) Reaction of the halogen atom of intermediate (VA) with $BQ_2$-(formula (II)) (VIA), whereby the compound of formula (IA) is obtained

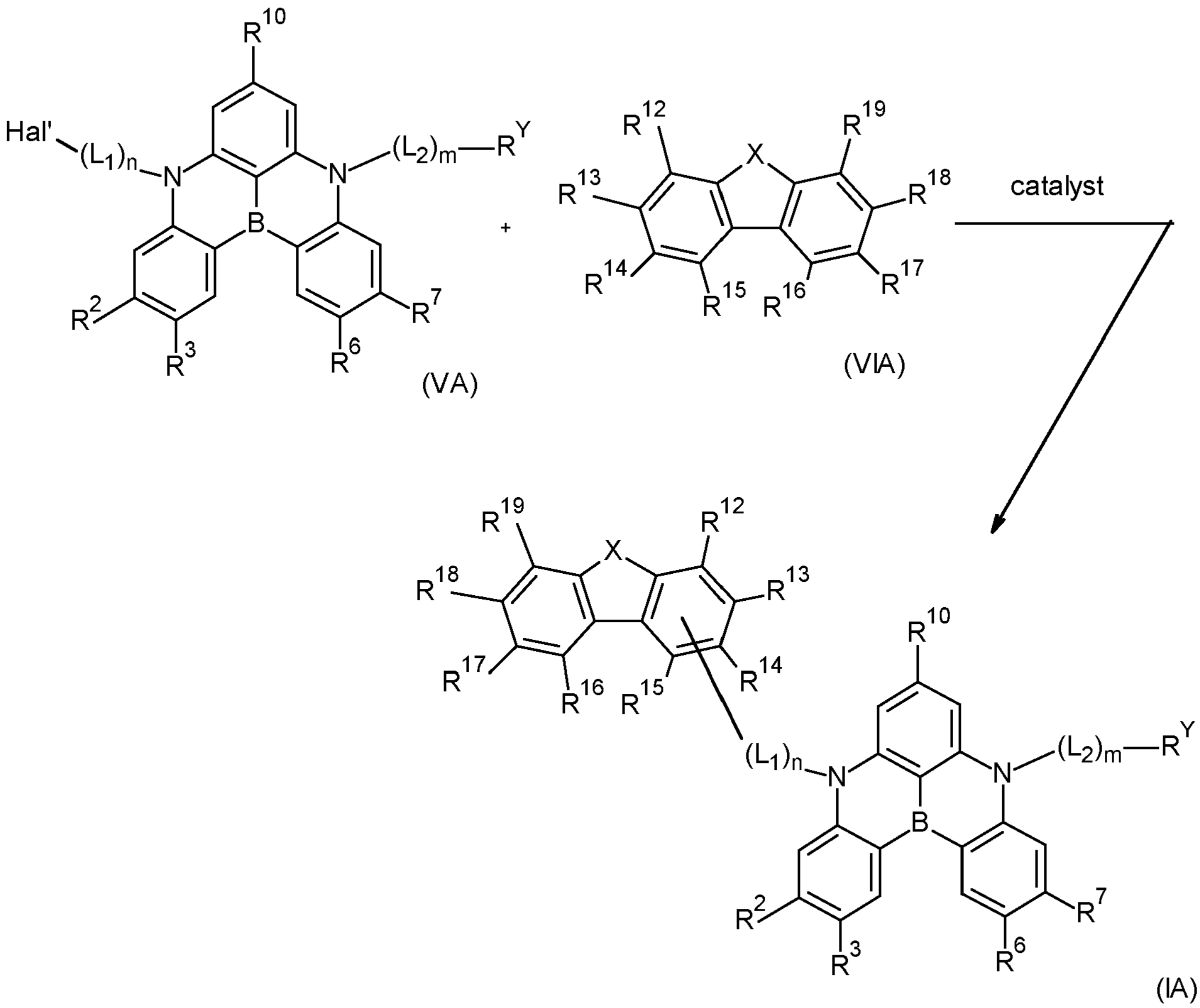


(VA) (VIA) (IA)

wherein

one of $R^{12}$, $R^{13}$, $R^{14}$, $R^{15}$, $R^{16}$, $R^{17}$, $R^{18}$ and $R^{19}$ in $BQ_2$-(formula (II)) (VIA) is $-BQ_2$;
Q is an unsubstituted alkoxy group having 1 to 8 carbon atoms, a hydroxyl group, wherein two alkyl groups Q or two alkoxy groups Q together may form a five or six membered substituted or unsubstituted ring;
catalyst: preferred catalysts are Pd catalysts;
all other residues, groups and indices are as defined before.

One example for a preferred intermediate $BQ_2$-(formula (II)) (VIA) is intermediate (VIA), wherein $R^{14}$ is $-BQ_2$:

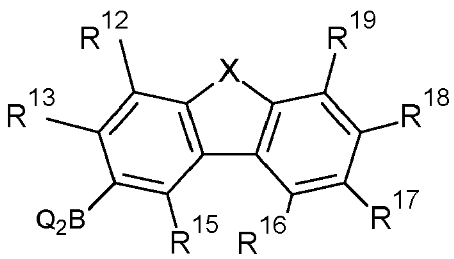

Suitable Pd catalysts are for example Pd(0) complexes with bidentate ligands like dba (dibenzylideneacetone), or Pd(II) salts like $PdCl_2$ or $Pd(OAc)_2$ in combination with bidentate phosphine ligands such as dppf ((diphenylphosphino) ferrocene), dppp ((diphenylphosphino)propane), BINAP (2,2'-Bis(diphenylphosphino)-1,1'-binaphthyl), Xantphos (4,5-Bis(diphenylphosphino)-9,9-dimethylxanthene), DPEphos (Bis[(2-diphenylphosphino)phenyl] ether) or Josiphos, or in combination with monodentate phosphine-ligands like triphenylphosphine, tri-ortho-tolyl phosphine, tri-tertbutylphosphine, tricyclohexylphosphine, 2-Dicyclohexylphosphino-2',6'-dimethox-ybiphenyl (SPhos), 2-Dicyclohexylphosphino-2',4',6'-triisopropylbiphenyl (XPhos), or N-heterocyclic carbenes such as 1,3-Bis(2,6-diisopropylphenyl)imidazol-2-ylidene (IPr), 1,3-Dimesitylim-idazol-2-ylidene (Imes).

Josiphos:

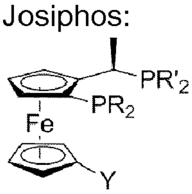

,

wherein R and R' are generally substituted or unsubstituted phenyl.

It is generally possible to change the sequence of steps (i) and (ii) in the process mentioned above, i.e. to carry out the addition of $BQ_2$-(formula (II)) (VIA) (equivalent to step (ii)) first and to carry out the borylation of the obtained intermediate (equivalent to step (i)) subsequently.

Suitable reaction conditions are known by a person skilled in the art. Reaction steps for obtaining intermediates (IVA), (VA) and (VIA) are shown in the examples of the present application.

The other compounds of formula (I), e.g. the compounds of formula (IB) and compounds of formula (I), wherein $Y^1$ and $Y^2$ are a group of formula (II) are prepared in analogy to the compounds of formula (IA) as known by a person skilled in the art.

Details of all reaction steps and process conditions are mentioned in the examples of the present application.

**Organic electroluminescence device**

According to one aspect of the present invention a material for an organic electroluminescence device comprising at least one compound of formula (I) is provided.

According to another aspect of the present invention, an organic electroluminescence device comprising at least one compound of formula (I) is provided.

According to another aspect of the invention, the following organic electroluminescence device is provided: An organic electroluminescence device comprising a cathode, an anode, and one or more organic thin film layers comprising a light emitting layer disposed between the cathode and the anode, wherein at least one layer of the organic thin film layers comprises at least one compound of formula (I).

According to another aspect of the invention an organic electroluminescence device is provided, wherein the light emitting layer comprises at least one compound of formula (I).

According to another aspect of the invention an organic electroluminescence device is provided, wherein the light emitting layer comprises at least one compound of formula (I) as a dopant material and an anthracene compound as a host material.

According to another aspect of the invention an electronic equipment provided with the organic electroluminescence device according to the present invention is provided.

According to another aspect of the invention an emitter material is provided comprising at least one compound of formula (I).

According to another aspect of the invention a light emitting layer is provided comprising at least one host and at least one dopant, wherein the dopant comprises at least one compound of formula (I).

According to another aspect of the invention the use of a compound of formula (I) according to the present invention in an organic electroluminescence device is provided.

In one embodiment, the organic EL device comprises a hole-transporting layer between the anode and the emitting layer.

In one embodiment, the organic EL device comprises an electron-transporting layer between the cathode and the emitting layer.

In the present specification, regarding the "one or more organic thin film layers between the emitting layer and the anode", if only one organic layer is present between the emitting layer and the anode, it means that layer, and if plural organic layers are present, it means at least one layer thereof. For example, if two or more organic layers are present between the emitting layer and the anode, an organic layer nearer to the emitting layer is called the "hole-transporting layer", and an organic layer nearer to the anode is called the "hole-injecting layer". Each of the "hole-transporting layer" and the "hole-injecting layer" may be a single layer or may be formed of two or more layers. One of these layers may be a single layer and the other may be formed of two or more layers.

Similarly, regarding the "one or more organic thin film layers between the emitting layer and the cathode", if only

one organic layer is present between the emitting layer and the cathode, it means that layer, and if plural organic layers are present, it means at least one layer thereof. For example, if two or more organic layers are present between the emitting layer and the cathode, an organic layer nearer to the emitting layer is called the "electron-transporting layer", and an organic layer nearer to the cathode is called the "electron-injecting layer". Each of the "electron-transporting layer" and the "electron-injecting layer" may be a single layer or may be formed of two or more layers. One of these layers may be a single layer and the other may be formed of two or more layers.

The "one or more organic thin film layers comprising an emitting layer" mentioned above, preferably the emitting layer, comprises a compound represented by formula (I). The compound represented by formula (I) preferably functions as an emitter material, more preferably as a fluorescent emitter material, most preferably as a blue fluorescent emitter material. By the presence of a compound of formula (I) in the organic EL device, preferably in the emitting layer, organic EL devices characterized by high external quantum efficiencies (EQE) and long lifetimes are provided.

According to another aspect of the invention, an emitting layer of the organic electroluminescence device is provided which comprises at least one compound of formula (I).

Preferably, the emitting layer comprises at least one emitting material (dopant material) and at least one host material, wherein the emitting material is at least one compound of formula (I).

In one embodiment, the host is not selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenylj ether oxide), 9-[3- (dibenzofuran-2-yl)phenyl]-9H-carbazole, 9-[3-(dibenzofuran-2-yl)phenyl]-9H-carbazole, 9-[3- (dibenzothiophen-2-yl)phenyl]-9H-carbazole, 9-[3,5-bis(2-dibenzofuranyl)phenyl]-9H- carbazole, 9-[3,5-bis(2-dibenzothiophenyl)phenyl]-9H-carbazole, T2T (2,4,6-tris(biphenyl-3- yl)-1 ,3,5-triazine), T3T (2,4,6-tris(triphenyl-3-yl)-1 ,3,5-triazine) and/or TST (2,4,6-tris(9,9'- spirobifluorene-2-yl)-1,3,5-triazine).

Preferred host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds.

More preferably, the organic electroluminescence device according to the present invention comprises in the emitting layer at least one compound of formula (I) as a dopant material and at least one host material selected from the group consisting of substituted or unsubstituted polyaromatic hydrocarbon (PAH) compounds, substituted or unsubstituted polyheteroaromatic compounds, substituted or unsubstituted anthracene compounds, and substituted or unsubstituted pyrene compounds. Preferably, the at least one host is at least one substituted or unsubstituted anthracene compound.

In a further preferred embodiment, the organic electroluminescence device according to the present invention comprises in the emitting layer at least one compound of formula (I) as a dopant material and at least one host material selected from the group consisting of substituted or unsubstituted polyaromatic hydrocarbon (PAH) compounds, substituted or unsubstituted anthracene compounds, and substituted or unsubstituted pyrene compounds. Preferably, the at least one host is at least one substituted or unsubstituted anthracene compound.

According to another aspect of the invention, an emitting layer of the organic electroluminescence device is provided which comprises at least one compound of formula (I) as a dopant material and an anthracene compound as a host material.

Suitable anthracene compounds are represented by the following formula (10):

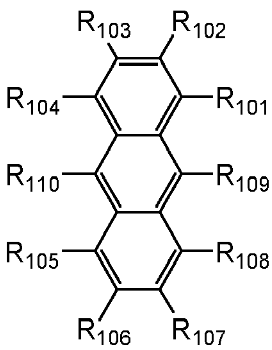

(10)

wherein

one or more pairs of two or more adjacent $R_{101}$ to $R_{110}$ may form a substituted or unsubstituted, saturated or unsaturated ring;

$R_{101}$ to $R_{110}$ that do not form the substituted or unsubstituted, saturated or unsaturated ring are independently a hydrogen atom, a substituted or unsubstituted alkyl group including 1 to 50 carbon atoms, a substituted or

unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, $-Si(R_{121})(R_{122})(R_{123})$, $-C(=O)R_{124}$, $-COOR_{125}$, $-N(R_{126})(R_{127})$, a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);

$R_{121}$ to $R_{127}$ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of $R_{121}$ to $R_{127}$ is present in plural, each of the plural $R_{121}$ to $R_{127}$ may be the same or different;

provided that at least one of $R_{101}$ to $R_{110}$ that do not form the substituted or unsubstituted, saturated or unsaturated ring is a group represented by the following formula (31). If two or more groups represented by the formula (31) are present, each of these groups may be the same or different;

$$-L_{101}-Ar_{101} \quad (31)$$

wherein in the formula (31),

$L_{101}$ is a single bond, a substituted or unsubstituted arylene group including 6 to 30 ring carbon atoms or a substituted or unsubstituted divalent heterocyclic group including 5 to 30 ring atoms; $Ar_{101}$ is a substituted or unsubstituted aryl group including 6 to 50 ring carbon atoms or a substituted or unsubstituted monovalent heterocyclic group including 5 to 50 ring atoms.

Specific examples of each substituent, substituents for "substituted or unsubstituted" and the halogen atom in the compound (10) are the same as those mentioned above.

An explanation will be given on "one or more pairs of two or more adjacent $R_{101}$ to $R_{110}$ may form a substituted or unsubstituted, saturated or unsaturated ring".

The "one pair of two or more adjacent $R_{101}$ to $R_{110}$" is a combination of $R_{101}$ and $R_{102}$, $R_{102}$ and $R_{103}$, $R_{103}$ and $R_{104}$, $R_{105}$ and $R_{106}$, $R_{106}$ and $R_{107}$, $R_{107}$ and $R_{108}$, $R_{108}$ and $R_{109}$, $R_{101}$ and $R_{102}$ and $R_{103}$ or the like, for example.

The substituent in "substituted" in the "substituted or unsubstituted" for the saturated or unsaturated ring is the same as those for "substituted or unsubstituted" mentioned in the formula (10).

The "saturated or unsaturated ring" means, when $R_{101}$ and $R_{102}$ form a ring, for example, a ring formed by a carbon atom with which $R_{101}$ is bonded, a carbon atom with which $R_{102}$ is bonded and one or more arbitrary elements. Specifically, when a ring is formed by $R_{101}$ and $R_{102}$, when an unsaturated ring is formed by a carbon atom with which $R_{101}$ is bonded, a carbon atom with $R_{102}$ is bonded and four carbon atoms, the ring formed by $R_{101}$ and $R_{102}$ is a benzene ring.

The "arbitrary element" is preferably a C element, a N element, an O element or a S element. In the arbitrary element (C element or N element, for example), atomic bondings that do not form a ring may be terminated by a hydrogen atom, or the like.

The "one or more arbitrary element" is preferably 2 or more and 15 or less, more preferably 3 or more and 12 or less, and further preferably 3 or more and 5 or less arbitrary elements.

For example, $R_{101}$ and $R_{102}$ may form a ring, and simultaneously, $R_{105}$ and $R_{106}$ may form a ring. In this case, the compound represented by the formula (10) is a compound represented by the following formula (10A), for example:

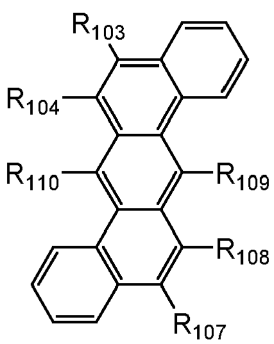

(10A)

In one embodiment, $R_{101}$ to $R_{110}$ are independently a hydrogen atom, a substituted or unsubstituted alkyl group including 1 to 50 carbon atoms, a substituted or unsubstituted aryl group including 6 to 50 ring carbon atoms, a substituted or unsubstituted heterocyclic group including 5 to 50 ring atoms or a group represented by the formula (31).

Preferably, $R_{101}$ to $R_{110}$ are independently a hydrogen atom, a substituted or unsubstituted aryl group including 6 to 50 ring carbon atoms, a substituted or unsubstituted heterocyclic group including 5 to 50 ring atoms or a group represented by the formula (31).

More preferably, $R_{101}$ to $R_{110}$ are independently a hydrogen atom, a substituted or unsubstituted aryl group including 6 to 18 ring carbon atoms, a substituted or unsubstituted heterocyclic group including 5 to 18 ring atoms or a group represented by the formula (31).

Most preferably, at least one of $R_{109}$ and $R_{110}$ is a group represented by the formula (31).

Further most preferably, $R_{109}$ and $R_{110}$ are independently a group represented by the formula (31).

In one embodiment, the compound (10) is a compound represented by the following formula (10-1):

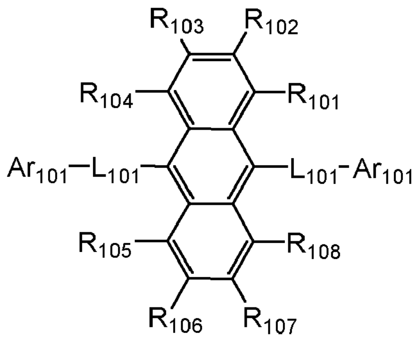

(10-1)

wherein in the formula (10-1), $R_{101}$ to $R_{108}$, $L_{101}$ and $Ar_{101}$ are as defined in the formula (10).

In one embodiment, the compound (10) is a compound represented by the following formula (10-2):

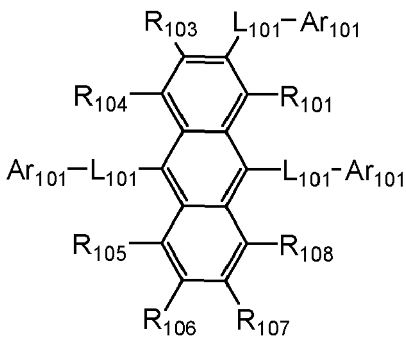

(10-2)

wherein in the formula (10-2), $R_{101}$, $R_{103}$ to $R_{108}$, $L_{101}$ and $Ar_{101}$ are as defined in the formula (10).

In one embodiment, the compound (10) is a compound represented by the following formula (10-3):

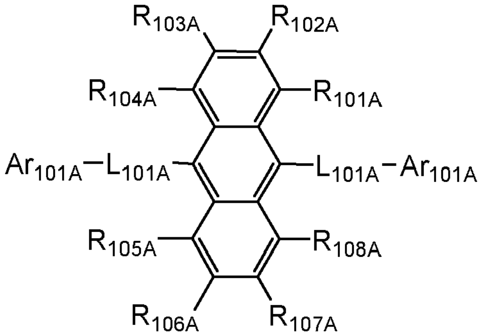

(10-3)

wherein in the formula (10-3),

$R_{101A}$ to $R_{108A}$ are independently a hydrogen atom or a substituted or unsubstituted aryl group including 6 to 50 ring carbon atoms;
$L_{101A}$ is a single bond or a substituted or unsubstituted arylene group including 6 to 30 ring carbon atoms, and the two $L_{101A}$s may be the same or different;
$Ar_{101A}$ is a substituted or unsubstituted aryl group including 6 to 50 ring carbon atoms, and the two $Ar_{101A}$s may be the same or different.

In one embodiment, the compound (10) is a compound represented by the following formula (10-4):

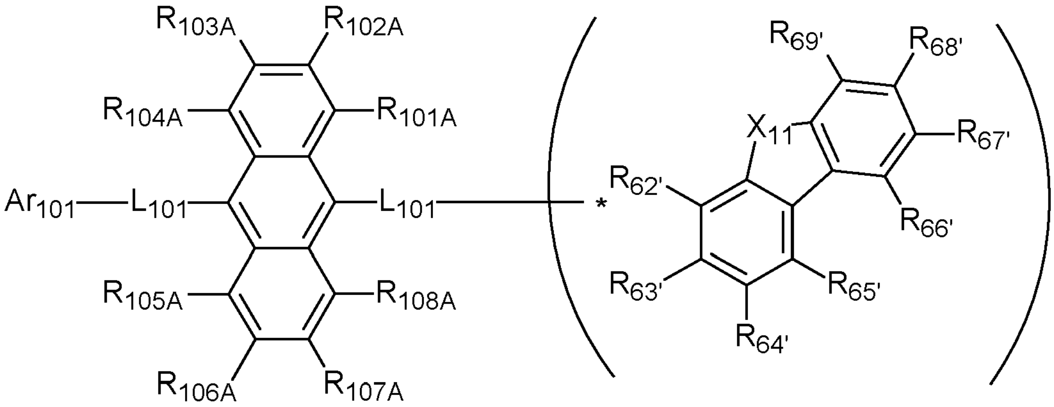

(10-4)

wherein in the formula (10-4),

$L_{101}$ and $Ar_{101}$ are as defined in the formula (10);
$R_{101A}$ to $R_{108A}$ are independently a hydrogen atom or a substituted or unsubstituted aryl group including 6 to 50 ring carbon atoms;
$X_{11}$ is O, S, or $N(R_{61'})$;
$R_{61'}$ is a hydrogen atom, a substituted or unsubstituted alkyl group including 1 to 50 carbon atoms or a substituted or unsubstituted aryl group including 6 to 50 ring carbon atoms;
one of $R_{62'}$ to $R_{69'}$ is an atomic bonding that is bonded with $L_{101}$;
one or more pairs of adjacent $R_{62'}$ to $R_{69'}$ that are not bonded with $L_{101}$ may be bonded with each other to form a substituted or unsubstituted, saturated or unsaturated ring; and $R_{62'}$ to $R_{69'}$ that are not bonded with $L_{101}$ and do not form the substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-4A):

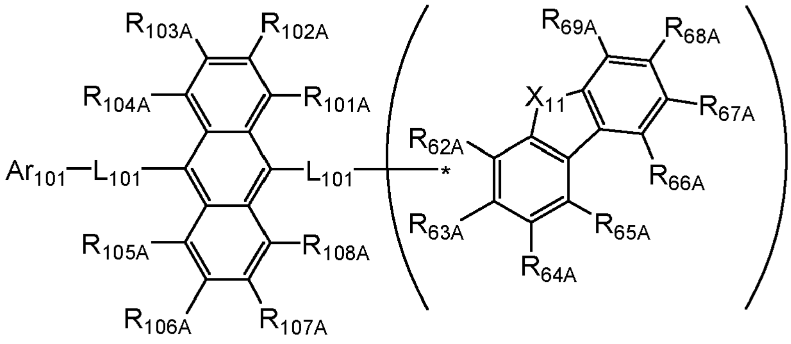

(10-4A)

wherein in the formula (10-4A),

$L_{101}$ and $Ar_{101}$ are as defined in the formula (10);
$R_{101A}$ to $R_{108A}$ are independently a hydrogen atom or a substituted or unsubstituted aryl group including 6 to 50 ring carbon atoms;
$X_{11}$ is O, S or $N(R_{61})$;
$R_{61}$ is a hydrogen atom, a substituted or unsubstituted alkyl group including 1 to 50 carbon atoms or a substituted or unsubstituted aryl group including 6 to 50 ring carbon atoms;
one or more pairs of adjacent two or more of $R_{62A}$ to $R_{69A}$ may form a substituted or unsubstituted, saturated or unsaturated ring, and adjacent two of $R_{62A}$ to $R_{69A}$ form a ring represented by the following formula (10-4A-1); and $R_{62A}$ to $R_{69A}$ that do not form a substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms.

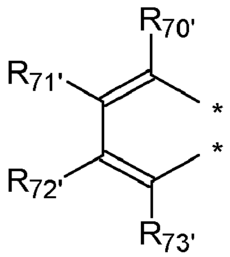

(10-4A-1)

wherein in the formula (10-4A-1),
each of the two atomic bondings * is bonded with adjacent two of $R_{62A}$ to $R_{69A}$;
one of $R_{70'}$ to $R_{73'}$ is an atomic bonding that is bonded with $L_{101}$; and
$R_{70'}$ to $R_{73'}$ that are not bonded with $L_{101}$ are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-6):

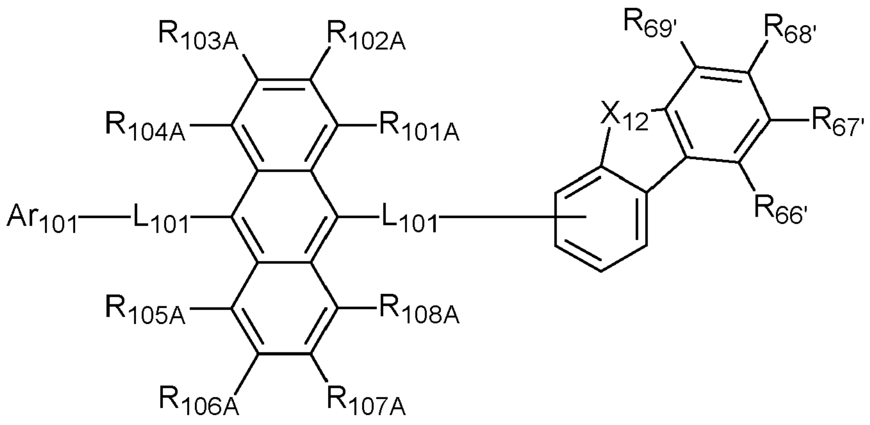

(10-6)

wherein in the formula (10-6),

$L_{101}$ and $Ar_{101}$ are as defined in the formula (10);
$R_{101A}$ to $R_{108A}$ are as defined in the formula (10-4);
$R_{66'}$ to $R_{69'}$ are as defined in the formula (10-4); and
$X_{12}$ is O or S.

In one embodiment, the compound represented by the formula (10-6) is a compound represented by the following formula (10-6H):

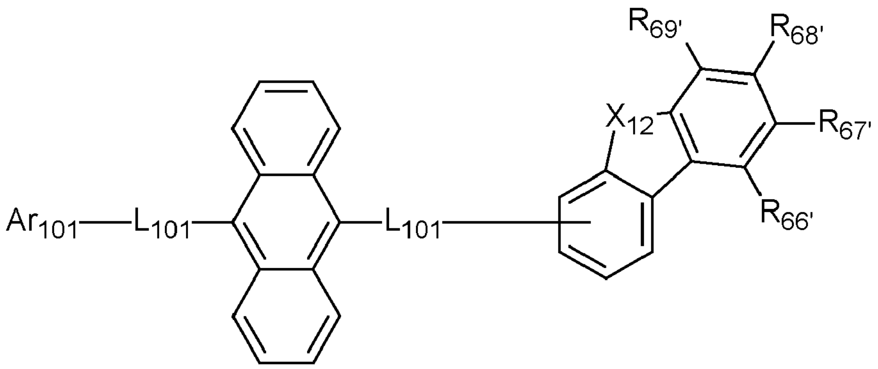

(10-6H)

wherein in the formula (10-6H),

$L_{101}$ and $Ar_{101}$ are as defined in the formula (10);
$R_{66'}$ to $R_{69'}$ are as defined in the formula (10-4); and
$X_{12}$ is O or S.

In one embodiment, the compound represented by the formulae (10-6) and (10-6H) is a compound represented by the following formula (10-6Ha):

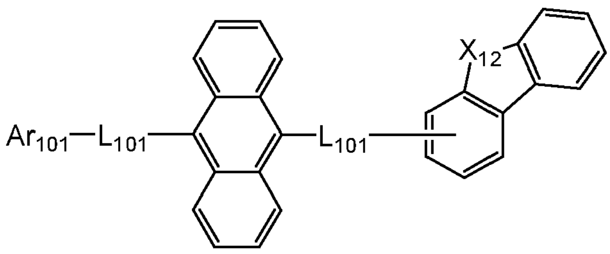

(10-6Ha)

wherein in the formula (10-6Ha),

$L_{101}$ and $Ar_{101}$ are as defined in the formula (10); and
$X_{12}$ is O or S.

In one embodiment, the compound represented by the formulae (10-6), (10-6H) and (10-6Ha) is a compound represented by the following formula (10-6Ha-1) or (10-6Ha-2):

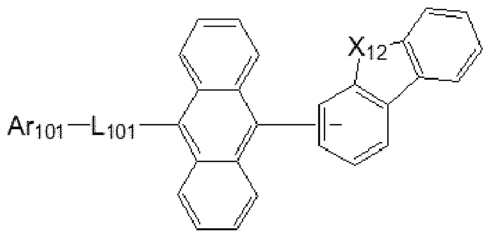

(10-6Ha-1)

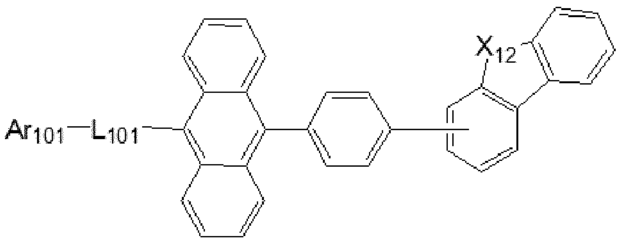

(10-6Ha-2)

wherein in the formula (10-6Ha-1) and (10-6Ha-2),

$L_{101}$ and $Ar_{101}$ are as defined in the formula (10); and
$X_{12}$ is O or S.

In one embodiment, the compound (10) is a compound represented by the following formula (10-7):

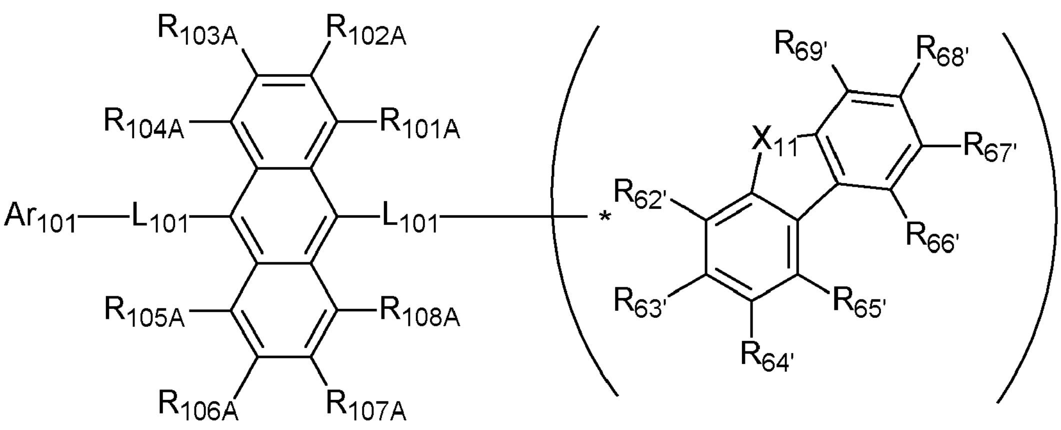

(10-7)

wherein in the formula (10-7),

$L_{101}$ and $Ar_{101}$ are as defined in the formula (10);

$R_{101A}$ to $R_{108A}$ are as defined in the formula (10-4);
$X_{11}$ is as defined in the formula (10-4); and
$R_{62'}$ to $R_{69'}$ are as defined in the formula (10-4), provided that any one pair of $R_{66'}$ and $R_{67'}$, $R_{67'}$ and $R_{68'}$, and $R_{68'}$ and $R_{69'}$ are bonded with each other to form a substituted or unsubstituted, saturated or unsaturated ring.

In one embodiment, the compound (10) is a compound represented by the following formula (10-7H):

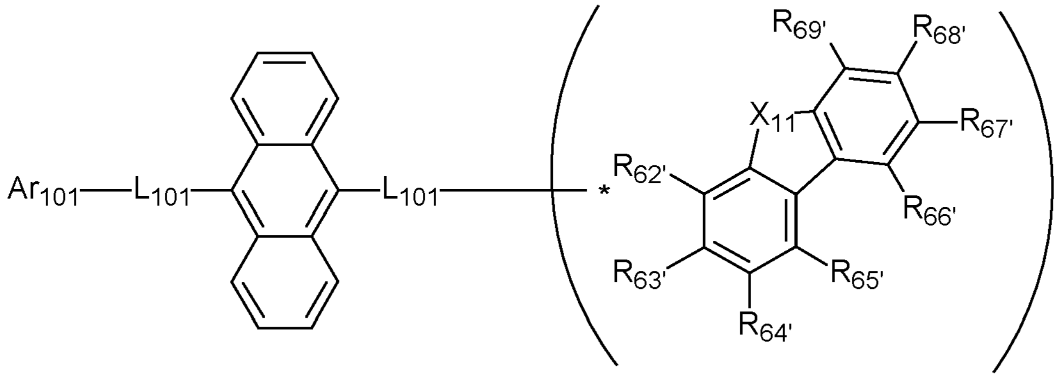

(10-7H)

wherein in the formula (10-7H),

$L_{101}$ and $Ar_{101}$ are as defined in the formula (10);
$X_{11}$ is as defined in the formula (10-4); and
$R_{62'}$ to $R_{69'}$ are as defined in the formula (10-4), provided that any one pair of $R_{66'}$ and $R_{67'}$, $R_{67'}$ and $R_{68'}$, and $R_{68'}$ and $R_{69'}$ are bonded with each other to form a substituted or unsubstituted, saturated or unsaturated ring.

In one embodiment, the compound (10) is a compound represented by the following formula (10-8):

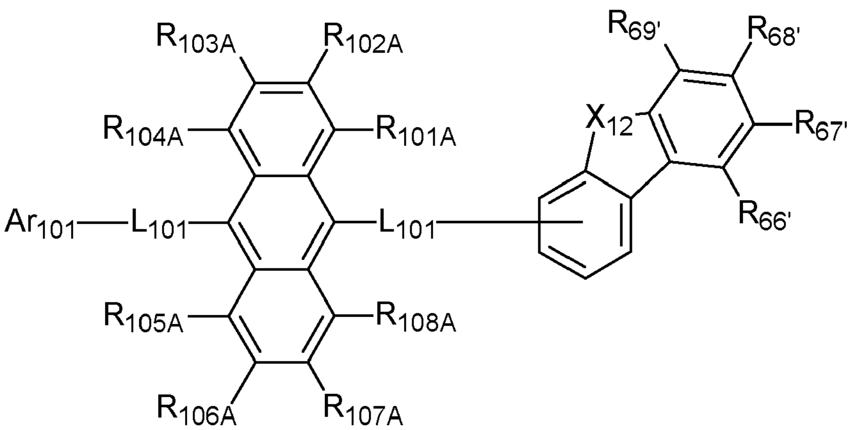

(10-8)

wherein in the formula (10-8),

$L_{101}$ and $Ar_{101}$ are as defined in the formula (10);
$R_{101A}$ to $R_{108A}$ are as defined in the formula (10-4);
$X_{12}$ is O or S; and
$R_{66'}$ to $R_{69'}$ are as defined in the formula (10-4), provided that any one pair of $R_{66'}$ and $R_{67'}$, $R_{67'}$ and $R_{68'}$, as well as $R_{68'}$ and $R_{69'}$ are bonded with each other to form a substituted or unsubstituted, saturated or unsaturated ring.

In one embodiment, the compound represented by the formula (10-8) is a compound represented by the

following formula (10-8H):

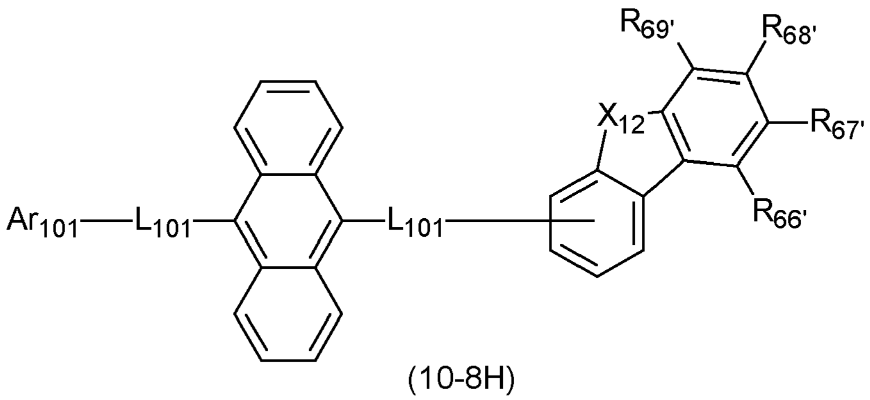

(10-8H)

In the formula (10-8H), $L_{101}$ and $Ar_{101}$ are as defined in the formula (10).

$R_{66'}$ to $R_{69'}$ are as defined in the formula (10-4), provided that any one pair of $R_{66'}$ and $R_{67'}$, $R_{67'}$ and $R_{68'}$, as well as $R_{68'}$ and $R_{69'}$ are bonded with each other to form a substituted or unsubstituted, saturated or unsaturated ring. Any one pair of $R_{66'}$ and $R_{67'}$, $R_{67'}$ and $R_{68'}$, as well as $R_{68'}$ and $R_{69'}$ may preferably be bonded with each other to form an unsubstituted benzene ring; and $X_{12}$ is O or S.

In one embodiment, as for the compound represented by the formula (10-7), (10-8) or (10-8H), any one pair of $R_{66'}$ and $R_{67'}$, $R_{67'}$ and $R_{68'}$, as well as $R_{68'}$ and $R_{69'}$ are bonded with each other to form a ring represented by the following formula (10-8-1) or (10-8-2), and $R_{66'}$ to $R_{69'}$ that do not form the ring represented by the formula (10-8-1) or (10-8-2) do not form a substituted or unsubstituted, saturated or unsaturated ring.

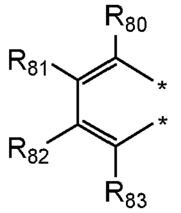

(10-8-1)

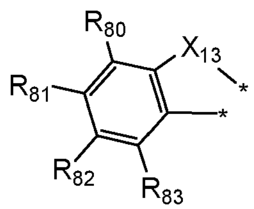

(10-8-2)

wherein in the formulae (10-8-1) and (10-8-2),

the two atomic bondings * are independently bonded with one pair of $R_{66'}$ and $R_{67'}$, $R_{67'}$ and $R_{68'}$, or $R_{68'}$ and $R_{69'}$;
$R_{80}$ to $R_{83}$ are independently a hydrogen atom, a substituted or unsubstituted alkyl group including 1 to 50 carbon atoms or a substituted or unsubstituted aryl group including 6 to 50 ring carbon atoms; and
$X_{13}$ is O or S.

In one embodiment, the compound (10) is a compound represented by the following formula (10-9):

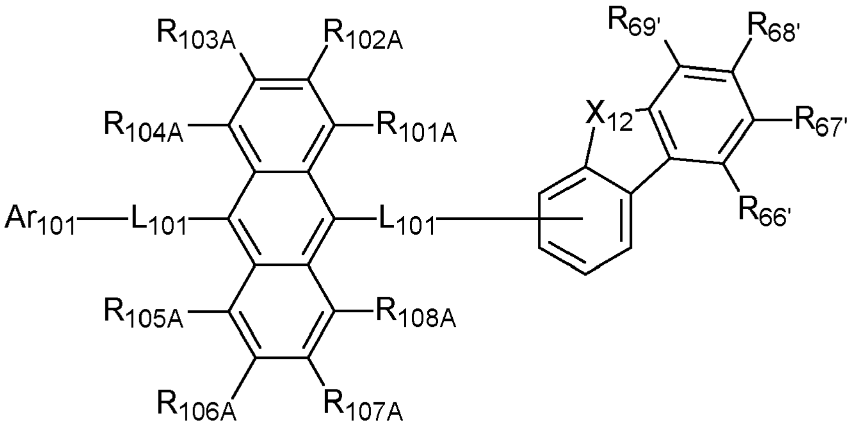

(10-9)

wherein in the formula (10-9),

$L_{101}$ and $Ar_{101}$ are as defined in the formula (10);
$R_{101A}$ to $R_{108A}$ are as defined in the formula (10-4);
$R_{66'}$ to $R_{69'}$ are as defined in the formula (10-4), provided that $R_{66'}$ and $R_{67'}$, $R_{67'}$ and $R_{68'}$, as well as $R_{68'}$ and $R_{69'}$ are not bonded with each other and do not form a substituted or unsubstituted, saturated or unsaturated ring; and
$X_{12}$ is O or S.

In one embodiment, the compound (10) is selected from the group consisting of compounds represented by the following formulae (10-10-1) to (10-10-4).

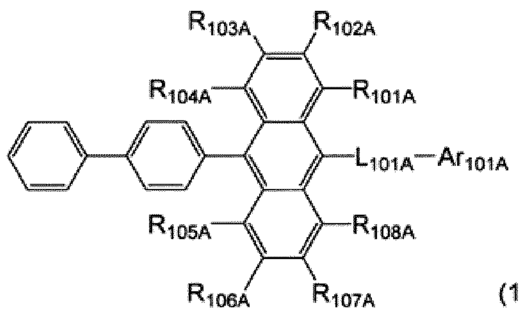

(10-10-1)

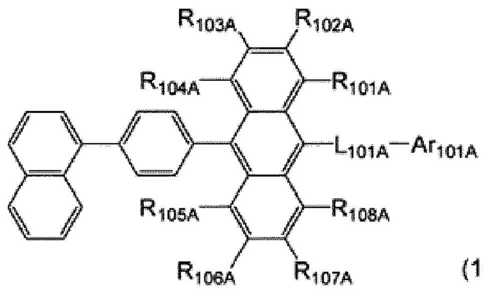

(10-10-2)

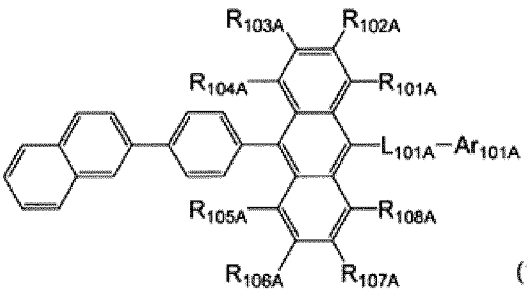

(10-10-3)

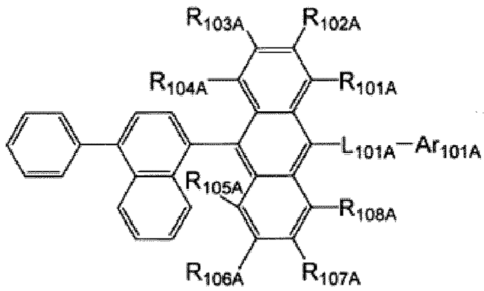

(10-10-4)

In the formulae (10-10-1H) to (10-10-4H), $L_{101A}$ and $Ar_{101A}$ are as defined in the formula (10-3).

In one embodiment, in the compound represented by the formula (10-1), at least one $Ar_{101}$ is a monovalent group having a structure represented by the following formula (50).

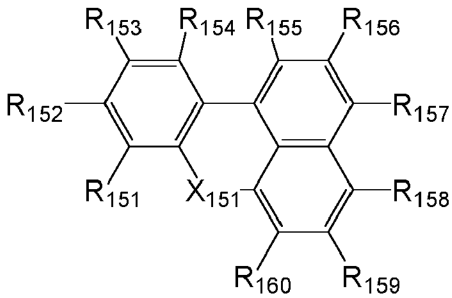

(50)

In the formula (50),
$X_{151}$ is O, S, or $C(R_{161})(R_{162})$.

One of $R_{151}$ to $R_{160}$ is a single bond which bonds with $L_{101}$.

One or more sets of adjacent two or more of $R_{151}$ to $R_{154}$ and one or more sets of adjacent two or more of $R_{155}$ to $R_{160}$, which are not a single bond which bonds with $L_{101}$, form a substituted or unsubstituted, saturated or unsaturated ring by bonding with each other, or do not form a substituted or unsubstituted, saturated or unsaturated ring.

$R_{161}$ and $R_{162}$ form a substituted or unsubstituted, saturated or unsaturated ring by bonding with each other, or do not form a substituted or unsubstituted, saturated or unsaturated ring.

$R_{161}$ and $R_{162}$ which do not form the substituted or unsubstituted, saturated or unsaturated ring, and $R_{151}$ to $R_{160}$ which are not a single bond which bonds with $L_{101}$ and do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R121)(R122)(R123), -C(=O)R124, -COOR125, -N(R126)(R127), a halogen atom, a cyano group, a nitro group, a substituted or unsubstituted aryl group including 6 to 50 ring carbon atoms, or a substituted or unsubstituted monovalent heterocyclic group including 5 to 50 ring atoms.

$Ar_{101}$, which is not a monovalent group having the structure represented by the formula (50) is a substituted or unsubstituted aryl group including 6 to 50 ring carbon atoms, or a substituted or unsubstituted divalent heterocyclic group including 5 to 50 ring atoms.

The position to be the single bond which bonds with $L_{101}$ in the formula (50) is not particularly limited. In one embodiment, one of $R_{151}$ to $R_{160}$ in the formula (50) is a single bond which bonds with $L_{101}$.

In one embodiment, $Ar_{101}$ is a monovalent group represented by the following formula (50-$R_{152}$), (50-$R_{153}$), (50-$R_{154}$), (50-$R_{157}$), or (50-$R_{158}$).

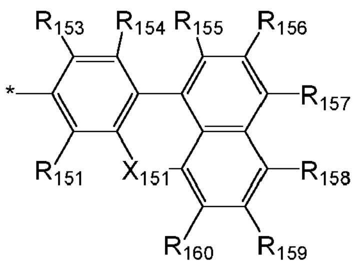

(50-$R_{152}$)

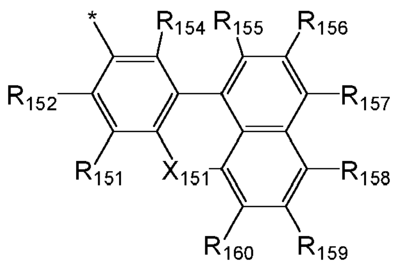

(50-$R_{153}$)

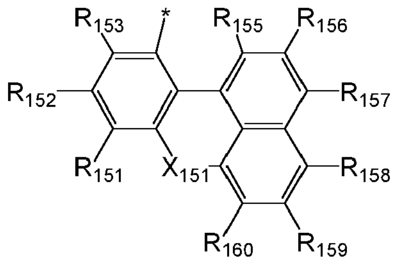

(50-$R_{154}$)

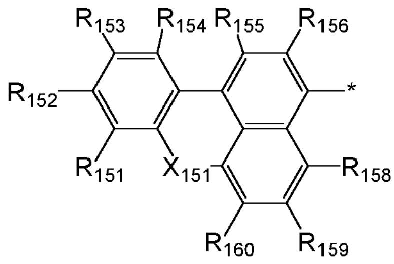

(50-$R_{157}$)

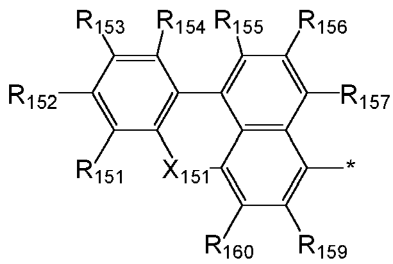

(50-$R_{158}$)

In the formulas (50-$R_{152}$), (50-$R_{153}$), (50-$R_{154}$), (50-$R_{157}$), and (50-$R_{158}$), $X_{151}$, $R_{151}$ to $R_{160}$ are as defined in the formula (50).

* is a single bond which bonds with $L_{101}$.

As for the compound represented by the formula (10), the following compounds can be given as specific examples. The compound represented by the formula (10) is not limited to these specific examples. In the following specific examples, "D" represents a deuterium atom.

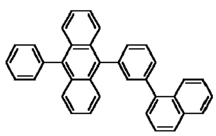
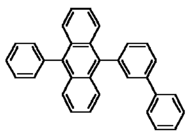
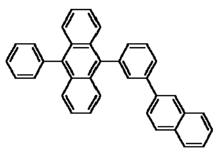
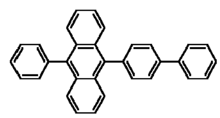

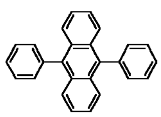
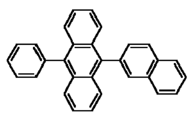
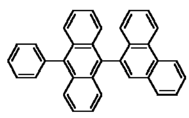
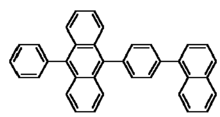

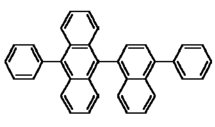
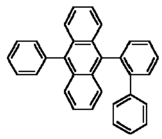
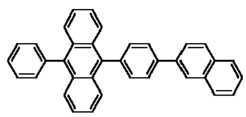
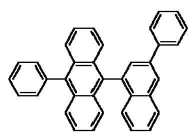

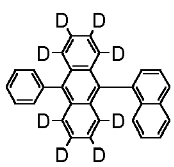
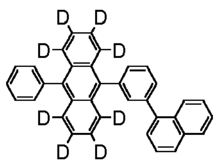
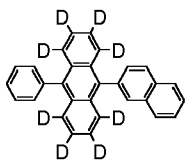
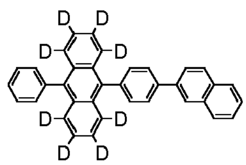

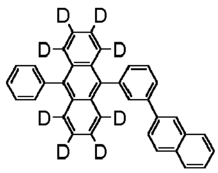
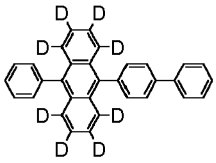
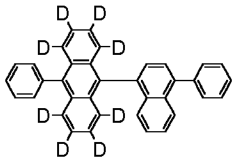
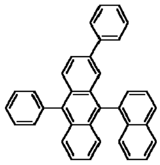
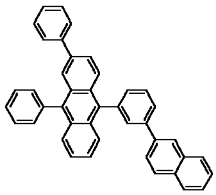
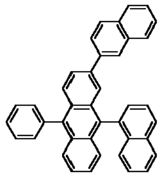
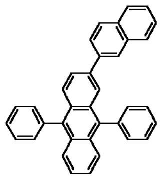
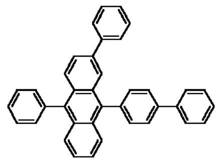
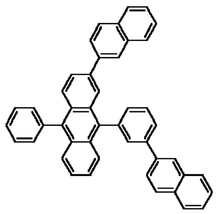
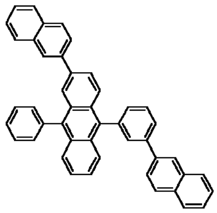
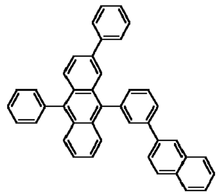
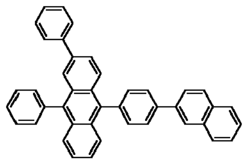
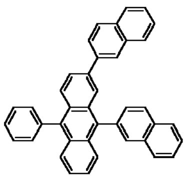
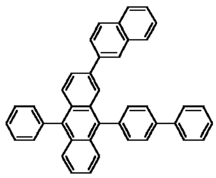
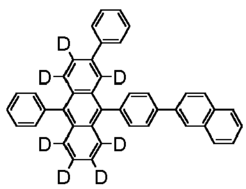
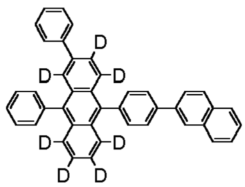
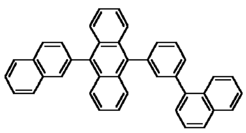
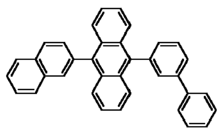
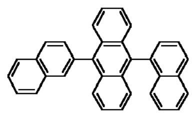
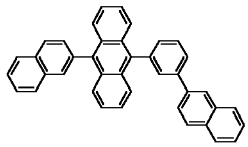
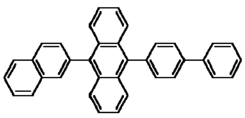
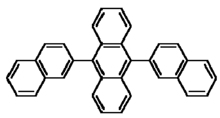
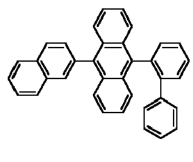
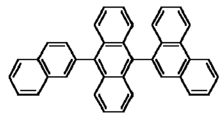
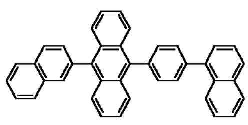
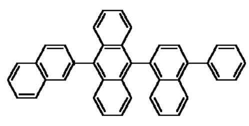
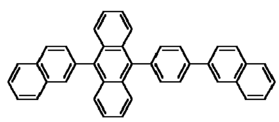
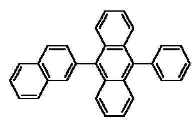
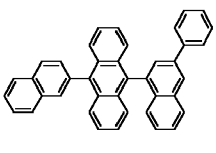
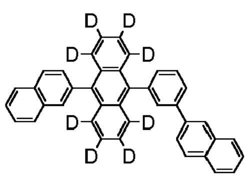
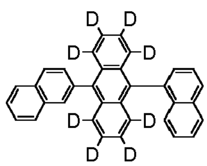
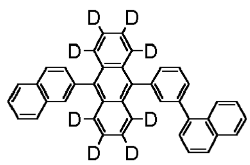

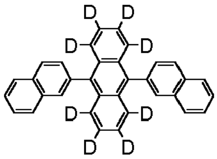
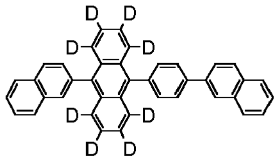
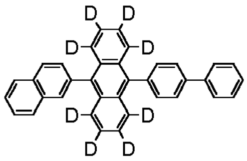
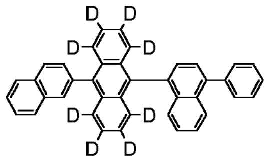

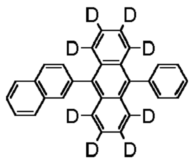
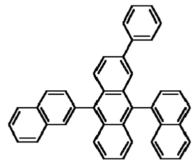
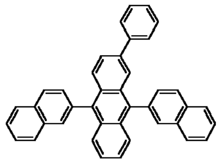
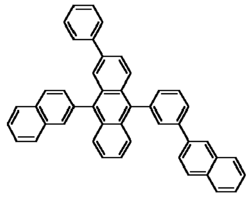

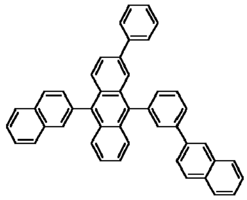
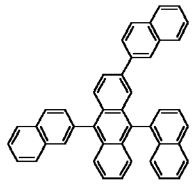
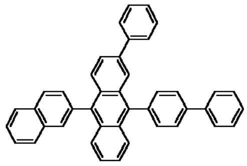
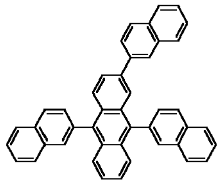

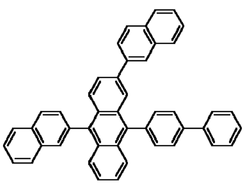
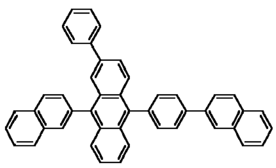
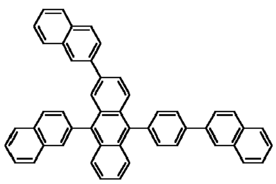
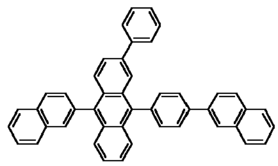

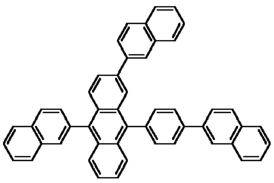
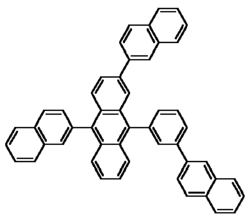
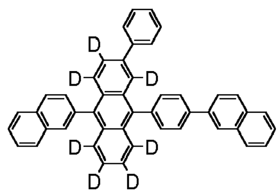
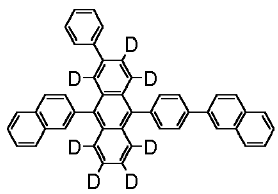

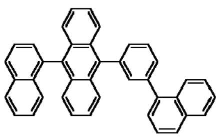
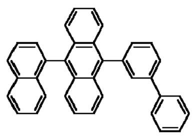
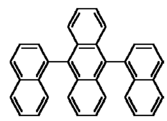
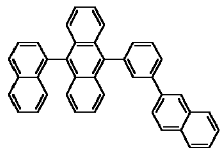

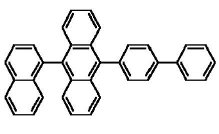
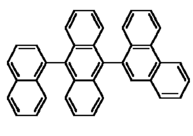
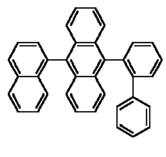
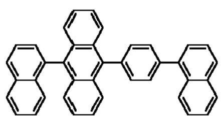

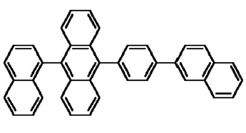
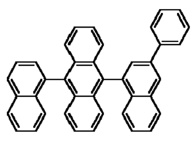
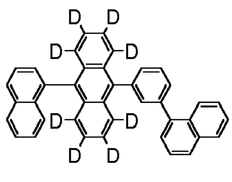
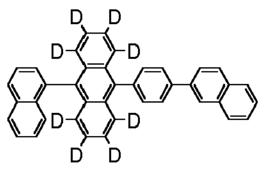

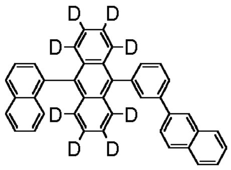 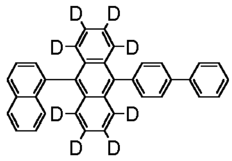 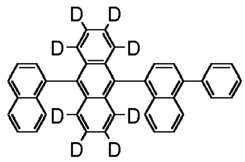 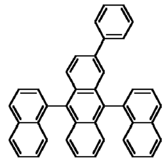

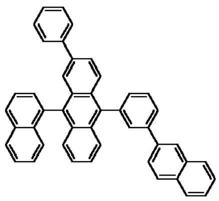 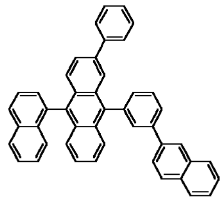 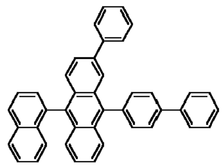 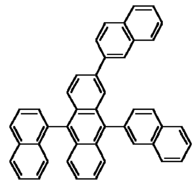

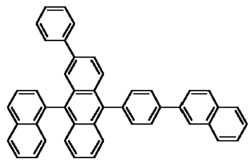 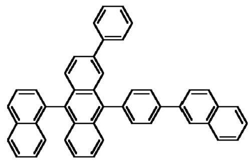 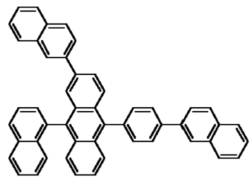 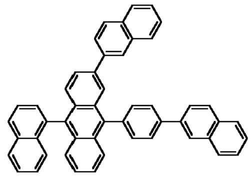

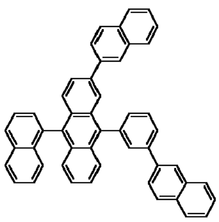 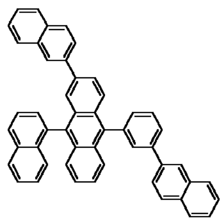 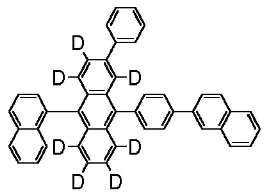 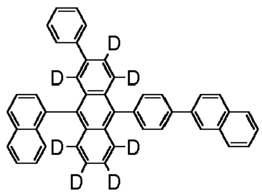

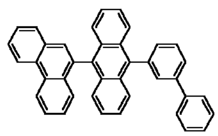 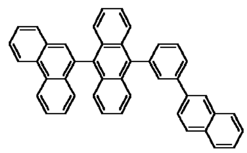 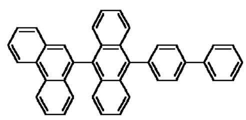 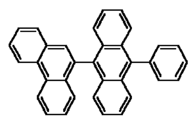

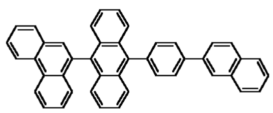 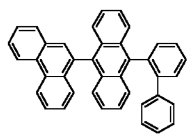 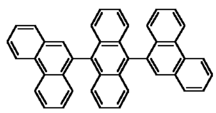 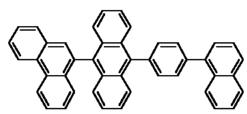

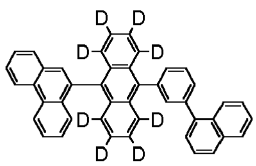 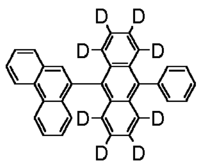 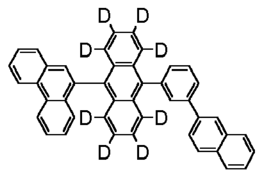 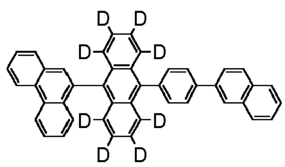

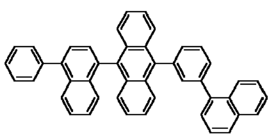 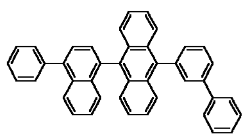 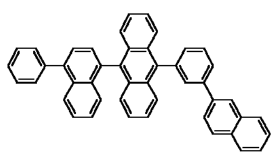 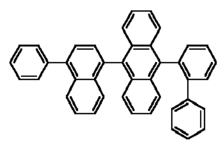

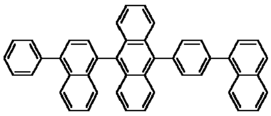 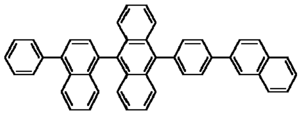 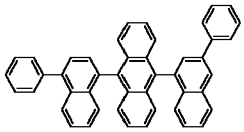

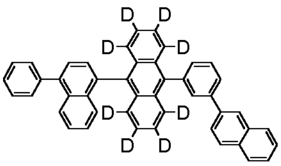 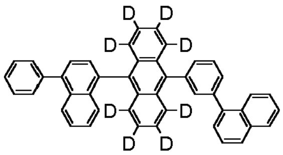 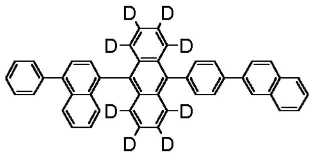

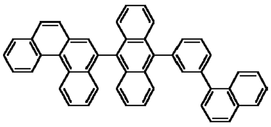 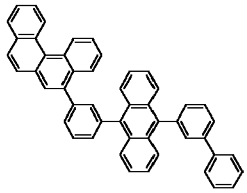 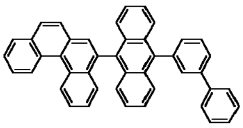 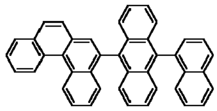

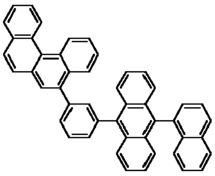 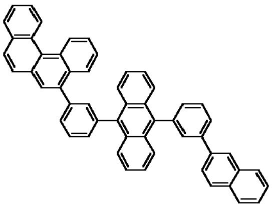 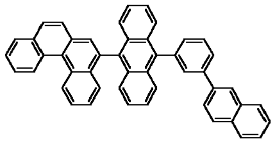 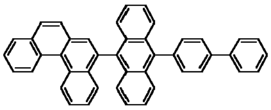

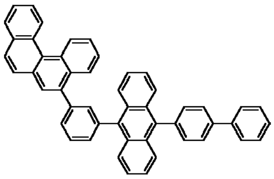 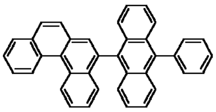 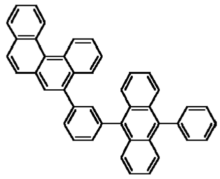 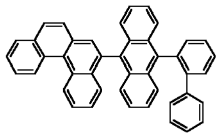

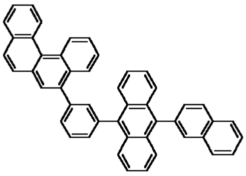 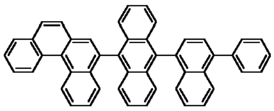 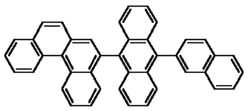 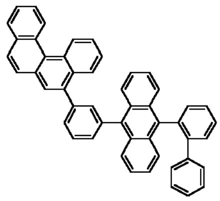

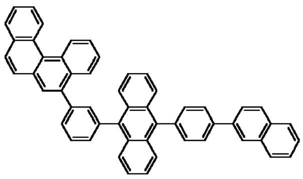 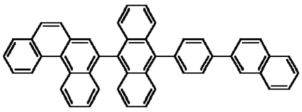 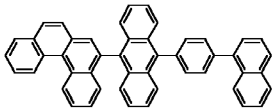

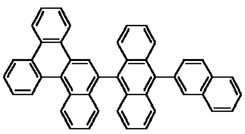 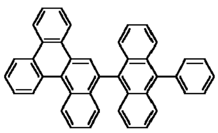 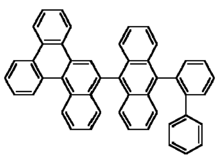 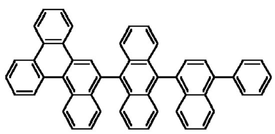

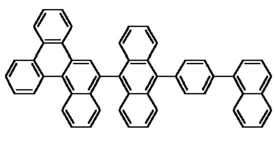
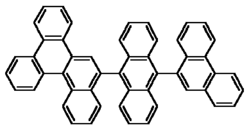
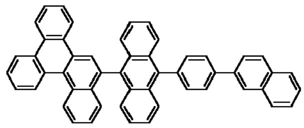
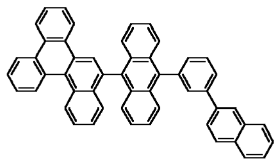

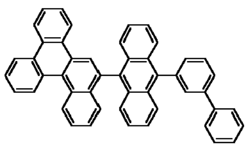
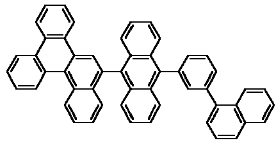
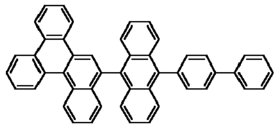
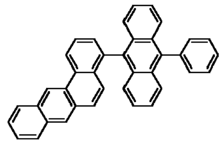

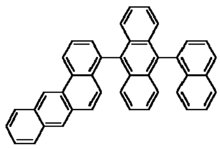
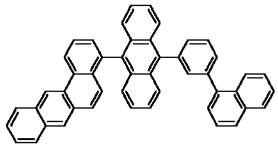
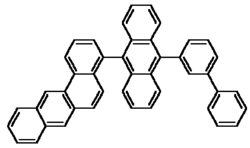
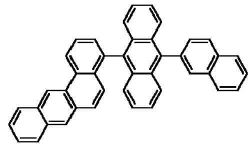

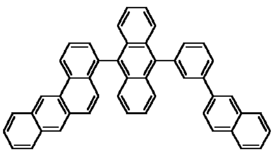
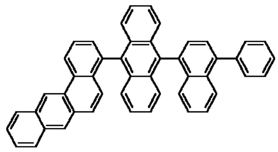
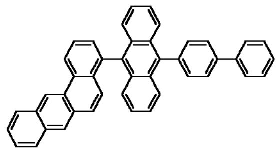

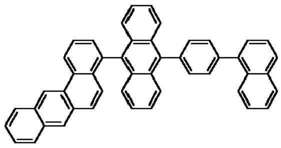
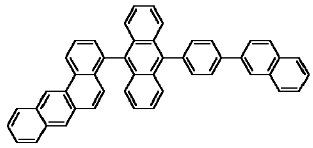
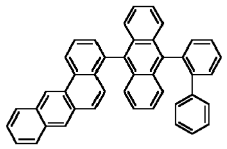

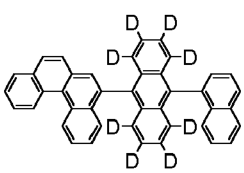
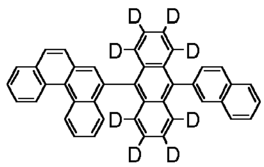
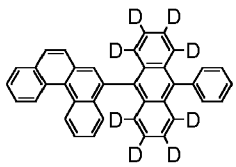
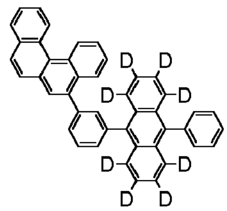

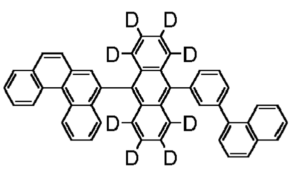
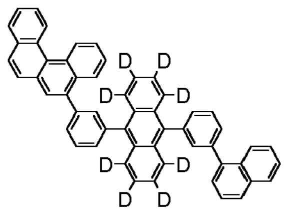
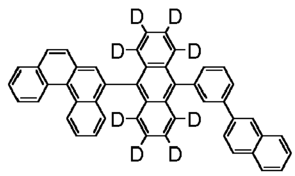

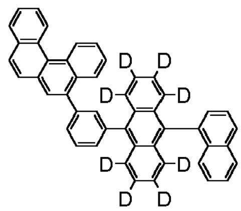
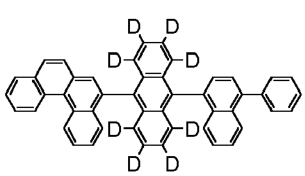
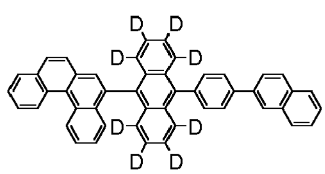

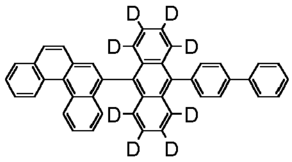
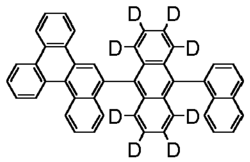
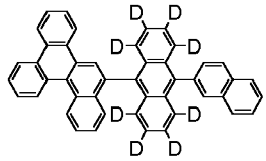
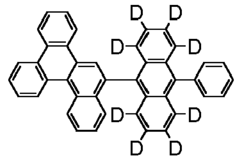

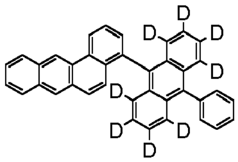
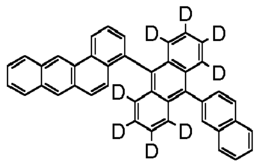
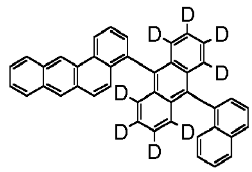
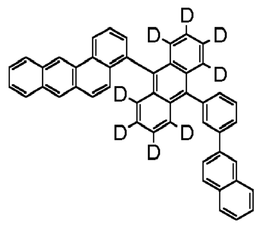

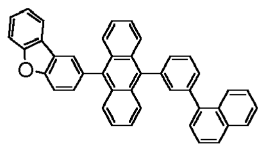
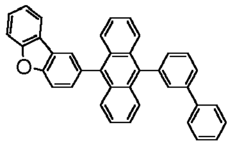
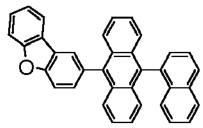
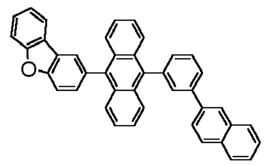

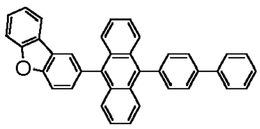
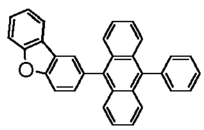
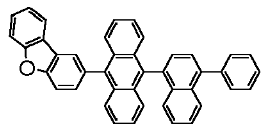
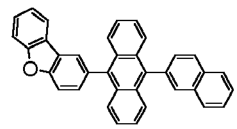

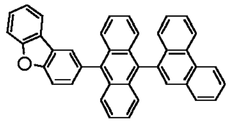
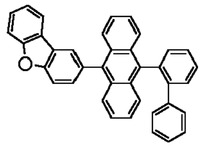
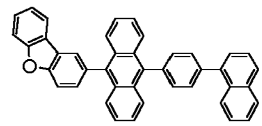
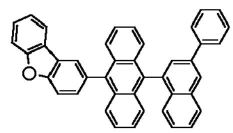

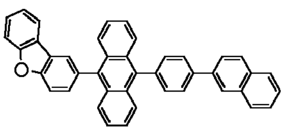
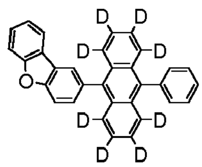
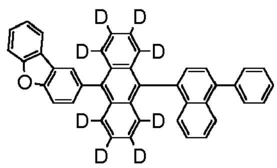
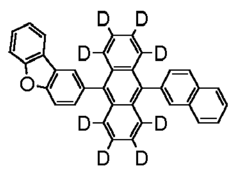

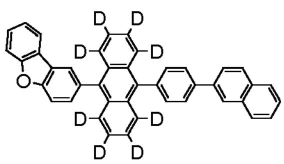
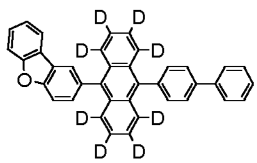
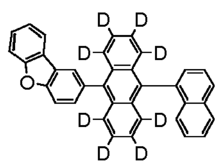
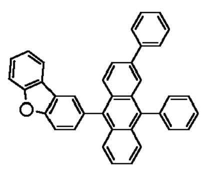

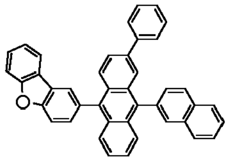 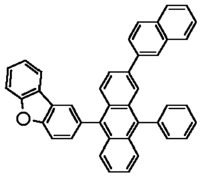 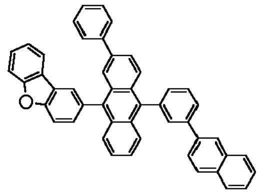 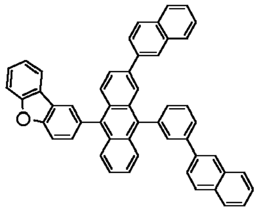

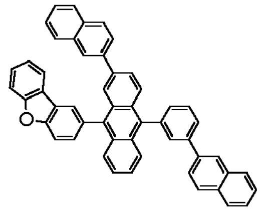 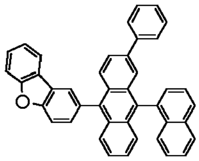 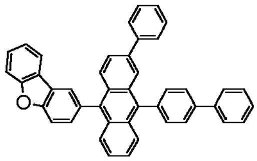 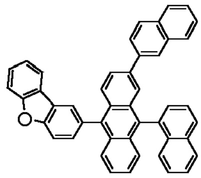

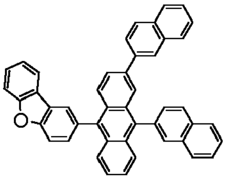 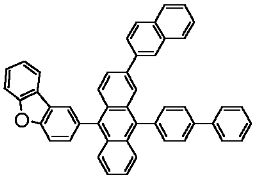 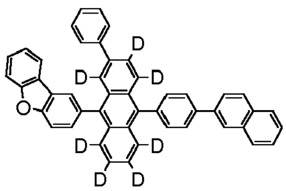 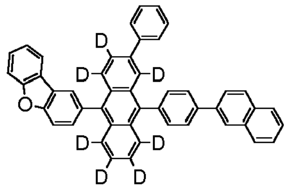

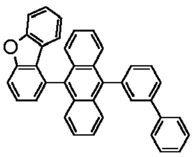 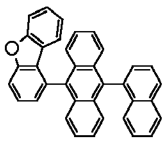 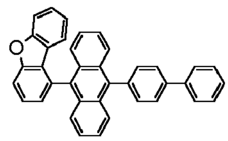 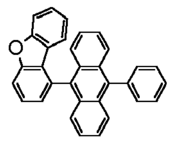

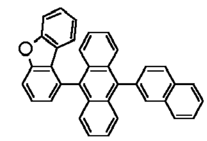 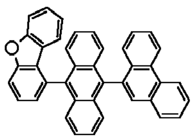 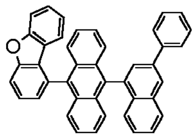 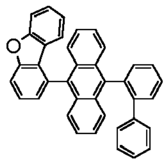

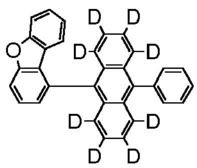 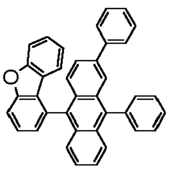 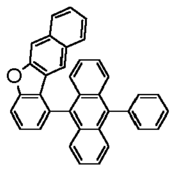 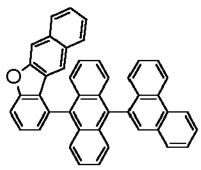

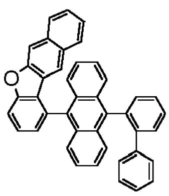 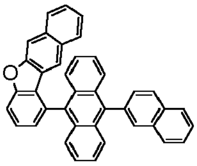 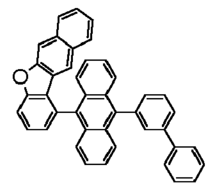 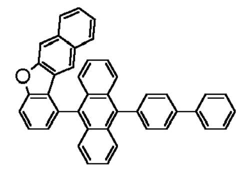

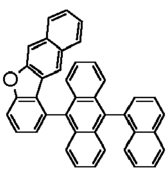 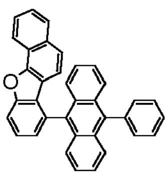 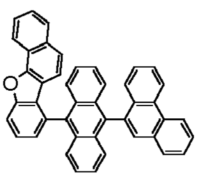 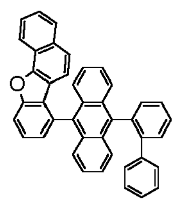

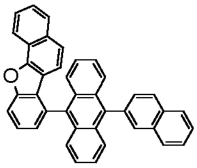
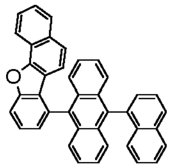
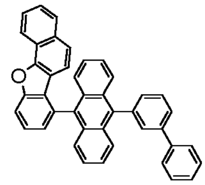
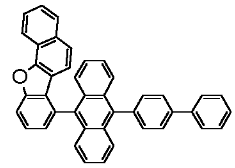
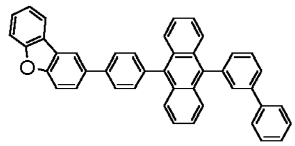
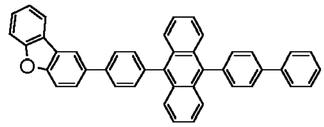
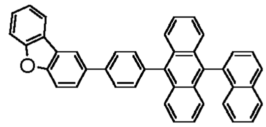
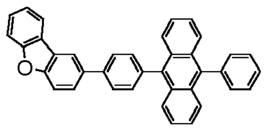
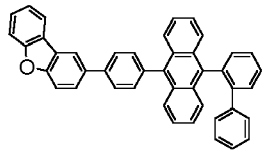
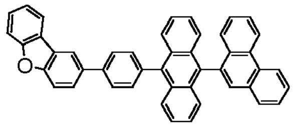
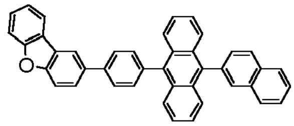
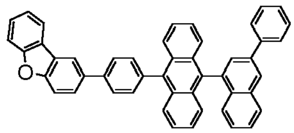
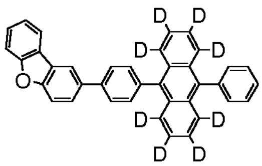
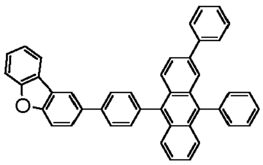
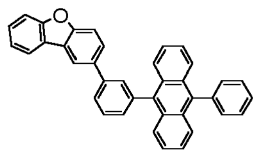
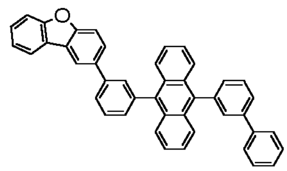
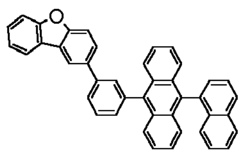
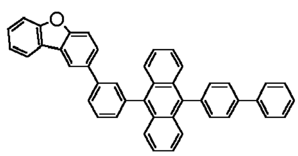
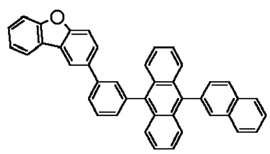
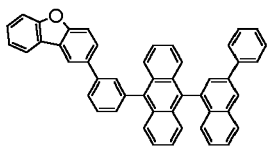
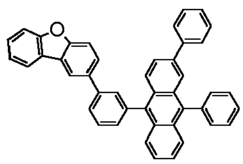
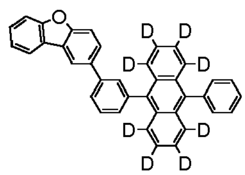
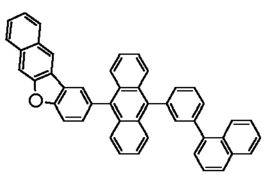
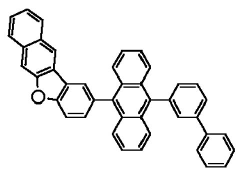
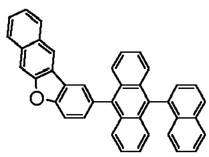
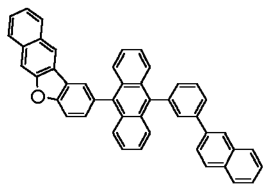

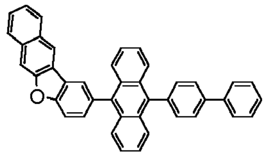
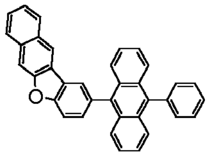
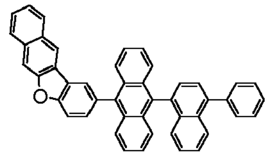
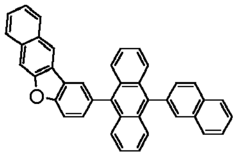
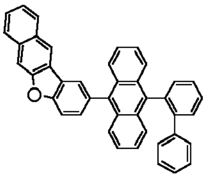
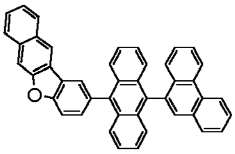
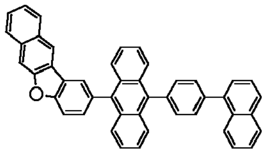
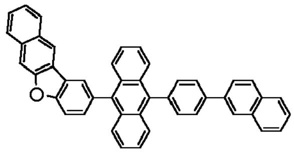
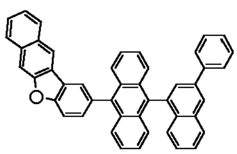
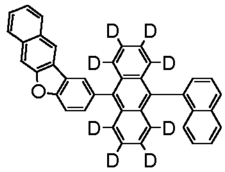
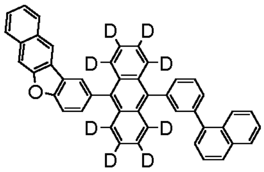
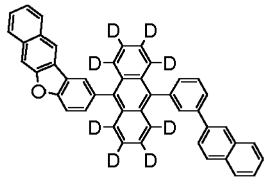
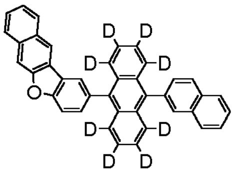
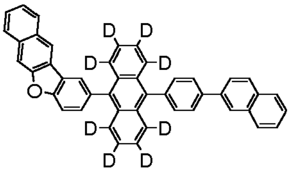
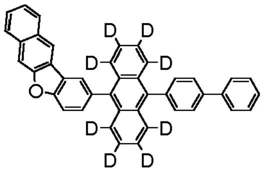
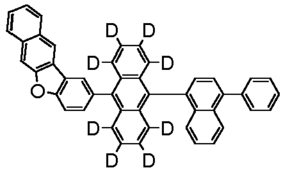
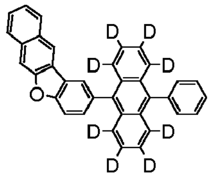
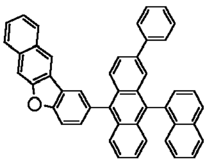
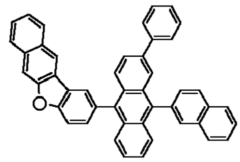
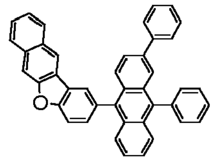
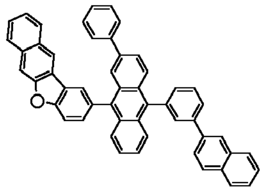
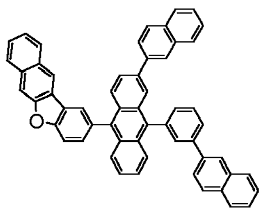
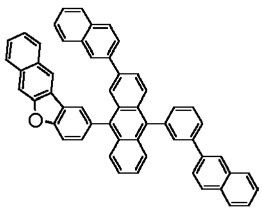
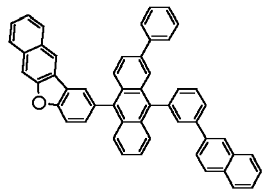
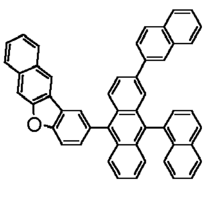
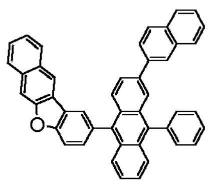
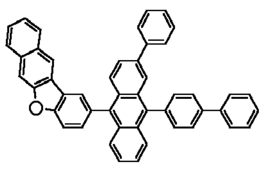
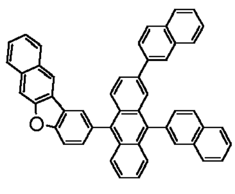
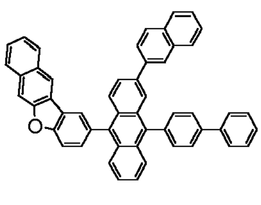
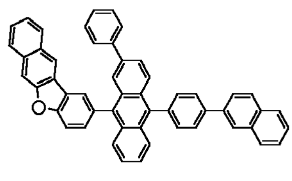
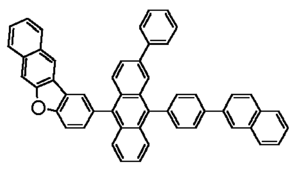

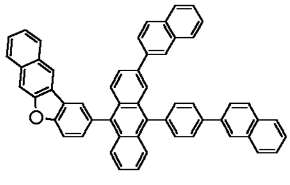
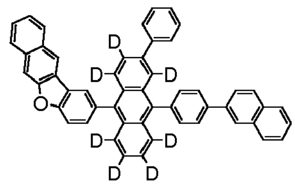
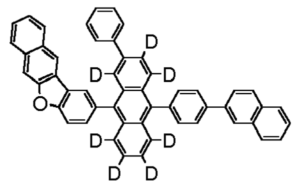

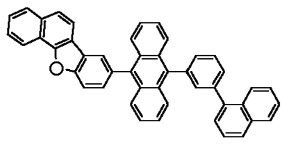
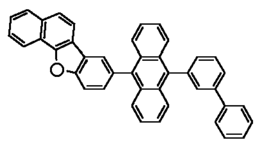
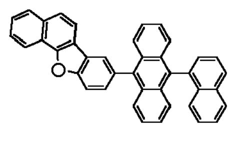
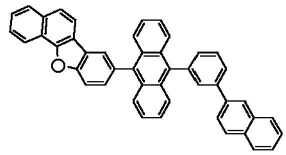

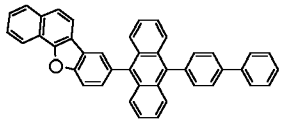
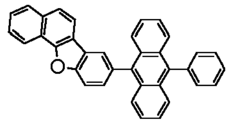
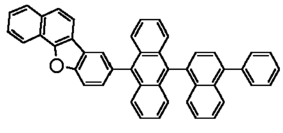
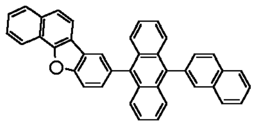

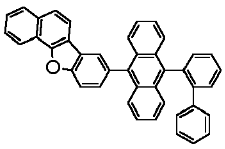
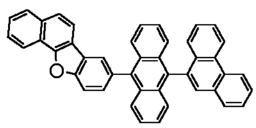
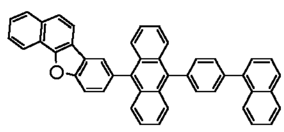
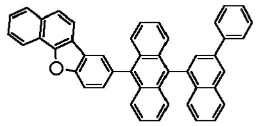

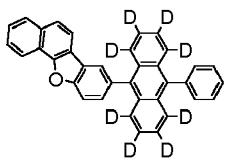
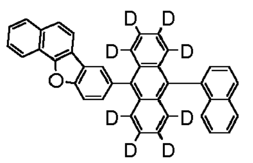
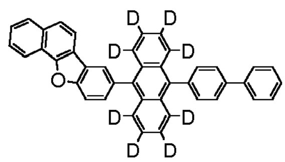
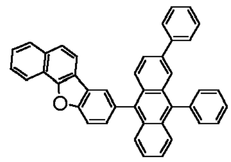

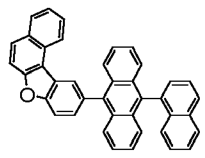
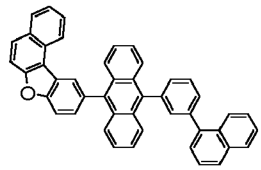
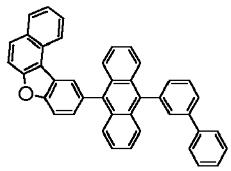
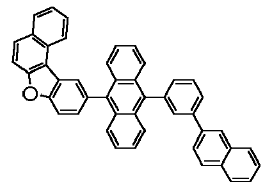

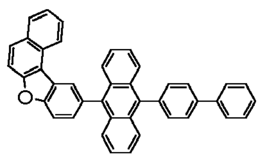
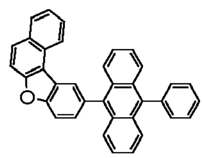
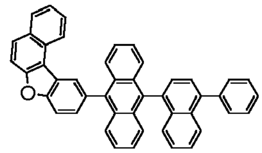
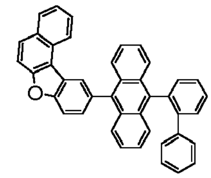

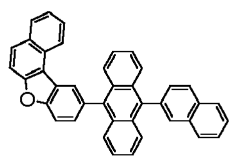
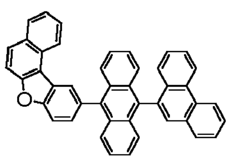
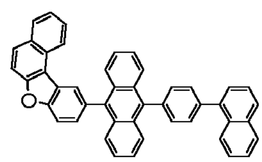
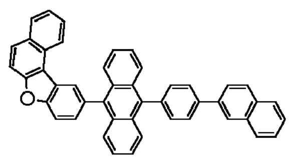

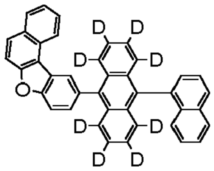
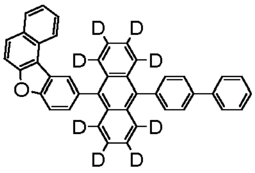
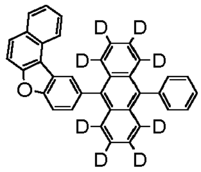
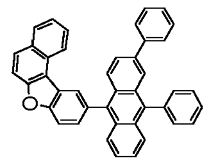

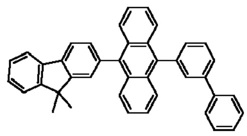
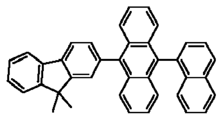
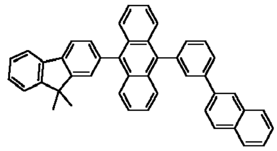
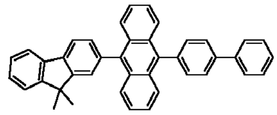

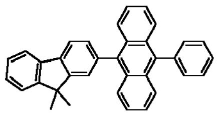
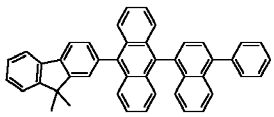
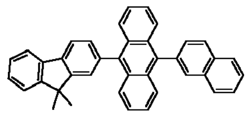
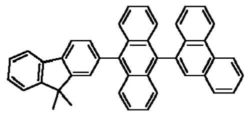

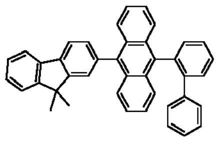
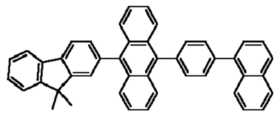
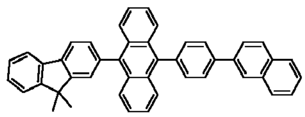
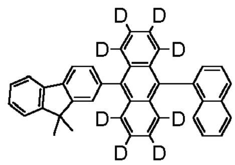

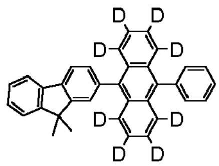
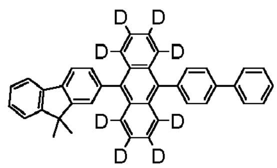
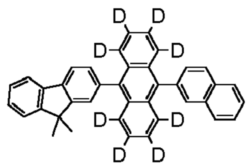
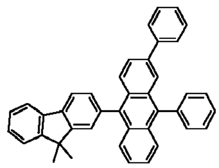

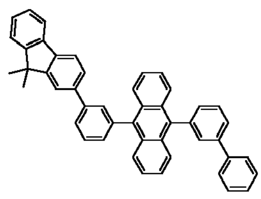
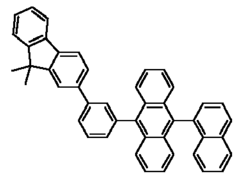
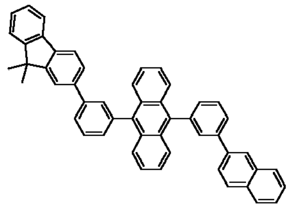
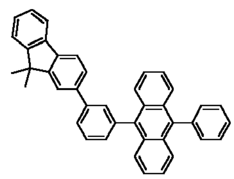

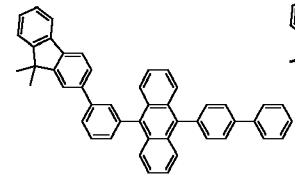
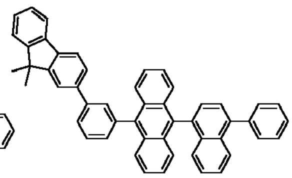
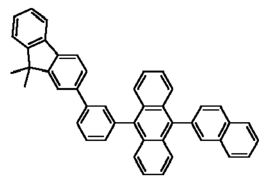
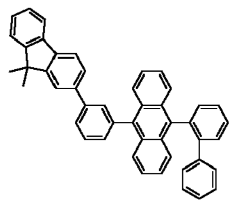

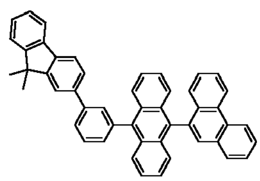
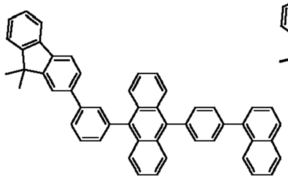
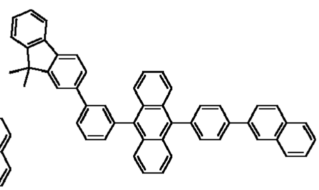
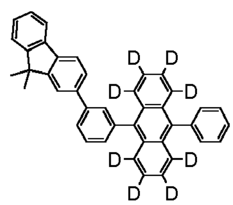

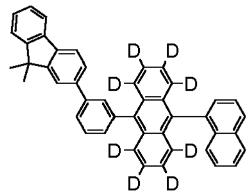
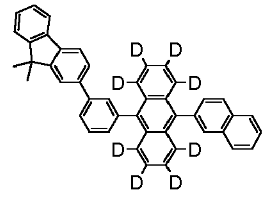
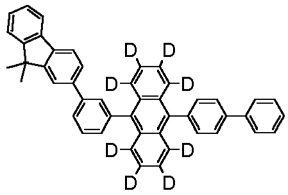
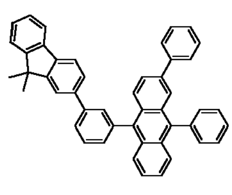

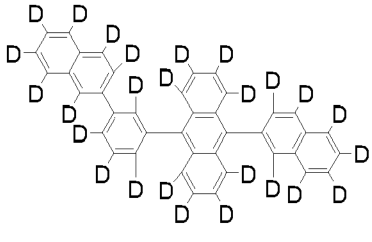
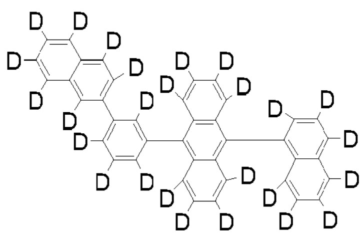
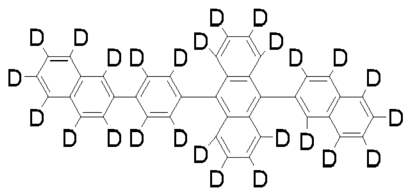

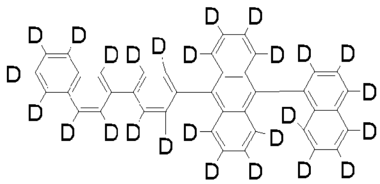
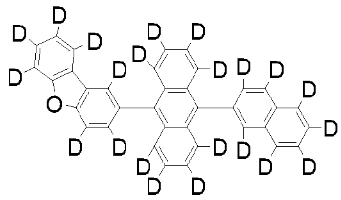
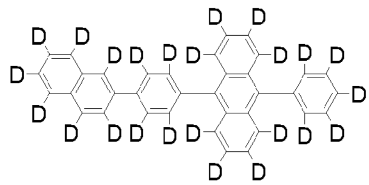

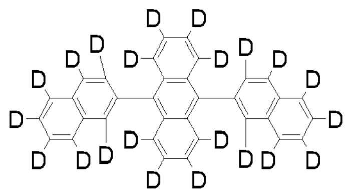
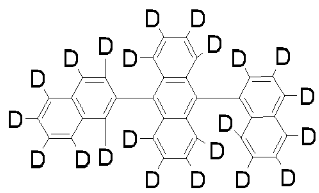
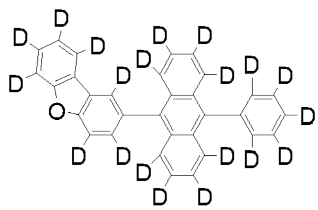

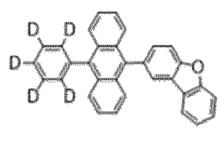
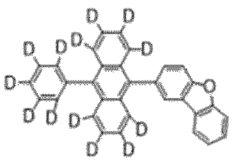
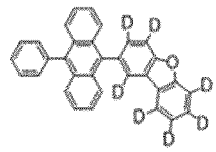
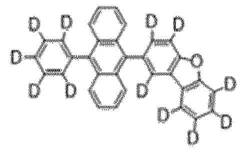

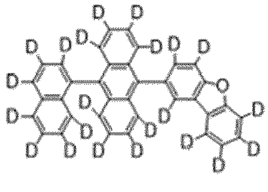
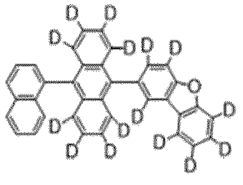
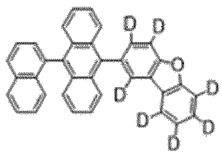
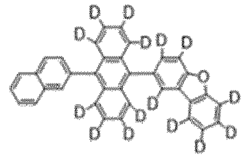

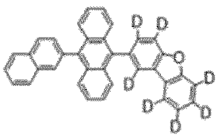
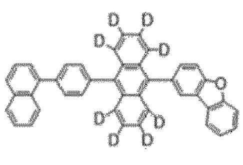
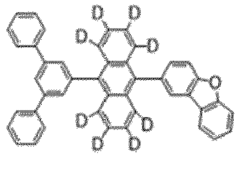
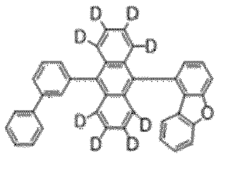

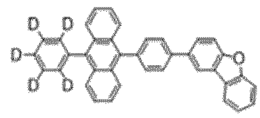 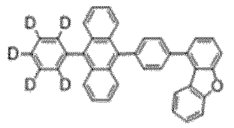 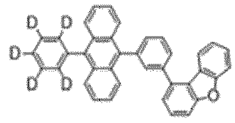 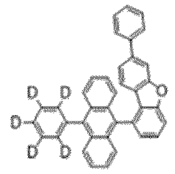

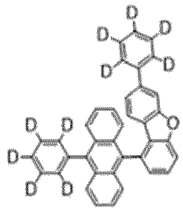 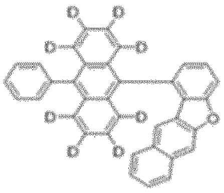 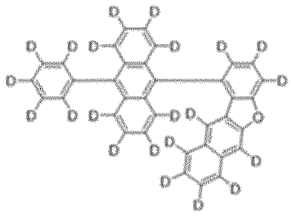 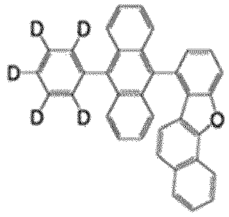

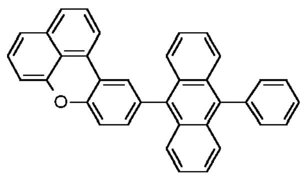 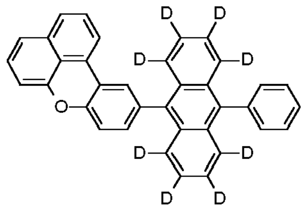 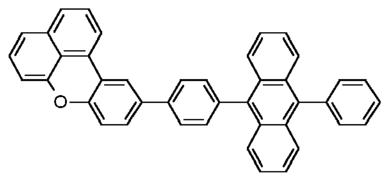

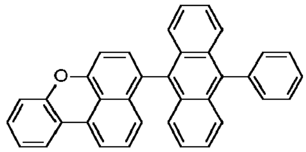 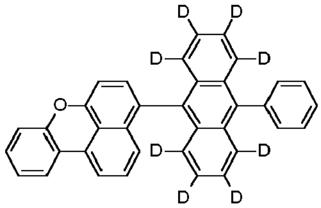

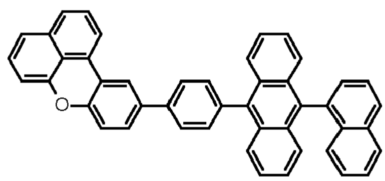 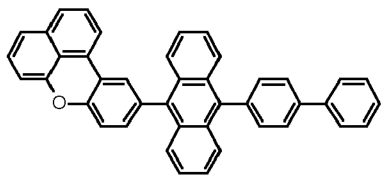

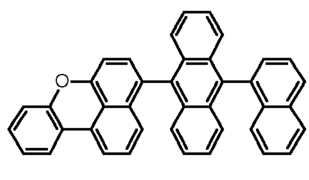 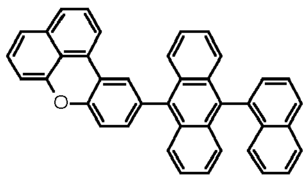

In the case that the emitting layer comprises the compound represented by formula (I) as a dopant and at least one host, wherein preferred hosts are mentioned above, and the host is more preferably at least one compound represented by formula (10), the content of the at least one compound represented by formula (I) is preferably 0.5 mass% to 70 mass%, more preferably 0.5 to 30 mass%, further preferably 1 to 30 mass%, still further preferably 1 to 20 mass%, and particularly preferably 1 to 10 mass%, further particularly preferably 1 to 5 mass%, relative to the entire mass of the emitting layer.

The content of the at least one host, wherein preferred hosts are mentioned above, preferably the at least one compound represented by formula (10) is preferably 30 mass% to 99.9 mass%, more preferably 70 to 99.5 mass%, further preferably 70 to 99 mass%, still further preferably 80 to 99 mass%, and particularly preferably 90 to 99 mass%, further particularly preferably 95 to 99 mass %, relative to the entire mass of the emitting layer.

**An explanation will be made on the layer configuration of the organic EL device according to one aspect of the invention.**

An organic EL device according to one aspect of the invention comprises a cathode, an anode, and one or more

organic thin film layers comprising an emitting layer disposed between the cathode and the anode. The organic layer comprises at least one layer composed of an organic compound. Alternatively, the organic layer is formed by laminating a plurality of layers composed of an organic compound. The organic layer may further comprise an inorganic compound in addition to the organic compound.

At least one of the organic layers is an emitting layer. The organic layer may be constituted, for example, as a single emitting layer, or may comprise other layers which can be adopted in the layer structure of the organic EL device. The layer that can be adopted in the layer structure of the organic EL device is not particularly limited, but examples thereof include a hole-transporting zone (comprising at least one hole-transporting layer and preferably in addition at least one of a hole-injecting layer, an electron-blocking layer, an exciton-blocking layer, etc.), an emitting layer, a spacing layer, and an electron-transporting zone (comprising at least one electron-transporting layer and preferably in addition at least one of an electron-injecting layer, a hole-blocking layer, etc.) provided between the cathode and the emitting layer.

The organic EL device according to one aspect of the invention may be, for example, a fluorescent or phosphorescent monochromatic light emitting device or a fluorescent/phosphorescent hybrid white light emitting device. Preferably, the organic EL device is a fluorescent monochromatic light emitting device, more preferably a blue fluorescent monochromatic light emitting device or a fluorescent/phosphorescent hybrid white light emitting device. Blue fluorescence means a fluorescence at 400 to 500 nm (peak maximum), preferably at 430 nm to 490 nm (peak maximum).

Further, it may be a simple type device having a single emitting unit or a tandem type device having a plurality of emitting units.

The "emitting unit" in the specification is the smallest unit that comprises organic layers, in which at least one of the organic layers is an emitting layer and light is emitted by recombination of injected holes and electrons.

In addition, the "emitting layer" described in the present specification is an organic layer having an emitting function. The emitting layer is, for example, a phosphorescent emitting layer, a fluorescent emitting layer or the like, preferably a fluorescent emitting layer, more preferably a blue fluorescent emitting layer, and may be a single layer or a stack of a plurality of layers.

The emitting unit may be a stacked type unit having a plurality of phosphorescent emitting layers or fluorescent emitting layers. In this case, for example, a spacing layer for preventing excitons generated in the phosphorescent emitting layer from diffusing into the fluorescent emitting layer may be provided between the respective light-emitting layers.

As the simple type organic EL device, a device configuration such as anode/emitting unit/cathode can be given.

Examples for representative layer structures of the emitting unit are shown below. The layers in parentheses are provided arbitrarily.

(a) (Hole-injecting layer/) Hole-transporting layer/Fluorescent emitting layer (/Electron- transporting layer/Electron-injecting layer)

(b) (Hole-injecting layer/) Hole-transporting layer/Phosphorescent emitting layer (/Electron-transporting layer/Electron-injecting layer)

(c) (Hole-injecting layer/) Hole-transporting layer/First fluorescent emitting layer/Second fluorescent emitting layer (/Electron-transporting layer/Electron-injecting layer)

(d) (Hole-injecting layer/) Hole-transporting layer/First phosphorescent layer/Second phosphorescent layer (/Electron-transporting layer/Electron-injecting layer)

(e) (Hole-injecting layer/) Hole-transporting layer/Phosphorescent emitting layer/Spacing layer /Fluorescent emitting layer (/Electron-transporting layer/Electron-injecting layer)

(f) (Hole-injecting layer/) Hole-transporting layer/First phosphorescent emitting layer/Second phosphorescent emitting layer/Spacing layer/Fluorescent emitting layer (/Electron-transporting layer/Electron-injecting layer)

(g) (Hole-injecting layer/) Hole-transporting layer/First phosphorescent layer/Spacing layer/ Second phosphorescent emitting layer/Spacing layer/Fluorescent emitting layer (/Electron-transporting layer / Electron-injecting layer)

(h) (Hole-injecting layer/) Hole-transporting layer/Phosphorescent emitting layer/Spacing layer/First fluorescent emitting layer/Second fluorescent emitting layer (/Electron-transporting Layer/Electron-injecting Layer)

(i) (Hole-injecting layer/) Hole-transporting layer/Electron-blocking layer/Fluorescent emitting layer (/Electron-transporting layer/Electron-injecting layer)

(j) (Hole-injecting layer/) Hole-transporting layer/Electron-blocking layer/Phosphorescent emitting layer (/Electron-transporting layer /Electron-injecting layer)

(k) (Hole-injecting layer/) Hole-transporting layer/Exciton-blocking layer/Fluorescent emitting layer (/Electron-transporting layer/Electron-injecting layer)

(l) (Hole-injecting layer/) Hole-transporting layer/Exciton-blocking layer/Phosphorescent emitting layer (/Electron-transporting layer/Electron-injecting layer)

(m) (Hole-injecting layer/) First hole-transporting Layer/Second hole-transporting Layer/ Fluorescent emitting layer (/Electron-transporting layer/electron-injecting Layer)

(n) (Hole-injecting layer/) First hole-transporting layer/Second hole-transporting layer/ Fluorescent emitting layer

(/First electron-transporting layer/Second electron-transporting layer /Electron-injection layer)
(o) (Hole-injecting layer/) First hole-transporting layer /Second hole-transporting layer/Phosphorescent emitting layer (/Electron-transporting layer /Electron-injecting Layer)
(p) (Hole-injecting layer/) First hole-transporting layer/Second hole-transporting layer /Phosphorescent emitting layer (/First electron-transporting Layer/Second electron-transporting layer /Electron-injecting layer)
(q) (Hole-injecting layer/) Hole-transporting layer/Fluorescent emitting layer/Hole-blocking layer (/Electron-transporting layer/Electron-injecting layer)
(r) (Hole-injecting layer /) Hole-transporting layer/Phosphorescent emitting layer/ Hole-blocking layer (/ Electron-transport layer/ Electron-injecting layer)
(s) (Hole-injecting layer/) Hole-transporting layer/Fluorescent emitting layer /Exciton-blocking layer (/Electron-transporting layer/Electron-injecting layer)
(t) (Hole-injecting layer/) Hole-transporting layer/Phosphorescent emitting layer /Exciton- blocking layer (/Electron-transporting layer/Electron-injecting layer)

The layer structure of the organic EL device according to one aspect of the invention is not limited to the examples mentioned above.

For example, when the organic EL device has a hole-injecting layer and a hole-transporting layer, it is preferred that a hole-injecting layer be provided between the hole-transporting layer and the anode. Further, when the organic EL device has an electron-injecting layer and an electron-transporting layer, it is preferred that an electron-injecting layer be provided between the electron-transporting layer and the cathode. Further, each of the hole-injecting layer, the hole-transporting layer, the electron-transporting layer and the electron-injecting layer may be formed of a single layer or be formed of a plurality of layers.

The plurality of phosphorescent emitting layer, and the plurality of the phosphorescent emitting layer and the fluorescent emitting layer may be emitting layers that emit mutually different colors. For example, the emitting unit (f) may include a hole-transporting layer/first phosphorescent layer (red light emission)/ second phosphorescent emitting layer (green light emission)/spacing layer/fluorescent emitting layer (blue light emission)/electron-transporting layer.

An electron-blocking layer may be provided between each light emitting layer and the hole-transporting layer or the spacing layer. Further, a hole-blocking layer may be provided between each emitting layer and the electron-transporting layer. By providing the electron-blocking layer or the hole-blocking layer, it is possible to confine electrons or holes in the emitting layer, thereby to improve the recombination probability of carriers in the emitting layer, and to improve light emitting efficiency.

As a representative device configuration of a tandem type organic EL device, for example, a device configuration such as anode/first emitting unit/intermediate layer/second emitting unit/cathode can be given.

The first emitting unit and the second emitting unit are independently selected from the above-mentioned emitting units, for example.

The intermediate layer is also generally referred to as an intermediate electrode, an intermediate conductive layer, a charge generating layer, an electron withdrawing layer, a connecting layer, a connector layer, or an intermediate insulating layer. The intermediate layer is a layer that supplies electrons to the first emitting unit and holes to the second emitting unit, and can be formed from known materials.

FIG. 1 shows a schematic configuration of one example of the organic EL device of the invention. The organic EL device 1 comprises a substrate 2, an anode 3, a cathode 4 and an emitting unit 10 provided between the anode 3 and the cathode 4. The emitting unit 10 comprises an emitting layer 5 preferably comprising a host material and a dopant. A hole injecting and transporting layer 6 or the like may be provided between the emitting layer 5 and the anode 3 and an electron injecting layer 8 and an electron transporting layer 7 or the like (electron injecting and transporting unit 11) may be provided between the emitting layer 5 and the cathode 4. An electron-barrier layer may be provided on the anode 3 side of the emitting layer 5 and a hole-barrier layer may be provided on the cathode 4 side of the emitting layer 5. Due to such configuration, electrons or holes can be confined in the emitting layer 5, whereby possibility of generation of excitons in the emitting layer 5 can be improved.

## Hereinbelow, an explanation will be made on function, materials, etc. of each layer constituting the organic EL device described in the present specification.

### (Substrate)

The substrate is used as a support of the organic EL device. The substrate preferably has a light transmittance of 50% or more in the visible light region with a wavelength of 400 to 700 nm, and a smooth substrate is preferable. Examples of the material of the substrate include sodalime glass, aluminosilicate glass, quartz glass, plastic and the like. As a substrate, a flexible substrate can be used. The flexible substrate means a substrate that can be bent (flexible), and

examples thereof include a plastic substrate and the like. Specific examples of the material for forming the plastic substrate include polycarbonate, polyallylate, polyether sulfone, polypropylene, polyester, polyvinyl fluoride, polyvinyl chloride, polyimide, polyethylene naphthalate and the like. Also, an inorganic vapor deposited film can be used.

**(Anode)**

As the anode, for example, it is preferable to use a metal, an alloy, a conductive compound, a mixture thereof or the like and having a high work function (specifically, 4.0 eV or more). Specific examples of the material of the anode include indium oxide-tin oxide (ITO: Indium Tin Oxide), indium oxide-tin oxide containing silicon or silicon oxide, indium oxide-zinc oxide, indium oxide containing tungsten oxide or zinc oxide, graphene and the like. In addition, it is also possible to use gold, silver, platinum, nickel, tungsten, chromium, molybdenum, iron, cobalt, copper, palladium, titanium, and nitrides of these metals (e.g. titanium oxide).

The anode is normally formed by depositing these materials on the substrate by a sputtering method. For example, indium oxide-zinc oxide can be formed by a sputtering method by using a target in which 1 to 10 mass% zinc oxide is added relative to indium oxide. Further, indium oxide containing tungsten oxide or zinc oxide can be formed by a sputtering method by using a target in which 0.5 to 5 mass% of tungsten oxide or 0.1 to 1 mass% of zinc oxide is added relative to indium oxide.

As other methods for forming the anode, a vacuum deposition method, a coating method, an inkjet method, a spin coating method or the like can be given. When silver paste or the like is used, it is possible to use a coating method, an inkjet method or the like.

The hole-injecting layer formed in contact with the anode is formed by using a material that allows easy hole injection regardless of the work function of the anode. For this reason, in the anode, it is possible to use a common electrode material, e.g. a metal, an alloy, a conductive compound and a mixture thereof. Specifically, a material having a small work function such as alkaline metals such as lithium and cesium; alkaline earth metals such as calcium and strontium; alloys containing these metals (for example, magnesium-silver and aluminum-lithium); rare earth metals such as europium and ytterbium; and an alloy containing rare earth metals.

**(Hole-transporting layer) / (Hole-injecting layer)**

The hole-transporting layer is an organic layer that is formed between the emitting layer and the anode, and has a function of transporting holes from the anode to the emitting layer. If the hole-transporting layer is composed of plural layers, an organic layer that is nearer to the anode may often be defined as the hole-injecting layer. The hole-injecting layer has a function of injecting holes efficiently to the organic layer unit from the anode. Said hole injection layer is generally used for stabilizing hole injection from anode to hole transporting layer which is generally consist of organic materials. Organic material having good contact with anode or organic material with p-type doping is preferably used for the hole injection layer.

p-doping usually consists of one or more p-dopant materials and one or more matrix materials. Matrix materials preferably have shallower HOMO level and p-dopant preferably have deeper LUMO level to enhance the carrier density of the layer. Specific examples for p-dopants are the below mentioned acceptor materials. Suitable matrix materials are the hole transport materials mentioned below, preferably aromatic or heterocyclic amine compounds.

Acceptor materials, or fused aromatic hydrocarbon materials or fused heterocycles which have high planarity, are preferably used as p-dopant materials for the hole injection layer.

Specific examples for acceptor materials are, quinone compounds with one or more electron withdrawing groups, such as $F_4$TCNQ (2,3,5,6-tetrafluoro-7,7,8,8-tetracyanoquinodimethane), and 1,2,3-tris[(cyano)(4-cyano-2,3,5,6-tetrafluorophenyl)methylene]cyclopropane; hexa-azatriphenylene compounds with one or more electron withdrawing groups, such as hexa-azatriphenylene-hexanitrile; aromatic hydrocarbon compounds with one or more electron withdrawing groups; and aryl boron compounds with one or more electron withdrawing groups. Preferred p-dopants are quinone compounds with one or more electron withdrawing groups, such as $F_4$TCNQ, 1,2,3-Tris[(cyano)(4-cyano-2,3,5,6-tetrafluorophenyl) methylene]cyclopropane.

The ratio of the p-type dopant is preferably less than 20% of molar ratio, more preferably less than 10%, such as 1%, 3%, or 5%, related to the matrix material.

The hole transporting layer is generally used for injecting and transporting holes efficiently, and aromatic or heterocyclic amine compounds are preferably used.

Specific examples for compounds for the hole transporting layer are represented by the general formula (H),

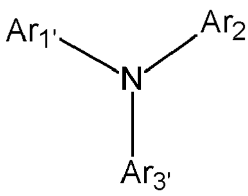
(H)

wherein

$Ar_{1'}$ to $Ar_{3'}$ each independently represents substituted or unsubstituted aryl group having 5 to 50 carbon atoms or substituted or unsubstituted heterocyclic group having 5 to 50 cyclic atoms, preferably phenyl group, biphenyl group, terphenyl group, naphthyl group, phenanthryl group, triphenylenyl group, fluorenyl group, spirobifluorenyl group, indenofluorenyl group, carbazolyl group, dibenzofuranyl group, dibenzothiophenyl group, carbazole substituted aryl group, dibenzofuran substituted aryl group or dibenzothiophene substituted aryl group; two or more substituents selected among $Ar_{1'}$ to $Ar_{3'}$ may be bonded to each other to form a ring structure, such as a carbazole ring structure, or a acridane ring structure.

Preferably, at least one of $Ar_{1'}$ to $Ar_{3'}$ have additional one aryl or heterocyclic amine substituent, more preferably $Ar_{1'}$ has an additional aryl amino substituent, at the case of that it is preferable that $Ar_{1'}$ represents substituted or unsubstituted biphenylene group, substituted or unsubstituted fluorenylene group. Specific examples for the hole transport material are

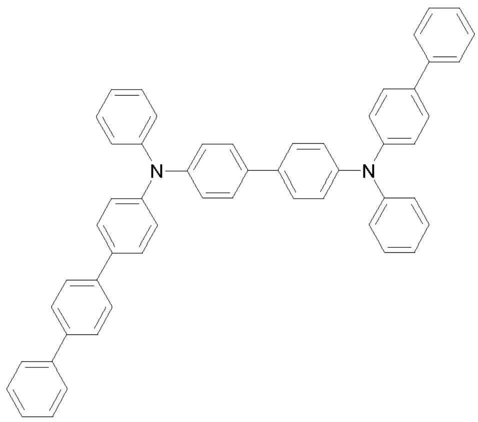
,
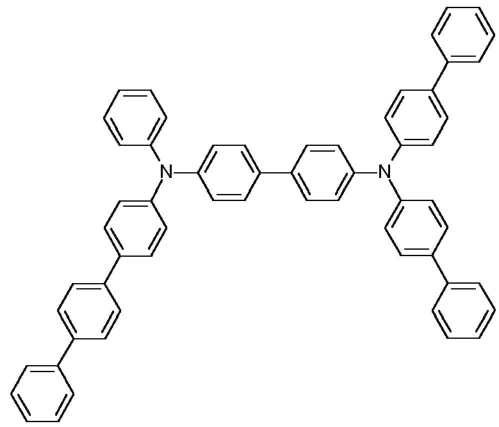

and

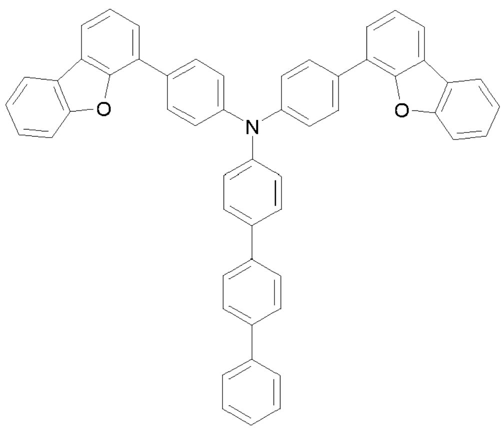

and the like.

A second hole transporting layer is preferably inserted between the first hole transporting layer and the emitting layer to enhance device performance by blocking excess electrons or excitons. Specific examples for second hole transporting layer are the same as for the first hole transporting layer. It is preferred that second hole transporting layer has higher triplet energy to block triplet excitons, especially for phosphorescent devices, such as bicarbazole compounds, biphenylamine compounds, triphenylenyl amine compounds, fluorenyl amine compounds, carbazole substituted arylamine compounds, dibenzofuran substituted arylamine compounds, and dibenzothiophene substituted arylamine compounds.

**(Emitting layer)**

The emitting layer is a layer containing a substance having a high emitting property (emitter material or dopant material). As the dopant material, various materials can be used. For example, a fluorescent emitting compound (fluorescent dopant), a phosphorescent emitting compound (phosphorescent dopant) or the like can be used. A fluorescent emitting compound is a compound capable of emitting light from the singlet excited state, and an emitting layer containing a fluorescent emitting compound is called a fluorescent emitting layer. Further, a phosphorescent emitting compound is a compound capable of emitting light from the triplet excited state, and an emitting layer containing a phosphorescent emitting compound is called a phosphorescent emitting layer.

Preferably, the emitting layer in the organic EL device of the present application comprises a compound of formula (I) as a dopant material.

The emitting layer preferably comprises at least one dopant material and at least one host material that allows it to emit light efficiently. In some literatures, a dopant material is called a guest material, an emitter or an emitting material. In some literatures, a host material is called a matrix material.

A single emitting layer may comprise plural dopant materials and plural host materials. Further, plural emitting layers may be present.

In the present specification, a host material combined with the fluorescent dopant is referred to as a "fluorescent host" and a host material combined with the phosphorescent dopant is referred to as the "phosphorescent host". Note that the fluorescent host and the phosphorescent host are not classified only by the molecular structure. The phosphorescent host is a material for forming a phosphorescent emitting layer containing a phosphorescent dopant, but does not mean that it cannot be used as a material for forming a fluorescent emitting layer. The same can be applied to the fluorescent host.

In one embodiment, it is preferred that the emitting layer comprises the compound represented by formula (I) according to the present invention (hereinafter, these compounds may be referred to as the "compound (I)"). More preferably, it is contained as a dopant material. Further, it is preferred that the compound (I) be contained in the emitting layer as a fluorescent dopant. Even further, it is preferred that the compound (I) be contained in the emitting layer as a blue fluorescent dopant.

In one embodiment, no specific restrictions are imposed on the content of the compound (I) as the dopant material in the emitting layer. In respect of sufficient emission and concentration quenching, the content is preferably 0.5 to 70 mass%, more preferably 0.8 to 30 mass%, further preferably 1 to 30 mass%, still further preferably 1 to 20 mass%, and particularly preferably 1 to 10 mass%, further particularly preferably 1 to 5 mass%, even further particularly preferably 2 to 4 mass%, related to the mass of the emitting layer.

**(Fluorescent dopant)**

As a fluorescent dopant other than the compound (I), a fused polycyclic aromatic compound, a styrylamine compound, a fused ring amine compound, a boron-containing compound, a pyrrole compound, an indole compound, a carbazole compound can be given, for example. Among these, a fused ring amine compound, a boron-containing compound, carbazole compound is preferable.

As the fused ring amine compound, a diaminopyrene compound, a diaminochrysene compound, a diaminoanthracene compound, a diaminofluorene compound, a diaminofluorene compound with which one or more benzofuro skeletons are fused, or the like can be given.

As the boron-containing compound, a pyrromethene compound, a triphenylborane compound or the like can be given.

As a blue fluorescent dopant, pyrene compounds, styrylamine compounds, chrysene compounds, fluoranthene compounds, fluorene compounds, diamine compounds, triarylamine compounds and the like can be given, for example. Specifically, N,N'-bis[4-(9H-carbazol-9-yl)phenyl]-N,N'-diphenylstilbene-4,4'-diamine (abbreviation: YGA2S), 4-(9H-carbazol-9-yl)-4'-(10-phenyl-9-anthryl)triphenyamine (abbreviation: YGAPA), 4-(10-phenyl-9-anthryl)-4'-(9-phenyl-9H-carbazole-3-yl)triphenylamine (abbreviation: PCBAPA) or the like can be given.

As a green fluorescent dopant, an aromatic amine compound or the like can be given, for example. Specifically, N-(9,10-diphenyl-2-anthryl)-N,9-diphenyl-9H-carbazole-3-amine (abbreviation: 2PCAPA), N-[9,10-bis(1,1'-biphenyl-2-yl)-2-anthryl]-N,9-diphenyl-9H-carbazole-3-amine (abbreviation: 2PCABPhA), N-(9,10-diphenyl-2-anthryl)-N,N',N'-triphenyl-1,4-phenylenediamine (abbreviation: 2DPAPA), N-[9,10-bis(1,1'-biphenyl-2-yl)-2-anthryl]-N,N',N'-triphenyl-1,4-phenylenediamine (abbreviation: 2DPABPhA), N-[9,10-bis(1,1'-biphenyl-2-yl)]-N-[4-(9H-carbazole-9-yl)phenyl]-N-phenylanthracene-2-amine (abbreviation: 2YGABPhA), N,N,9-triphenylanthracene-9-amine (abbreviation: DPhAPhA) or the like can be given, for example.

As a red fluorescent dopant, a tetracene compound, a diamine compound or the like can be given. Specifically, N,N,N',N'-tetrakis(4-methylphenyl)tetracene-5,11-diamine (abbreviation: p-mPhTD), 7,14-diphenyl-N,N,N',N'-tetrakis(4-methylphenyl)acenaphtho[1,2-a]fluoranthene-3,10-diamine (abbreviation: p-mPhAFD) or the like can be given.

**(Phosphorescent dopant)**

As a phosphorescent dopant, a phosphorescent emitting heavy metal complex and a phosphorescent emitting rare earth metal complex can be given.

As the heavy metal complex, an iridium complex, an osmium complex, a platinum complex or the like can be given. The heavy metal complex is for example an ortho-metalated complex of a metal selected from iridium, osmium and platinum.

Examples of rare earth metal complexes include terbium complexes, europium complexes and the like. Specifically, tris(acetylacetonate)(monophenanthroline)terbium(III) (abbreviation: $Tb(acac)_3(Phen)$), tris(1,3-diphenyl-1,3-propandionate)(monophenanthroline)europium(III) (abbreviation: $Eu(DBM)_3(Phen)$), tris[1-(2-thenoyl)-3,3,3-trifluoroacetonate](monophenanthroline)europium(III) (abbreviation: $Eu(TTA)_3(Phen)$) or the like can be given. These rare earth metal complexes are preferable as phosphorescent dopants since rare earth metal ions emit light due to electronic transition between different multiplicity.

As a blue phosphorescent dopant, an iridium complex, an osmium complex, a platinum complex, or the like can be given, for example. Specifically, bis[2-(4',6'-difluorophenyl)pyridinate-N,C2']iridium(III) tetrakis(1-pyrazolyl)borate (abbreviation: FIr6), bis[2-(4',6'-difluorophenyl) pyridinato-N,C2']iridium(III) picolinate (abbreviation: $Ir(CF_3ppy)_2(pic)$), bis[2-(4',6'-difluorophenyl)pyridinato-N,C2']iridium(III) acetylacetonate (abbreviation: FIracac) or the like can be given.

As a green phosphorescent dopant, an iridium complex or the like can be given, for example. Specifically, tris(2-phenylpyridinato-N,C2') iridium(III) (abbreviation: $Ir(ppy)_3$), bis(1,2-diphenyl-1H-benzimidazolato)iridium(III) acetylacetonate (abbreviation: $Ir(pbi)_2(acac)$), bis(benzo[h]quinolinato)iridium(III) acetylacetonate (abbreviation: $Ir(bzq)_2(acac)$) or the like can be given.

As a red phosphorescent dopant, an iridium complex, a platinum complex, a terbium complex, a europium complex or the like can be given. Specifically, bis[2-(2'-benzo[4,5-$\alpha$]thienyl)pyridinato-N,C3']iridium(III) acetylacetonate (abbreviation: $Ir(btp)_2(acac)$), bis(1-phenylisoquinolinato-N,C2')iridium(III) acetylacetonate (abbreviation: $Ir(piq)_2(acac)$), (acetylacetonato)bis[2,3-bis(4-fluorophenyl)quinoxalinato]iridium(III) (abbreviation: $Ir(Fdpq)_2(acac)$), 2,3,7,8,12,13,17,18-octaethyl-21H,23H-porphyrin platinum(II) (abbreviation PtOEP) or the like can be given.

As mentioned above, the emitting layer preferably comprises at least one compound (I) as a dopant.

**(Host material)**

As host material, metal complexes such as aluminum complexes, beryllium complexes and zinc complexes; heterocyclic compounds such as indole compounds, pyridine compounds, pyrimidine compounds, triazine compounds, quinoline compounds, isoquinoline compounds, quinazoline compounds, dibenzofuran compounds, dibenzothiophene compounds, oxadiazole compounds, benzimidazole compounds, phenanthroline compounds; fused polyaromatic hydrocarbon (PAH) compounds such as a naphthalene compound, a triphenylene compound, a carbazole compound, an anthracene compound, a phenanthrene compound, a pyrene compound, a chrysene compound, a naphthacene compound, a fluoranthene compound; and aromatic amine compound such as triarylamine compounds and fused polycyclic aromatic amine compounds can be given, for example. Plural types of host materials can be used in combination.

As a **fluorescent** host, a compound having a higher singlet energy level than a fluorescent dopant is preferable. For example, a heterocyclic compound, a fused aromatic compound or the like can be given. As a fused aromatic compound, an anthracene compound, a pyrene compound, a chrysene compound, a naphthacene compound or the like are preferable. An anthracene compound is preferentially used as blue fluorescent host.

In the case that compound (I) is employed as at least one dopant material, preferred host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds, preferably substituted or unsubstituted anthracene compounds or substituted or unsubstituted pyrene compounds, more preferably substituted or unsubstituted anthracene compounds, most preferably anthracene compounds represented by formula (10), as mentioned above.

As a **phosphorescent host,** a compound having a higher triplet energy level as compared with a phosphorescent dopant is preferable. For example, a metal complex, a heterocyclic compound, a fused aromatic compound or the like can be given. Among these, an indole compound, a carbazole compound, a pyridine compound, a pyrimidine compound, a triazine compound, a quinolone compound, an isoquinoline compound, a quinazoline compound, a dibenzofuran compound, a dibenzothiophene compound, a naphthalene compound, a triphenylene compound, a

phenanthrene compound, a fluoranthene compound or the like can be given.

**(Electron-transporting layer) / (Electron-injecting layer)**

The electron-transporting layer is an organic layer that is formed between the emitting layer and the cathode and has a function of transporting electrons from the cathode to the emitting layer. When the electron-transporting layer is formed of plural layers, an organic layer or an inorganic layer that is nearer to the cathode is often defined as the electron injecting layer (see for example layer 8 in FIG. 1, wherein an electron injecting layer 8 and an electron transporting layer 7 form an electron injecting and transporting unit 11). The electron injecting layer has a function of injecting electrons from the cathode efficiently to the organic layer unit. Preferred electron injection materials are alkali metal, alkali metal compounds, alkali metal complexes, the alkaline earth metal complexes and the rare earth metal complexes.
According to one embodiment, it is preferred that the electron-transporting layer further comprises one or more layer(s) like a second electron-transporting layer, an electron injection layer to enhance efficiency and lifetime of the device, a hole blocking layer, an exciton blocking layer or a triplet blocking layer.
According to one embodiment, it is preferred that an electron-donating dopant be contained in the interfacial region between the cathode and the emitting unit. Due to such a configuration, the organic EL device can have an increased luminance or a long life. Here, the electron-donating dopant means one having a metal with a work function of 3.8 eV or less. As specific examples thereof, at least one selected from an alkali metal, an alkali metal complex, an alkali metal compound, an alkaline earth metal, an alkaline earth metal complex, an alkaline earth metal compound, a rare earth metal, a rare earth metal complex and a rare earth metal compound or the like can be mentioned.
As the alkali metal, Li (work function: 2.9 eV), Na (work function: 2.36 eV), K (work function: 2.28 eV), Rb (work function: 2.16 eV), Cs (work function: 1.95 eV) and the like can be given. One having a work function of 2.9 eV or less is particularly preferable. Among them, K, Rb and Cs are preferable. Rb or Cs is further preferable. Cs is most preferable. As the alkaline earth metal, Ca (work function: 2.9 eV), Sr (work function: 2.0 eV to 2.5 eV), Ba (work function: 2.52 eV) and the like can be given. One having a work function of 2.9 eV or less is particularly preferable. As the rare-earth metal, Sc, Y, Ce, Tb, Yb and the like can be given. One having a work function of 2.9 eV or less is particularly preferable.
Examples of the alkali metal compound include an alkali oxide such as $Li_2O$, $Cs_2O$ or $K_2O$, and an alkali halide such as LiF, NaF, CsF and KF. Among them, LiF, $Li_2O$ and NaF are preferable. Examples of the alkaline earth metal compound include BaO, SrO, CaO, and mixtures thereof such as $Ba_xSr_{1-x}O$ ($0<x<1$) and $Ba_xCa_{1-x}O$ ($0<x<1$). Among them, BaO, SrO and CaO are preferable. Examples of the rare earth metal compound include $YbF_3$, $ScF_3$, $ScO_3$, $Y_2O_3$, $Ce_2O_3$, $GdF_3$ and $TbF_3$. Among these, $YbF_3$, $ScF_3$ and $TbF_3$ are preferable.
The alkali metal complexes, the alkaline earth metal complexes and the rare earth metal complexes are not particularly limited as long as they contain, as a metal ion, at least one of alkali metal ions, alkaline earth metal ions, and rare earth metal ions. Meanwhile, preferred examples of the ligand include, but are not limited to, quinolinol, benzoquinolinol, acridinol, phenanthridinol, hydroxyphenyloxazole, hydroxyphenylthiazole, hydroxydiaryloxadiazole, hydroxydiarylthiadiazole, hydroxyphenylpyridine, hydroxyphenylbenzimidazole, hydroxybenzotriazole, hydroxyfluborane, bipyridyl, phenanthroline, phthalocyanine, porphyrin, cyclopentadiene, β-diketones, and azomethines.
Regarding the addition form of the electron-donating dopant, it is preferred that the electron-donating dopant be formed in a shape of a layer or an island in the interfacial region. A preferred method for the formation is a method in which an organic compound (a light emitting material or an electron-injecting material) for forming the interfacial region is deposited simultaneously with deposition of the electron-donating dopant by a resistant heating deposition method, thereby dispersing the electron-donating dopant in the organic compound.
In a case where the electron-donating dopant is formed into the shape of a layer, the light-emitting material or electron-injecting material which serves as an organic layer in the interface is formed into the shape of a layer. After that, a reductive dopant is solely deposited by the resistant heating deposition method to form a layer preferably having a thickness of from 0.1 nm to 15 nm. In a case where the electron-donating dopant is formed into the shape of an island, the emitting material or the electron-injecting material which serves as an organic layer in the interface is formed into the shape of an island. After that, the electron-donating dopant is solely deposited by the resistant heating deposition method to form an island preferably having a thickness of from 0.05 nm to 1 nm. As the electron-transporting material used in the electron-transporting layer other than a compound of the formula (I), an aromatic heterocyclic compound having one or more hetero atoms in the molecule may preferably be used. In particular, a nitrogen-containing heterocyclic compound is preferable.
According to one embodiment, it is preferable that the electron-transporting layer comprises a nitrogen-containing heterocyclic metal chelate.
According to the other embodiment, it is preferable that the electron-transporting layer comprises a substituted or unsubstituted nitrogen containing heterocyclic compound. Specific examples of preferred heterocyclic compounds for the electron-transporting layer are, 6-membered azine compounds; such as pyridine compounds, pyrimidine compounds, triazine compounds, pyrazine compounds, preferably pyrimidine compounds or triazine compounds; 6-membered fused azine compounds, such as quinolone compounds, isoquinoline compounds, quinoxaline compounds, quinazoline

compounds, phenanthroline compounds, benzoquinoline compounds, benzoisoquinoline compounds, dibenzoquinoxaline compounds, preferably quinolone compounds, isoquinoline compounds, phenanthroline compounds; 5-membered heterocyclic compounds, such as imidazole compounds, oxazole compounds, oxadiazole compounds, triazole compounds, thiazole compounds, thiadiazole compounds; fused imidazole compounds, such as benzimidazole compounds, imidazopyridine compounds, naphthoimidazole compounds, benzimidazophenanthridine compounds, benzimidzobenzimidazole compounds, preferably benzimidazole compounds, imidazopyridine compounds or benzimidazophenanthridine compounds.

According to another embodiment, it is preferable the electron-transporting layer comprises a phosphine oxide compound represented as $Ar_{p1}Ar_{p2}Ar_{P3}P{=}O$.

$Ar_{p1}$ to $Ar_{p3}$ are the substituents of phosphor atom and each independently represent substituted or unsubstituted above mentioned aryl group or substituted or unsubstituted above mentioned heterocyclic group.

According to another embodiment, it is preferable that the electron-transporting layer comprises aromatic hydrocarbon compounds. Specific examples of preferred aromatic hydrocarbon compounds for the electron-transporting layer are, oligo-phenylene compounds, naphthalene compounds, fluorene compounds, fluoranthenyl group, anthracene compounds, phenanthrene compounds, pyrene compounds, triphenylene compounds, benzanthracene compounds, chrysene compounds, benzphenanthrene compounds, naphthacene compounds, and benzochrysene compounds, preferably anthracene compounds, pyrene compounds and fluoranthene compounds.

**(Cathode)**

For the cathode, a metal, an alloy, an electrically conductive compound, and a mixture thereof, each having a small work function (specifically, a work function of 3.8 eV or less) are preferably used. Specific examples of a material for the cathode include an alkali metal such as lithium and cesium; an alkaline earth metal such as magnesium, calcium, and strontium; aluminum, an alloy containing these metals (for example, magnesium-silver, aluminum-lithium); a rare earth metal such as europium and ytterbium; and an alloy containing a rare earth metal.

The cathode is usually formed by a vacuum vapor deposition or a sputtering method. Further, in the case of using a silver paste or the like, a coating method, an inkjet method, or the like can be employed.

Moreover, various electrically conductive materials such as silver, ITO, graphene, indium oxide-tin oxide containing silicon or silicon oxide, selected independently from the work function, can be used to form a cathode. These electrically conductive materials are made into films using a sputtering method, an inkjet method, a spin coating method, or the like.

**(Insulating layer)**

In the organic EL device, pixel defects based on leakage or a short circuit are easily generated since an electric field is applied to a thin film. In order to prevent this, it is preferred to insert an insulating thin layer between a pair of electrodes. Examples of materials used in the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture thereof may be used in the insulating layer, and a laminate of a plurality of layers that include these materials can be also used for the insulating layer.

**(Spacing layer)**

A spacing layer is a layer provided between a fluorescent emitting layer and a phosphorescent emitting layer when a fluorescent emitting layer and a phosphorescent emitting layer are stacked in order to prevent diffusion of excitons generated in the phosphorescent emitting layer to the fluorescent emitting layer or in order to adjust the carrier balance. Further, the spacing layer can be provided between the plural phosphorescent emitting layers.

Since the spacing layer is provided between the emitting layers, the material used for the spacing layer is preferably a material having both electron-transporting capability and hole-transporting capability. In order to prevent diffusion of the triplet energy in adjacent phosphorescent emitting layers, it is preferred that the spacing layer have a triplet energy of 2.6 eV or more. As the material used for the spacing layer, the same materials as those used in the above-mentioned hole-transporting layer can be given.

**(Electron-blocking layer, hole-blocking layer, exciton-blocking layer)**

An electron-blocking layer, a hole-blocking layer, an exciton (triplet)-blocking layer, and the like may be provided in adjacent to the emitting layer.

The electron-blocking layer has a function of preventing leakage of electrons from the emitting layer to the hole-transporting layer. The hole-blocking layer has a function of preventing leakage of holes from the emitting layer to the electron-transporting layer. In order to improve hole blocking capability, a material having a deep HOMO level is preferably used. The exciton-blocking layer has a function of preventing diffusion of excitons generated in the emitting layer to the adjacent layers and confining the excitons within the emitting layer. In order to improve triplet block capability, a material having a high triplet level is preferably used.

**(Method for forming a layer)**

The method for forming each layer of the organic EL device of the invention is not particularly limited unless otherwise specified. A known film-forming method such as a dry film-forming method, a wet film-forming method or the like can be used. Specific examples of the dry film-forming method include a vacuum deposition method, a sputtering method, a plasma method, an ion plating method, and the like. Specific examples of the wet film-forming method include various coating methods such as a spin coating method, a dipping method, a flow coating method, an inkjet method, and the like.

**(Film thickness)**

The film thickness of each layer of the organic EL device of the invention is not particularly limited unless otherwise specified. If the film thickness is too small, defects such as pinholes are likely to occur to make it difficult to obtain a sufficient luminance. If the film thickness is too large, a high driving voltage is required to be applied, leading to a lowering in efficiency. In this respect, the film thickness is preferably 0.1 nm to 10 μm, and more preferably 5 nm to 0.2 μm.

**(Electronic apparatus (electronic equipment))**

The present invention further relates to an electronic equipment (electronic apparatus) comprising the organic electroluminescence device according to the present application. Examples of the electronic apparatus include display parts such as an organic EL panel module; display devices of television sets, mobile phones, smart phones, and personal computer, and the like; and emitting devices of a lighting device and a vehicle lighting device.

EXAMPLES

Next, the invention will be explained in more detail in accordance with the following synthesis examples, examples, and comparative examples, which should not be construed as limiting the scope of the invention.
The percentages and ratios mentioned in the examples below - unless stated otherwise - are % by weight and weight ratios.

**I Synthesis Examples**

All experiments are carried out in protective gas atmosphere.

Compound 1

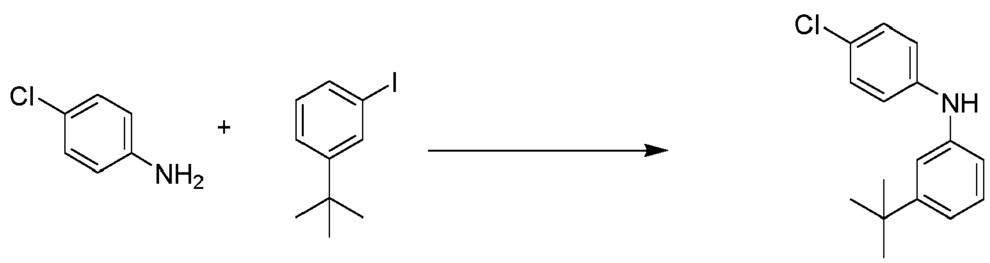

**Intermediate 1-1**

In a 500 mL degassed 3-necked round bottom flask was added 1-chloro-4-iodobenzene (15.0 g, 62.9 mmol), 3-(tert-butyl)aniline (10.3 g, 69.2 mmol), Tris(dibenzylideneacetone)dipalladium(0) (0.588 g, 0.629 mmol), (9,9-Dimethyl-9H-xanthene-4,5-diyl)bis(diphenylphosphane) (1.49 g, 2.52 mmol) and sodium tert-butoxide (12.5 g, 126 mmol). Toluene (200 mL) was then added and the reaction heated under an atmosphere of nitrogen in an oil bath temperature of 90 °C for 1 hour. The reaction was then allowed to cool to room temperature and the mixture filtered over hyflo. The mother

liquor was washed with aqueous saturated sodium hydrogencarbonate, water and then saturated aqueous sodium chloride and dried over magnesium sulphate. The solution was then filtered over a pad of silica flushing through with toluene. The solvent was removed under reduced pressure. The crude product was triturated with heptane and filtered, and the filtrate was treated with a solution of 4M HCl in dioxane (4M). The precipitate thus formed was then removed by filtration, dissolved in dichloromethane and the solution was washed with aquous sodium hydroxide (2M) until basic, water and then saturated aqueous sodium chloride and dried over magnesium sulphate. The solution was removed under reduced pressure to give the Intermediate 1-1 (13.3 g, 81% yield) as an oil which was characterized by ESI-MS (electrospray ionisation mass spectrometry). The results are shown below.
ESI-MS: calcd. for C16H18ClN = 259, mass found=260 (M+1)

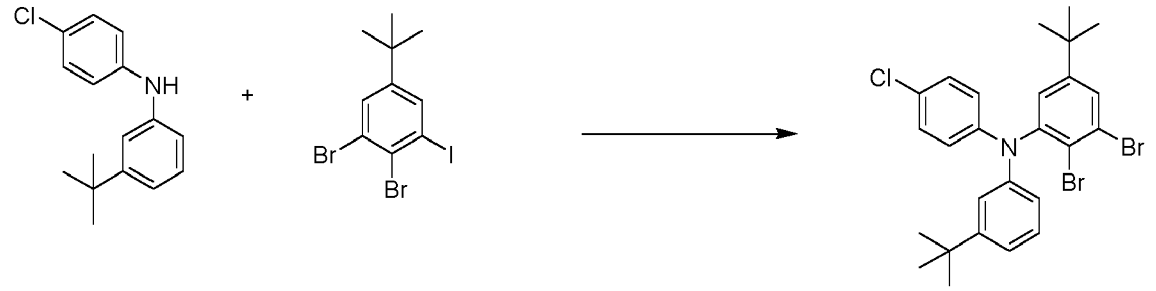

**Intermediate 1-1**

**Intermediate 1-2**

In a 500 mL degassed 3-necked round bottom flask was added Intermediate 1-1 (15.0 g, 57.7 mmol), 1,2-dibromo-5-(tert-butyl)-3-iodobenzene (25.3 g, 60.6 mmol), Tris(dibenzylideneacetone)dipalladium(0) (1.08 g, 1.16 mmol), (9,9-Dimethyl-9H-xanthene-4,5-diyl)bis(diphenylphosphane) (2.73 g, 4.62 mmol) and sodium tert-butoxide (8.01 g, 81 mmol). Toluene (250 mL) was then added and the reaction heated under an atmosphere of nitrogen in an oil bath temperature of 120 °C for 15 hours. The reaction was then allowed to cool to room temperature and the mixture filtered over hyflo. The mother liquor was washed with aqueous saturated sodium hydrogencarbonate, water and then saturated aqueous sodium chloride and dried over magnesium sulphate. The solution was then filtered over a pad of silica flushing through with toluene. The solvent was removed under reduced pressure. The crude product was purified by silica-gel column chromatography using heptane as eluent, followed by recrystallisation from a mixture of toluene and 2-propanol to give Intermediate 1-2 (14.8 g, 46% yield) as a white solid which was characterized by ESI-MS (electrospray ionisation mass spectrometry). The results are shown below.
ESI-MS: calcd. for C26H28Br2ClN = 549, mass found=550 (M+1)

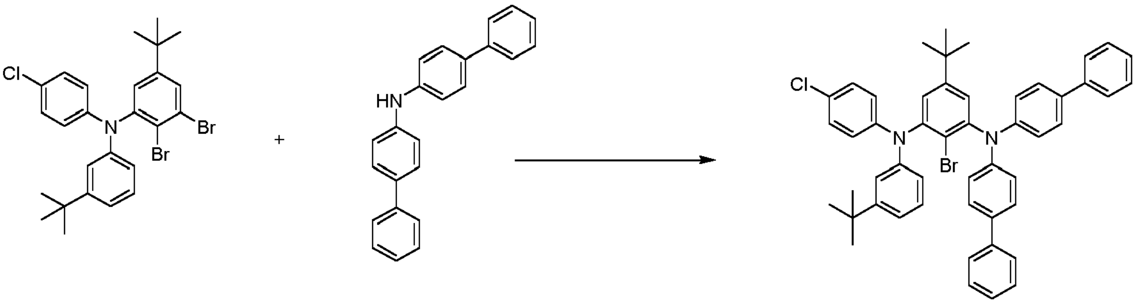

**Intermediate 1-2**

**Intermediate 1-3**

In a 250 mL degassed 3-necked round bottom flask was added Intermediate 1-2 (7.00 g, 12.7 mmol), di([1,1'-biphenyl]-4-yl)amine (4.30 g, 13.4 mmol), Bis-(tri-tert.-butylphosphin)-palladium(0) (0.130 g, 0.255 mmol) and sodium tert-butoxide (1.71 g, 17.8 mmol). Toluene (250 mL) was then added and the reaction heated under an atmosphere of nitrogen in an oil bath temperature of 115 °C for 2 hours. The reaction was then allowed to cool to room temperature and the mixture filtered over hyflo. The mother liquor was washed with aqueous saturated sodium hydrogencarbonate, water and then saturated aqueous sodium chloride and dried over magnesium sulphate. The crude product was purified by silica-gel column chromatography using dichloromethane as eluent, followed by recrystallisation from a mixture of toluene and ethanol to give Intermediate 1-3 (7.6 g, 76% yield) as a white solid which was characterized by ESI-MS (electrospray ionisation mass spectrometry). The results are shown below.
ESI-MS: calcd. for C50H46BrClN2 = 790, mass found=791 (M+1)

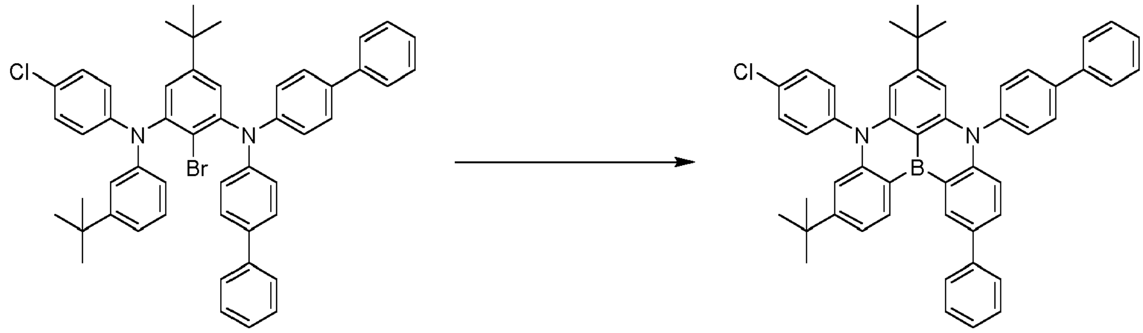

Intermediate 1-3 Intermediate 1-4

In a 250 mL degassed 3-necked round bottom flask was added Intermediate 1-3 (7.60 g, 9.62 mmol) and tButylbenzene (100 mL), and the solution was cooled in a water-ice bath at 0 °C under N2. n-butyllithium (2.5M solution in hexanes) (4.62 mL, 11.45 mmol) was added dropwise via a syringe and the resulting reaction mixture was allowed to warm to room temperature, and stirred for 30 minutes. The reaction mixture was cooled at -30°C and then boron tribromide (1M solution in heptane) (14.4 ml, 14.4 mmol) was added dropwise. Upon complete addition, the reaction was allowed to warm to room temperature, then heated in an oil bath temperature of 100 °C for 2 hours. After cooling to room temperature, Diisopropylethylamine (3.36 mL, 19.2 mmol) was then added to the reaction and the mixture was stirred for 1 hour. The reaction mixture was then diluted with ethanol (50 mL), and the resulting yellow precipitate was collected by filtration. The solid was recrystallised from xylene to give Intermediate 1-4 (2.4 g, 35% yield) as a yellow solid which was characterized by ESI-MS (electrospray ionisation mass spectrometry). The results are shown below.
ESI-MS: calcd. for C50H44BClN2 = 719, mass found = 720 (M+1)

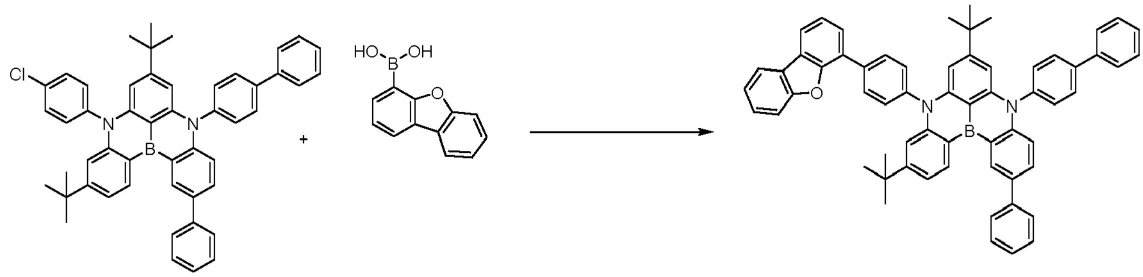

Intermediate 1-4 Compound 1

In a 250 mL degassed 3-necked round bottom flask was added Intermediate 1-4 (2.40 g, 3.34 mmol), dibenzo[b,d]furan-4-ylboronic acid (1.42 g, 6.67 mmol), palladium(II) acetate (37 mg, 0.167 mmol), dicyclohexyl[2',4',6'-tris(propan-2-yl)[1,1'-biphenyl]-2-yl]phosphane (159 mg, 0.334 mmol) and potassium carbonate (0.922 g, 6.67 mmol). Toluene (50 mL), Dioxane (10 mL) and water (10 mL) were then added and the reaction was heated under an atmosphere of nitrogen in an oil bath temperature of 115 °C overnight. The reaction mixture was then diluted with ethanol (50 mL), and the resulting yellow precipitate was collected by filtration. The crude product was purified by silica-gel column chromatography using dichloromethane as eluent, followed by trituration in acetone to give Compound 1 (0.94 g, 33% yield) as a yellow solid which was characterized by ESI-MS (electrospray ionisation mass spectrometry). The results are shown below.
ESI-MS: calcd. for C50H46BrClN2 = 850, mass found=851 (M+1)

## Compound 2

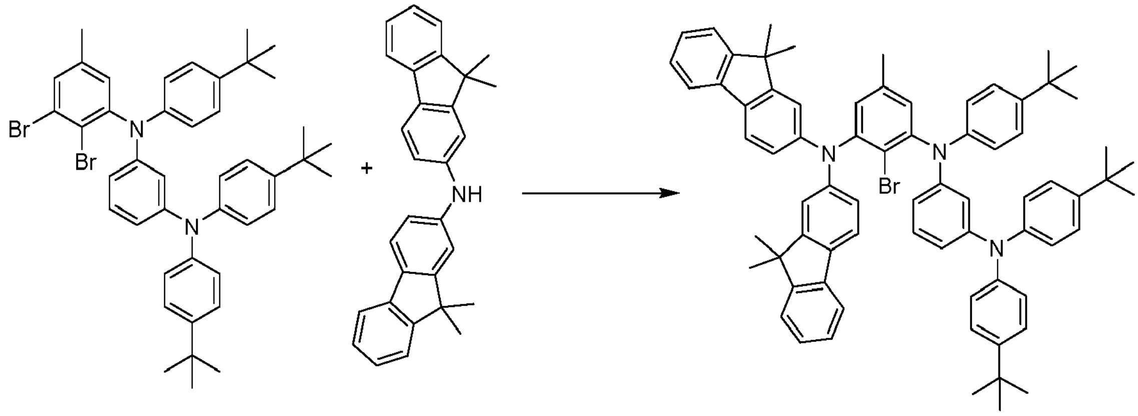

**Intermediate 2-1**

Intermediate 2-1 was synthesised according to the procedure outlined for Intermediate 1-3, except 1,3-Benzenediamine, *N*1-(2,3-dibromo-5-methylphenyl)-*N*1,*N*3,*N*3-tris[4-(1,1-dimethylethyl)phenyl]- was used instead of Intemediate 1-2, and *N*-(9,9-Dimethyl-9*H*-fluoren-2-yl)-9,9-dimethyl-9*H*-fluoren-2-amine was used instead of di([1,1'-biphenyl]-4-yl)amine. The crude product was purified by silica-gel column chromatography using a mixture of heptane and toluene as eluent to give Intermediate 2-1 (2.13 g, 34% yield) as a white solid which was characterized by ESI-MS (electrospray ionisation mass spectrometry). The results are shown below. ESI-MS: calcd. for C73H74BrN3 = 1073, mass found=1074 (M+1)

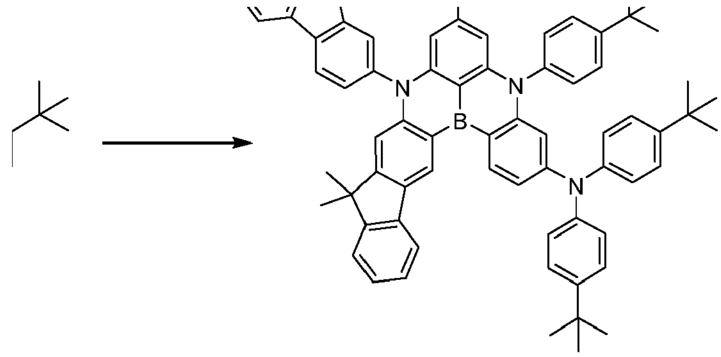

**Compound 2**

In a 100 mL degassed 3-necked round bottom flask was added Intermediate 2.1 (2.15 g, 2.00 mmol) and tButylbenzene (20 mL), and the solution was cooled in a water-ice-salt bath at -14 °C under N2. tert-butyllithium (1.6M solution in pentane) (2.50 mL, 4.00 mmol) was added dropwise via a syringe and the resulting reaction mixture was allowed to warm to room temperature, and stirred for 1.5 hours. The reaction mixture was cooled at -78 °C and then boron tribromide (1M solution in heptane) (4.00 mL, 4 mmol) was added dropwise. Upon complete addition, the reaction was allowed to warm to room temperature for 2 hours. After cooling to 0 °C, Di-isopropylethylamine (1.33 mL, 8.00 mmol) was then added to the reaction and the mixture was heated in an oil bath temperature of 150 °C for 2 hours. The reaction mixture was cooled to room temperature, and to this was added saturated sodium hydrogencarbonate solution until a neutral pH was reached. The organic phase was separated, and the aqueous phase was extracted with dichloromethane. The organic phases were combined and dried over magnesium sulfate, and the solvent was removed under reduced pressure. The crude product was purified by silica-gel column chromatography using a mixture of heptane and toluene as eluent to give Compound 2 (0.76 g, 38% yield) as a yellow solid which was characterized by ESI-MS (electrospray ionisation mass spectrometry). The results are shown below.

ESI-MS: calcd. for C73H72BN3 = 1002, mass found=1003 (M+1)

| Compound 1 | Compound 2 | Comparative Compound 1 |
| --- | --- | --- |
| | | 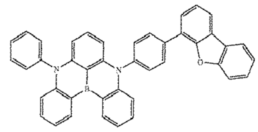 |

**Device (invented compound as emitter/dopant)**

Preparation and Evaluation of Organic EL Devices

The organic EL devices were prepared and evaluated as follows:

**Application Example 1**

A glass substrate with 130 nm-thick indium-tin-oxide (ITO) transparent electrode (manufactured by Geomatec Co., Ltd.) used as an anode was first treated with N2 plasma for 100 sec. This treatment also improved the hole injection properties of the ITO. The cleaned substrate was mounted on a substrate holder and loaded into a vacuum chamber. Thereafter, the organic materials specified below were applied by vapour deposition to the ITO substrate at a rate of approx. 0.2-1 Å/sec at about $10^{-6}$ -$10^{-8}$ mbar. As a hole injection layer, 10 nm-thick mixture of Compound HT-1 and 3% by weight of compound HI was applied. Then 80 nm-thick of compound HT-1 and 10 nm of Compound HT-2 were applied as hole-transporting layer 1 and hole-transporting layer 2, respectively. Subsequently, a mixture of 2% by weight of an emitter Compound 1 and 98% by weight of host Compound BH-1 was applied to form a 25 nm-thick fluorescent emitting layer. On the emitting layer, 10 nm-thick Compound ET-1 was applied as an hole-blocking layer and 15 nm of Compound ET-2 as electron-transporting layer. Finally, 1 nm-thick LiF was deposited as an electron-injection layer and 50 nm-thick Al was then deposited as a cathode to complete the device. The device was sealed with a glass lid and a getter in an inert nitrogen atmosphere with less than 1 ppm of water and oxygen. To characterize the OLED, electroluminescence (EL) spectra were recorded at various currents and voltages. EL peak maximum and Full Width at Half Maximum (FWHM) were recorded at 10 mA/$cm^2$. In addition, the current-voltage characteristic were measured in combination with the luminance to determine luminous efficiency and external quantum efficiency (EQE). Driving voltage (Voltage) was given at a current density of 10mA/$cm^2$. Lifetime of OLED device was measured as a decay of the luminance at constant current density of 50 mA/$cm^2$ to 95% of its initial value. The device results are shown in Table 1.

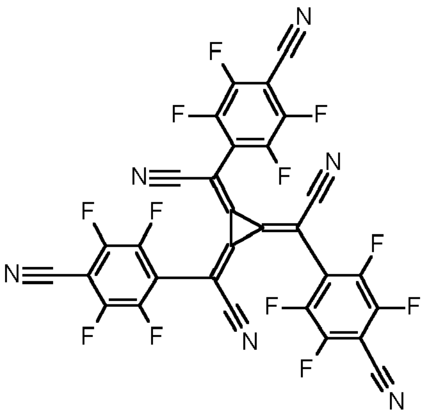

Compound HI

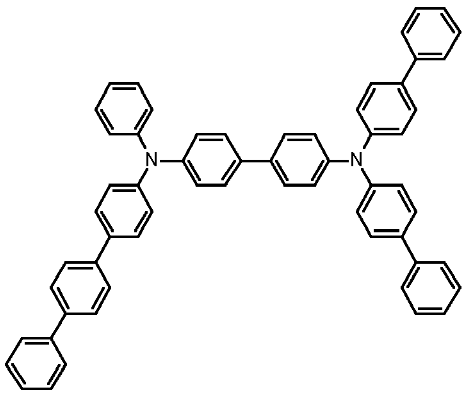

Compound HT-1

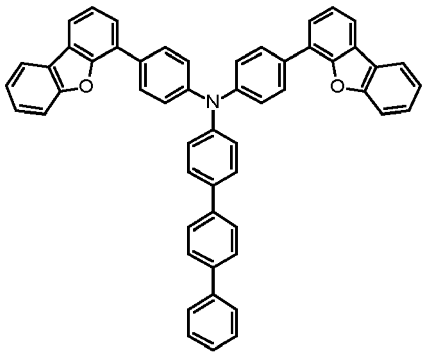

Compound HT-2

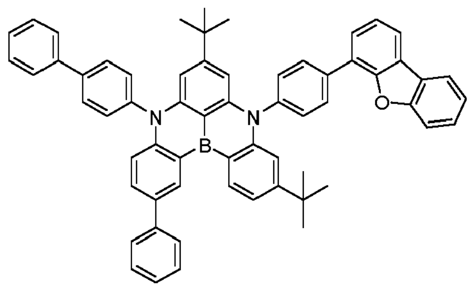

Compound 1

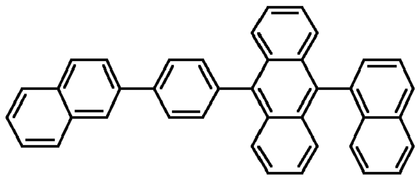

Compound BH-1

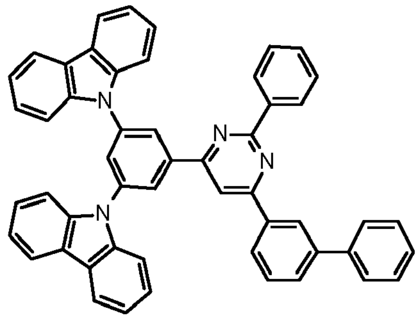

Compound ET-1

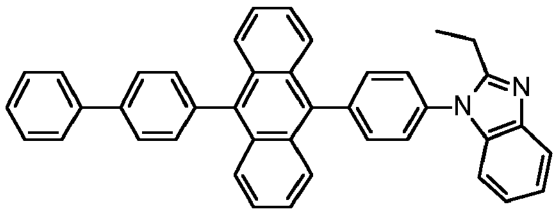

Compound ET-2

**Application Example 2**

Application example 1 was repeated except for using Compound 2 in place of Compound 1 in the emitter layer. The device result is shown in Table 1.

Compound 2

**Comparative Application Example 1**

Application example 1 was repeated except for using Comparative Compound 1 (disclosed in US 2021/0066599A1) in place of Compound 1 in the emitter layer. The device result is shown in Table 1.

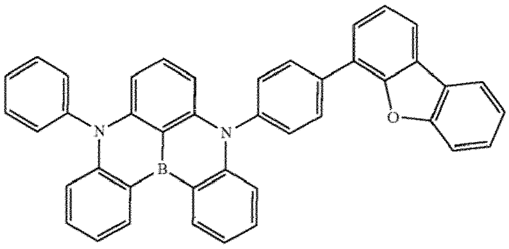

Comparative Compound 1

Table 1

| Application Example | Emitter | EL max, nm | Relative EQE (%)2) | Relative LT951), (%) |
|---|---|---|---|---|
| Application Example 1 | Compound 1 | 463 | 115 | 207 |
| Application Example 2 | Compound 2 | 465 | 116 | 107 |
| Comparative Example 1 | Comparative Compound 1 | 459 | 100 | 100 |

1) Device lifetime measured at a current density of 50 $mA/cm^2$ up to 95% of the initial luminance (at $50 mA/cm^2$), relative to the device lifetime of Comparative Example 1 using the following formula:

$$LT95 = \left(\frac{absolute\ LT95\ Application\ example}{absolute\ LT95\ Comparative\ example\ 1}\right) * 100$$

2) EQE relative to the EQE of Comparative Example 1 using the following formula:

$$EQE = \left(\frac{absolute\ EQE\ Application\ example}{absolute\ EQE\ Comparative\ example\ 1}\right) * 100$$

These results demonstrate that the lifetime (LT95) and the EQE are improved in the case that the inventive Compounds are used instead of the Comparative Compounds as the fluorescent emitting material.

It has been found by the inventors that the specific substitution pattern of the compounds of formula (I) of the present invention, wherein

- at least one of $R^1$, $R^2$, $R^3$ and $R^4$, preferably at least one of $R^2$ and $R^3$, represents an alkyl group having from 1 to 20 carbon atoms which is unsubstituted or substituted or an amino group $NR^{84}R^{85}$,
- at least one of $R^5$, $R^6$, $R^7$ and $R^8$, preferably at least one of $R^6$ and $R^7$, represents an aryl group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure; and
- at least one of $Y_1$ and $Y_2$ is a group of formula (II);

has an impact on the ionization potential of the compounds of formula (I):

| | | |
|---|---|---|
| Comparative Examples | 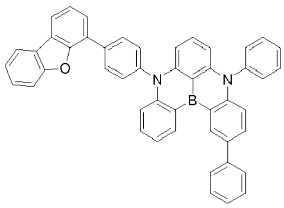 | 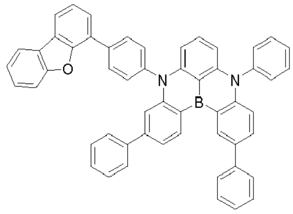 |
| Calculated Ionisa-tion Potential (eV) | 4.72 | 4.73 |

(continued)

| Inventive Examples | 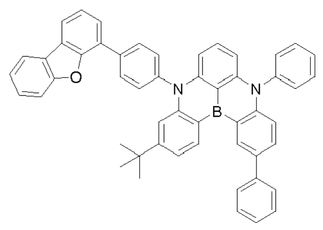 | 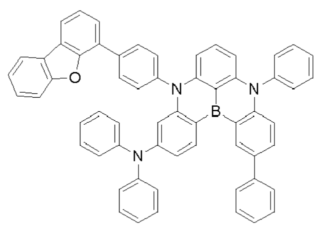 |
|---|---|---|
| Calculated Ionisation Potential (eV) | 4.68 | 4.68 |

## Claims

**1.** A compound represented by formula (I)

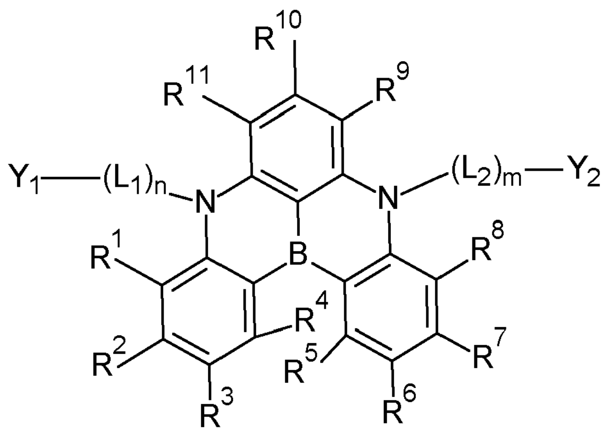

(I)

wherein

$R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen; preferably hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen; preferably $R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; $OR^{20}$; or an amino group $NR^{84}R^{85}$;

or

two adjacent residues of $R^1$, $R^2$, $R^3$, $R^4$, $R^5$, $R^6$, $R^7$, $R^8$, $R^9$ and $R^{11}$, preferably $R^6$ and $R^7$ together form a ring structure which is unsubstituted or substituted;

wherein at least one of $R^1$, $R^2$, $R^3$ and $R^4$ represents an alkyl group having from 1 to 20 carbon atoms which is unsubstituted or substituted or an amino group $NR^{84}R^{85}$, and at least one of $R^5$, $R^6$, $R^7$ and $R^8$ represents an aryl

group having from 6 to 30 ring carbon atoms which is unsubstituted or substituted; or a heteroaryl group having from 5 to 30 ring atoms which is unsubstituted or substituted, whereby the aryl group or the heteroaryl group may bind back to an adjacent residue and form a ring structure;
$Y_1$ and $Y_2$ each independently represents $R^Y$ or a group of formula (II);

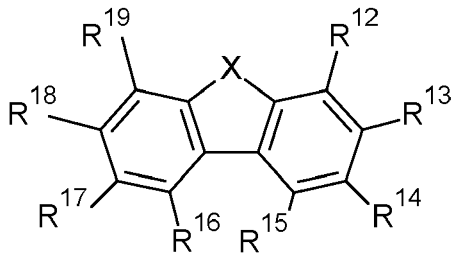
(II);

$R^Y$ represents an aryl group having from 6 to 30 ring carbon atoms which is unsubstituted or substituted, wherein the aryl group is not fused with a group of formula

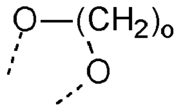
,

wherein o is 1, 2, 3 or 4 and the dotted lines are bonding sites; or a heteroaryl group having from 5 to 30 ring atoms which is unsubstituted or substituted; preferably, the aryl group is not fused with an aliphatic or heteroaliphatic group; more preferably, the aryl group and the heteroaryl group are not fused with an aliphatic or heteroaliphatic group;
wherein at least one of $Y_1$ and $Y_2$ is a group of formula (II)
wherein in formula (II)
$R^{12}$, $R^{13}$, $R^{14}$, $R^{15}$, $R^{16}$, $R^{17}$, $R^{18}$ and $R^{19}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; $NO_2$; $OR^{20}$; $SR^{21}$; $C(=O)R^{22}$; $COOR^{23}$; $SiR^{24}R^{25}R^{26}$; $NR^{84}R^{85}$, or halogen;
or
two adjacent residues together form a ring structure which is unsubstituted or substituted; wherein one of $R^{12}$, $R^{13}$, $R^{14}$, $R^{15}$, $R^{16}$, $R^{17}$, $R^{18}$ and $R^{19}$ is a bonding site;
X is O, S or $CR^{35'}R^{36'}$;
$L_1$ and $L_2$ each independently represents an unsubstituted or substituted aromatic group containing 6 to 30 ring atoms, wherein the aromatic group is not fused with a group of formula

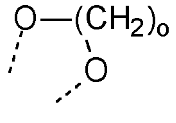
,

wherein o is 1, 2, 3 or 4 and the dotted lines are bonding sites; or an unsubstituted or substituted heteroaromatic group containing 5 to 30 ring atoms; preferably, the aromatic group is not fused with an aliphatic or heteroaliphatic group; more preferably, the aromatic group and the heteroaromatic group are not fused with an aliphatic or heteroaliphatic group;
n and m are each independently 0, 1, 2 or 3; preferably 0, 1 or 2, more preferably 0 or 1; wherein in the case that $Y_1$ is a group of formula (II) and X is O or S, n is 1, 2 or 3;
and/or
wherein in the case that $Y_2$ is a group of formula (II) and X is O or S, m is 1, 2 or 3;
$R^{35'}$ and $R^{36'}$ each independently represents an alkyl group having from 1 to 20 carbon atoms which is

unsubstituted or substituted; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; or

$R^{35'}$ and $R^{36'}$ together form an aromatic ring structure which is unsubstituted or substituted; $R^{84}$ and $R^{85}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;

$R^{20}$, $R^{21}$, $R^{22}$ and $R^{23}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;

$R^{24}$, $R^{25}$ and $R^{26}$ each independently represents an aryl group having from 6 to 30 ring carbon atoms which is unsubstituted or substituted; a heteroaryl group having from 5 to 30 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted.

**2.** The compound according to claim 1, wherein two adjacent residues of $R^1$, $R^2$, $R^3$, $R^4$, $R^5$, $R^6$, $R^7$ and $R^8$ do not form a ring structure of formula

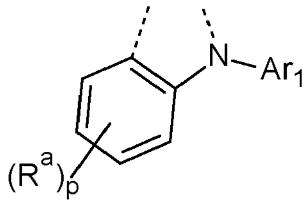

,

wherein $Ar_1$ is an aryl group having from 6 to 60 ring carbon atoms which is unsubstituted or substituted; and $R^a$ is defined as any one of $R^1$, $R^2$, $R^3$, $R^4$, $R^5$, $R^6$, $R^7$ and $R^8$ and p is 1, 2, 3 or 4.

**3.** The compound according to claim 1 or 2, wherein two adjacent residues of $R^1$, $R^2$, $R^3$, $R^4$, $R^9$, $R^{10}$ and $R^{11}$ do not form a ring structure.

**4.** The compound according to any one of claims 1 to 3, wherein $R^1$, $R^2$, $R^3$, $R^4$, $R^5$, $R^6$, $R^7$, $R^8$, $R^9$, $R^{10}$ and $R^{11}$ each independently represents hydrogen; an aryl group having from 6 to 30 ring carbon atoms which is unsubstituted or substituted; a heteroaryl group having from 5 to 30 ring atoms which is unsubstituted or substituted; an aralkyl group having from 7 to 30 carbon atoms which is unsubstituted or substituted; an alkyl group having from 1 to 20 carbon atoms which is unsubstituted or substituted; $OR^{20}$; or an amino group N $R^{84}R^{85}$;

or

$R^6$ and $R^7$ together form a ring structure which is unsubstituted or substituted.

**5.** The compound according to any one of claims 1 to 4, wherein $R^{11}$ and $R^9$ are hydrogen.

**6.** The compound according to any one of claims 1 to 5, wherein $R^1$, $R^4$, $R^5$ and $R^8$ are hydrogen.

**7.** The compound according to any one of claims 1 to 6, wherein $R^{10}$ is an alkyl group having from 1 to 20 carbon atoms which is unsubstituted or substituted; preferably an alkyl group having from 1 to 8 carbon atoms which is unsubstituted, more preferably an alkyl group having from 1 to 4 carbon atoms which is unsubstituted.

**8.** The compound according to any one of claims 1 to 7, wherein one of $R^2$ and $R^3$ is hydrogen and the other one of $R^2$ and $R^3$ is an alkyl group having from 1 to 20 carbon atoms which is unsubstituted or substituted; or an amino group $NR^{84}R^{85}$.

**9.** The compound according to any one of claims 1 to 8, wherein one of $R^6$ and $R^7$ represents hydrogen; and the other one of $R^6$ and $R^7$ represents an aryl group having from 6 to 30 ring carbon atoms which is unsubstituted or substituted; or a heteroaryl group having from 5 to 30 ring atoms which is unsubstituted or substituted;

or
$R^6$ and $R^7$ together form a ring structure which is unsubstituted or substituted.

**10.** The compound according to any one of claims 1 to 9, wherein $L_1$ and $L_2$ each independently represents an unsubstituted or substituted phenylene group.

**11.** The compound according to any one of claims 1 to 10, wherein exactly one of $Y_1$ and $Y_2$ is a group of formula (II).

**12.** The compound according to any one of claims 1 to 11, wherein the compound is represented by one of the following formulae

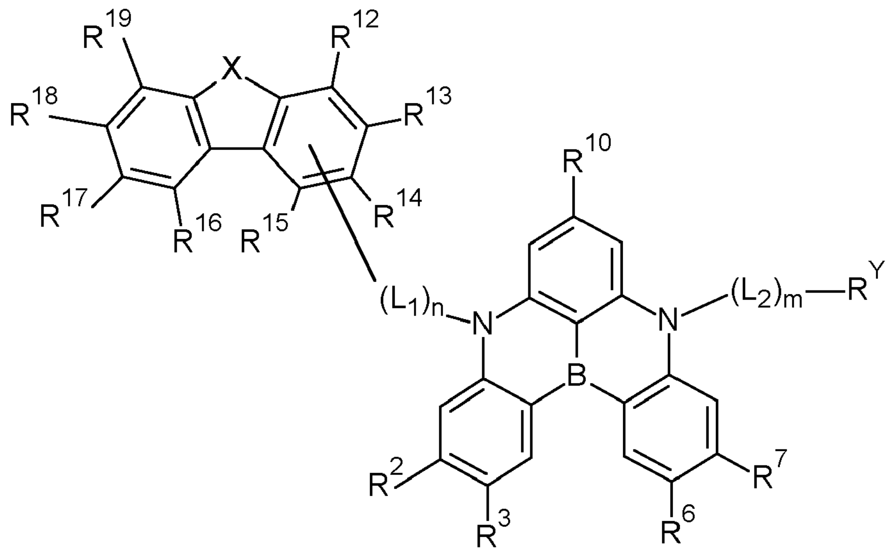

(IA)

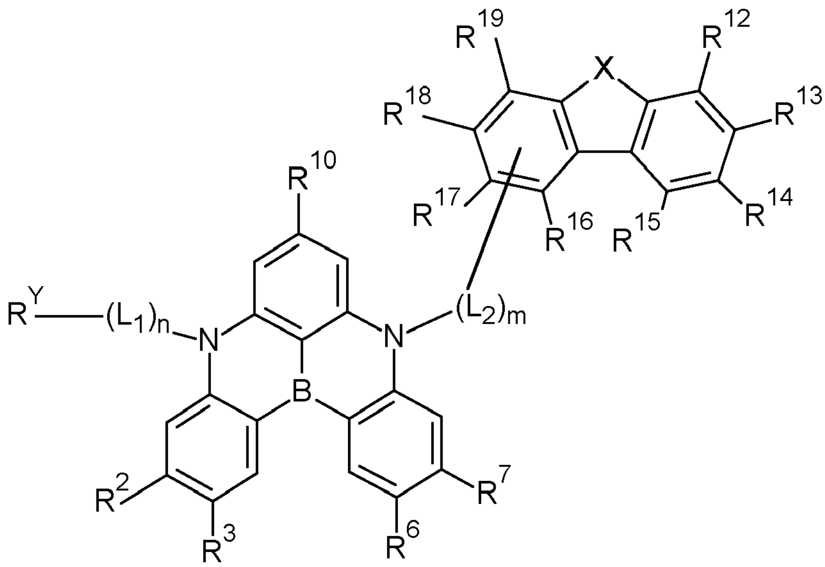

(IB).

**13.** The compound according to claim 12, wherein $L_1$ and $L_2$ represent a phenylene group which is unsubstituted or substituted and m and n are each independently 0 or 1,. wherein in the case that in formula (IA) X is O or S, n is 1; and/or
wherein in the case that in formula (IB) X is O or S, m is 1.

**14.** A material, preferably an emitter material, for an organic electroluminescence device, comprising at least one compound according to any one of claims 1 to 13.

**15.** An organic electroluminescence device comprising at least one compound according to any one of claims 1 to 13.

**16.** The organic electroluminescence device according to claim 15, comprising a cathode, an anode and one or more organic thin film layers comprising an emitting layer disposed between the cathode and the anode, wherein at least one layer of the organic thin film layers comprises at least one compound according to any one of claims 1 to 13.

**17.** The organic electroluminescence device according to claim 16, wherein the light emitting layer comprises at least one compound according to any one of claims 1 to 13.

**18.** The organic electroluminescence device according to claim 17, wherein the light emitting layer comprises at least one host and at least one dopant, wherein the dopant comprises at least one compound according to any one of claims 1 to 13.

**19.** The organic electroluminescence device according to claim 18, wherein the host comprises at least one substituted or unsubstituted fused aromatic hydrocarbon compound and/or at least one substituted or unsubstituted anthracene compound.

**20.** The organic electroluminescence device according to claim 19, wherein the anthracene compound is represented by the following formula (10):

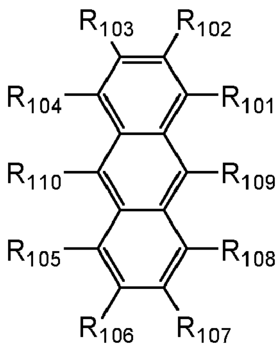

(10)

wherein

one or more pairs of two or more adjacent $R_{101}$ to $R_{110}$ may form a substituted or unsubstituted, saturated or unsaturated ring;

$R_{101}$ to $R_{110}$ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, $-Si(R_{121})(R_{122})(R_{123})$, $-C(=O)R_{124}$, $-COOR_{125}$, $-N(R_{126})(R_{127})$, a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);

$R_{121}$ to $R_{127}$ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of $R_{121}$ to $R_{127}$ is present in plural, each of the plural $R_{121}$ to $R_{127}$ may be the same or different;

provided that at least one of $R_{101}$ to $R_{110}$ that do not form the substituted or unsubstituted, saturated or unsaturated ring is a group represented by the following formula (31). If two or more groups represented by the formula (31) are present, each of these groups may be the same or different;

$$-L_{101}-Ar_{101} \qquad (31)$$

wherein in the formula (31),

$L_{101}$ is a single bond, a substituted or unsubstituted arylene group including 6 to 30 ring carbon atoms or a substituted or unsubstituted divalent heterocyclic group including 5 to 30 ring atoms;

$Ar_{101}$ is a substituted or unsubstituted aryl group including 6 to 50 ring carbon atoms or a substituted or unsubstituted monovalent heterocyclic group including 5 to 50 ring atoms.

**21.** An electronic equipment comprising the organic electroluminescence device according to any one of claims 15 to 20.

**22.** A light emitting layer comprising at least one host and at least one dopant, wherein the dopant comprises at least one compound according to any one of claims 1 to 13.

**23.** Use of a compound of formula (I) according to any one of claims 1 to 13 in an organic electroluminescence device.

FIG.1

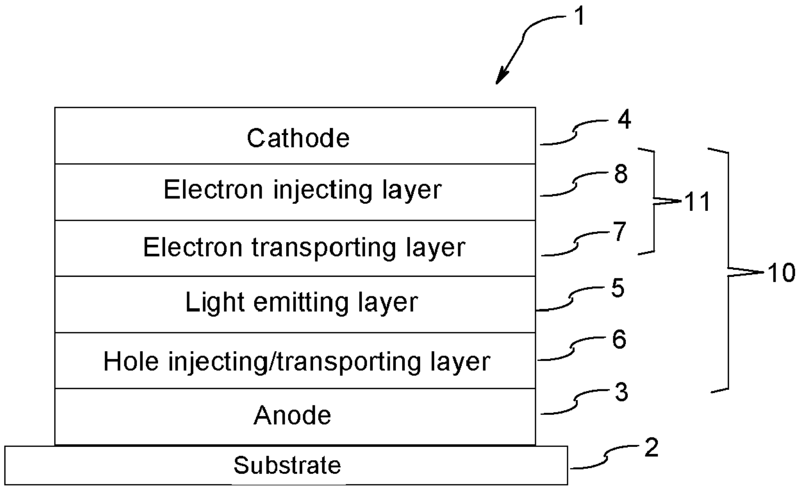
1
Cathode
4
Electron injecting layer
8
11
Electron transporting layer
7
10
Light emitting layer
5
Hole injecting/transporting layer
6
Anode
3
Substrate
2

Europäisches Patentamt
European Patent Office
Office européen des brevets

# EUROPEAN SEARCH REPORT

Application Number
EP 23 18 7654

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/273416 A1 (SHAANXI LIGHTE OPTOELECTRONICS MAT CO LTD [CN]) 5 January 2023 (2023-01-05)<br>* page 33; claims 1-12 *<br>* page 55 *<br>----- | 1-23 | INV.<br>C09K11/06<br>C07F5/02<br>H10K50/00 |
| X | KR 2022 0117680 A (LG CHEMICAL LTD [KR]) 24 August 2022 (2022-08-24)<br>* page 22; claims 1-12 *<br>* page 26 *<br>----- | 1-23 | |
| X | WO 2021/107728 A1 (LG CHEMICAL LTD [KR]) 3 June 2021 (2021-06-03)<br>* page 147; claims 1-18 *<br>* page 167 *<br>----- | 1-23 | |
| X | WO 2020/080872 A1 (LG CHEMICAL LTD [KR]) 23 April 2020 (2020-04-23)<br>* page 140 - page 150; claims 1-8 *<br>----- | 1-23 | |
| X | WO 2018/216990 A1 (MAT SCIENCE CO LTD [KR]) 29 November 2018 (2018-11-29)<br>* page 81; claims 1-10 *<br>----- | 1-23 | TECHNICAL FIELDS SEARCHED (IPC)<br>C09K<br>C07F<br>H10K |

The present search report has been drawn up for all claims

1

| Place of search | Date of completion of the search | Examiner |
|---|---|---|
| The Hague | 8 January 2024 | Mehdaoui, Imed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 18 7654

This annex lists the patent family members relating to the patent documents cited in the above-mentioned European search report. The members are as contained in the European Patent Office EDP file on
The European Patent Office is in no way liable for these particulars which are merely given for the purpose of information.

08-01-2024

| Patent document cited in search report | Publication date | Patent family member(s) | Publication date |
|---|---|---|---|
| WO 2023273416 A1 | 05-01-2023 | CN 114075231 A | 22-02-2022 |
| | | CN 117186130 A | 08-12-2023 |
| | | WO 2023273416 A1 | 05-01-2023 |
| KR 20220117680 A | 24-08-2022 | NONE | |
| WO 2021107728 A1 | 03-06-2021 | KR 20210067849 A | 08-06-2021 |
| | | KR 20210067968 A | 08-06-2021 |
| | | KR 20210067969 A | 08-06-2021 |
| | | US 2022393111 A1 | 08-12-2022 |
| | | WO 2021107728 A1 | 03-06-2021 |
| WO 2020080872 A1 | 23-04-2020 | CN 111699191 A | 22-09-2020 |
| | | KR 20200043923 A | 28-04-2020 |
| | | WO 2020080872 A1 | 23-04-2020 |
| WO 2018216990 A1 | 29-11-2018 | CN 110662750 A | 07-01-2020 |
| | | JP 7026405 B2 | 28-02-2022 |
| | | JP 2020520976 A | 16-07-2020 |
| | | KR 101876763 B1 | 11-07-2018 |
| | | KR 20180127918 A | 30-11-2018 |
| | | US 2020176679 A1 | 04-06-2020 |
| | | WO 2018216990 A1 | 29-11-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20220020925 A1
- US 20210066599 A1
- US 20210062078 A1
- WO 2021049889 A1
- KR 20190127529 A
- US 20200176679 A1
- WO 2022191561 A1
- KR 20220073182 A
- WO 2020080872 A1